# EUROPEAN PATENT APPLICATION

(11) **EP 4 530 686 A1**
(43) Date of publication of application: **02.04.2025**
(21) Application number: 24199941.6
(22) Date of filing: 12.09.2024
(51) Int. Cl.: G02B 6/12, G02B 6/42, G02B 5/18, H01S 5/40

(54) **OPTICAL MEASUREMENT SYSTEMS WITH MULTI-WAVELENGTH EMISSION**

(30) Priority: 29.09.2023 US 202363541575 P; 04.09.2024 US 202463690516 P; 09.09.2024 US 202418829173
(71) Applicant: Apple Inc., Cupertino, CA 95014 (US)
(72) Inventor: ARBORE, Mark Alan, Cupertino, 95014 (US); GREENING, Thomas C., Cupertino, 95014 (US); TERREL, Matthew A., Cupertino, 95014 (US); RIDDER, Trent D., Cupertino, 95014 (US)
(74) Representative: Zacco Denmark A/S

(57) **Abstract**

Various embodiments disclosed herein describe photonic integrated circuits and associated optical measurement systems. The photonic integrated circuit may be configured to simultaneously output light of different wavelengths from different outputs of a multiplexer. A switch network, which may include a multiplexing photonic switch, may be used to selectively route the different wavelengths to a common set of launch groups, from which the light may be emitted from the photonic integrated circuit.

## Description

### FIELD

This disclosure relates generally to optical measurement systems that utilize multiple light sources to generate light during a measurement. More particularly, this disclosure includes optical measurement systems that include routing arrangements that combine light and emit light of multiple wavelengths during a measurement.

### BACKGROUND

Optical measurement systems can be used to identify the presence, type, and/or one or more characteristics of objects or substances in the environment surrounding the system. In some instances, an optical measurement system can perform spectroscopic measurements by emitting light at multiple wavelengths and measuring light returned to the system. The relative amounts of light returned at each wavelength may provide information about the nature of the material or materials being measured. Depending on the property or properties being measured, individual measurements performed at certain wavelengths may have low signal-to-noise ratio ("SNR"). Accordingly, it may be desirable to provide an optical measurement system that may improve the SNR of one or more measurements performed by the optical measurement system.

### SUMMARY

Described herein are optical measurement systems, as well as photonic integrated circuits and individual components such as light source units and switch networks for use in optical measurement systems.

Some embodiments are directed to a light source unit that includes an Echelle grating multiplexer, wherein the Echelle grating includes a plurality of inputs, and a plurality of outputs positioned to receive light from the plurality of inputs. The light source unit includes a plurality of groups of light sources, wherein each group of light sources is operable to emit a plurality of wavelengths, wherein each light source of the plurality of groups of light sources is connected to a corresponding input of the plurality of inputs, and the plurality of inputs is positioned such that: i) light generated by a first light source of each of the plurality of groups of light sources is routed to a first output of the plurality of outputs, and ii) light generated by a second light source of each of the plurality of groups of light sources is routed to a second output of the plurality of outputs.

In some variations, the plurality of inputs is positioned such that light generated by a third light source of each the plurality of the light sources is routed to a third output of the plurality of outputs. In some variations, the plurality of groups of light sources includes a first group of light sources, and the first light source and the second light source of the first group of light sources are connected to immediately adjacent inputs of the plurality of inputs.

In some variations, the plurality of groups of light source includes a first group of light sources and a second group of light sources. The first light source of the first group of light sources is connected to a first input of the plurality of inputs. The second light source of the first group of light sources is connected to a second input of the plurality of inputs. The first light source of the second group of light sources is connected to a third input of the plurality of inputs. The second light source of the second group of light sources is connected to a fourth input of the plurality of inputs. The third input is positioned between the first and second input.

The plurality of groups of light sources may include a first group of light sources and a second group of light sources. In some variations, the first light source of the first group of light sources and the first light source of the second group of light sources are positioned on a first laser chip. Additionally or alternatively, the second light source of the first group of light sources and the second light source of the second group of light sources are positioned on a second laser chip.

In some variations, the first output is connected to a first wavelength locking unit and the second output is connected to a second wavelength locking unit. In some of these variations, the plurality of inputs is positioned such that light generated by a third light source of each the plurality of the light sources is routed to a third output of the plurality of outputs; and the third output is connected to a third wavelength locking unit. In some variations, the first light source and the second light source of each of the plurality of groups generate light having a common frequency difference.

Other embodiments are directed to a light source unit that includes a first plurality of light sources operable to emit first and second wavelengths of light, wherein the first and the second wavelengths are separated by less than a threshold amount. A second plurality of light sources is operable to emit third and fourth wavelengths of light, wherein the third and the fourth wavelengths are separated by less than the threshold amount. A multiplexer includes a first input positioned to receive the first wavelength of light emitted by the first plurality of light sources, a second input positioned to receive the second wavelength of light emitted by the first plurality of light sources, a third input positioned to receive the third wavelength of light emitted by the second plurality of light sources, a fourth input positioned to receive the fourth wavelength of light emitted by the second plurality of light sources, a first output, and a second output, wherein the multiplexer is configured to route light received from the first input and the third input to the first output, and the multiplexer is configured to route light received from the second input and the fourth input to the second output.

In some variations, the multiplexer that is an Echelle grating multiplexer. In some variations, the third output is positioned between the first input and the second output. In some of these variations, the first wavelength is longer than the second wavelength. Additionally or alternatively, the second input may be positioned between the third input and the fourth input. In some instances, the first plurality of light sources is positioned on a first laser chip and the second plurality of light sources are positioned on a second laser chip. The light source unit may include first wavelength locking unit and a second wavelength locking unit, wherein the first output is connected to a first wavelength locking unit and the second output is connected to a second wavelength locking unit.

Other embodiments are directed to a method of operating a light source unit that includes simultaneously emitting, using a first plurality of light sources, a first wavelength of light and a second wavelength of light during a first period. The method includes receiving the first wavelength of light and the second wavelength of light at a multiplexer during the first period. The method includes outputting the first wavelength of light from a first output of the multiplexer during the first period. The method includes outputting the second wavelength of light from a second output of the multiplexer during the first period. The method includes simultaneously emitting, using a second plurality of light sources, a third wavelength of light and a fourth wavelength of light during a second period. The method includes receiving the third wavelength of light and the fourth wavelength of light at the multiplexer during the second period. The method includes outputting the third wavelength of light from the first output of the multiplexer during the second period. The method includes outputting the fourth wavelength of light from the second output of the multiplexer during the second period.

In some variations, the first wavelength of light is emitted from a first light source and the second wavelength of light is emitted from a second light source, and the first light source and the second light source connect to immediately adjacent inputs of the multiplexer. In some variations, the first light source is positioned on a first laser chip, and the second light source is positioned on a second laser chip. In some variations, the first wavelength of light and the second wavelength of light have a first frequency difference, and the third wavelength of light and the fourth wavelength of light have the first frequency difference. In some variations, the first output is connected to a first wavelength locking unit and the second output is connected to a second wavelength locking unit.

Other embodiments are directed to a photonic integrated circuit that includes a photonic switch configured to simultaneously route a first wavelength of light and a second wavelength of light having a predetermined frequency difference. The photonic switch includes a first coupler having a first input, a second input, a first output, and a second output. The photonic switch includes a second coupler having a third input, a fourth input, a third output, and a fourth output. The photonic switch includes a first leg connecting the first output of the first coupler to the third input of the second coupler. The photonic switch includes a second leg connecting the second output of the first coupler to the fourth input of the second coupler, wherein a length difference between the first leg and the second leg provides a free spectral range. The photonic switch includes a first phase shifter positioned and controllable to selectively provide a first phase shift to light traveling between the first coupler and the second coupler. The free spectral range is selected based on the predetermined frequency difference, such that the first wavelength of light received at the first input and the second wavelength of light received at the second input will be routed to a common selection of the third and fourth outputs, and the first phase shifter at least partially controls the common selection of the third and fourth outputs.

In some variations, the photonic switch is controllable to split the first wavelength of light and the second wavelength of light between the third output and the fourth output of the second coupler. Additionally or alternatively, the photonic switch is controllable to selectively route the first wavelength of light and the second wavelength of light to a single output of the third output and the fourth output.

In some variations, a second phase shifter is positioned and controllable to selectively provide a second amount of phase shift to light travelling between the first coupler and the second coupler. In some variations, the first phase shifter is positioned on the first leg and the first phase shifter provides the first phase shift to light travelling through the first leg. In some variations, the second phase shifter is positioned on the second leg, and the second phase shifter provides the second phase shift to light travelling through the second leg. In some variations, the controllable switch includes a variable optical attenuator optically connected to the first input.

Other embodiments are directed to a photonic integrated circuit that includes a plurality of light sources including a first light source and a second light source, wherein the first light source is operable to emit a first wavelength of light and the second light source is operable to emit a second wavelength of light. The photonic integrated circuit includes a photonic switch that includes a first coupler having a first input, a second input, a first output, and a second output. The photonic switch includes a second coupler having a third input, a fourth input, a third output, and a fourth output. The photonic switch includes a first leg connecting the first output of the first coupler to the third input of the second coupler. The photonic switch includes a second leg connecting the second output of the first coupler to the fourth input of the second coupler, wherein a length difference between the first leg and the second leg provides a free spectral range. The photonic switch includes a first phase shifter positioned and controllable to selectively provide a first phase shift to light traveling between the first coupler and the second coupler, wherein the free spectral range is selected based on the predetermined frequency difference, such that the first wavelength of light received at the first input and the second wavelength of light received at the second input will be routed to a common selection of the third and fourth outputs, and the first phase shifter at least partially controls the common selection of the third and fourth outputs. In some variations, the controllable switch includes a variable optical attenuator optically connected to the first input.

In other embodiments, a method of operating a photonic integrated circuit having a plurality of light sources and a photonic switch including a first coupler, a second coupler, a first leg connecting the first coupler to the second coupler, a second leg connecting the first coupler to the second coupler, and a plurality of phase shifters. The method includes simultaneously generating, during a first period of time, a first wavelength of light and a second wavelength of light using the plurality of light sources, the first and second wavelengths of light having a predetermined frequency difference. The method further includes receiving, during the first period of time, the first wavelength of light at a first input of the photonic switch and the second wavelength of light at a second input of the photonic switch. A first phase shift is applied to the first leg during the first period of time to simultaneously route the first wavelength of light and the second wavelength to a first common selection of outputs of the photonic switch. Additionally, a length difference between the first leg and the second leg provides a free spectral range of the photonic switch, and the free spectral range is selected based on the predetermined frequency difference, such that the first wavelength of light received at the first input and the second wavelength of light received at the second input are combined into the same outputs of the photonic switch.

In some variations, the method includes simultaneously receiving, during a second period of time, a third wavelength of light at the first input of the photonic switch and a fourth wavelength of light at the second input of the photonic switch, wherein the third and the fourth wavelengths of light having the predetermined frequency difference. In some instance the method includes applying the first phase shift to the first leg during the second period of time to simultaneously route the third wavelength of light and the fourth wavelength to the first common selection of outputs of the photonic switch. In other instances, the method includes applying a second phase shift to the first leg during the second period of time to simultaneously route the third wavelength of light and the fourth wavelength to a second common selection of outputs of the photonic switch. In some variations the photonic switch includes a first phase shifter positioned to apply the first phase shift to the first leg and a second phase shifter positioned to provide a second phase shift to the second leg. In some of these variations, the method includes applying the second phase shift to the second leg during the first period of time.

Other embodiments are directed to a photonic integrated circuit that includes a light source unit that includes a plurality of light sources, and a multiplexer optically connected to the plurality of light sources and including a first output and a second output. The photonic integrated circuit also includes a switch network optically connected to the first output and the second output and including a plurality of outputs, wherein (1) the light source unit is controllable, during a first period of time, to simultaneously output a first wavelength of light from the first output and a second wavelength of light from the second output, and (2) the switch network is controllable, during the first period of time, to simultaneously route the first wavelength of light and the second wavelength of light to a first common selection of the plurality of outputs.

In some variations, the light source unit is controllable, during a second period of time, to simultaneously output a third wavelength of light from the first output and a fourth wavelength of light from the second output. In some variations, the switch network is controllable, during the second period of time, to simultaneously route the third wavelength of light and the fourth wavelength of light to a second common selection of the plurality of outputs. In some variations, the first wavelength of light and the second wavelength of light have a first frequency difference. In some variations, the third wavelength of light and the fourth wavelength of light have the first frequency difference. In some variations, the light source unit is controllable, during a third period of time, to simultaneously output a fifth wavelength of light from the third output and a sixth wavelength of light from the fourth output. In some variations, the switch network is controllable, during the third period of time, to simultaneously route the fifth wavelength of light and the sixth wavelength of light to a third common selection of the plurality of outputs.

In some variations, the switch network includes a first passive optical combiner that is optically connected to the first output and the second output, wherein the first passive optical combiner is configured to combine light from the first output and second output having a first predetermined frequency difference into a first waveguide. In some variations, the switch network includes a second passive optical combiner that is optically connected to the third output and the fourth output, wherein the second passive optical combiner is configured to combine light from the third output and fourth output having a second predetermined frequency difference into a second waveguide.

In some variations, the switch network includes a first controllable switch optically connected to the first waveguide and the second waveguide. In some variations, the switch network includes a first multiplexing optical switch that is optically connected to the first output and the second output, wherein the first multiplexing optical switch is configured to combine light from the first output and second output having a first predetermined frequency difference into a common selection of outputs of the first multiplexing photonic switch.

In some variations, the switch network includes a second multiplexing optical switch that is optically connected to the third output and the fourth output, wherein the second multiplexing optical switch is configured to combine light from the third output and fourth output having a second predetermined frequency difference into a common selection of outputs of the second multiplexing photonic switch.

In some variations, the photonic integrated circuit includes a first wavelength locking unit optically connected to the first output and the third output, and a second wavelength locking unit optically connected to the second output and the fourth output.

Other embodiments are directed to a photonic integrated circuit having a light source unit includes a first plurality of light sources and a second plurality of light sources. The light source unit includes a first multiplexer optically connected to the first plurality of light sources and having a first output and a second output. The light source unit includes a second multiplexer optically connected to the second plurality of light sources and having a third output and a fourth output. The photonic integrated circuit includes a switch network including a plurality of outputs and optically connected to the first output, the second output, third output, and the fourth output. The light source unit is controllable, during a first period of time, to simultaneously output a first wavelength of light from the first output and a second wavelength of light from the second output. The switch network is controllable, during the second period of time, to simultaneously route the first wavelength of light and the second wavelength of light to a first common selection of the plurality of outputs.

In some variations, the light source unit is controllable, during a second period of time, to simultaneously output a third wavelength of light from the first output and a fourth wavelength of light from the second output. In some variations, the switch network is controllable, during the second period of time, to simultaneously route the third wavelength of light and the fourth wavelength of light to a second common selection of the plurality of outputs. In some variations, the first wavelength of light and the second wavelength of light have a first frequency difference. In some variations, the third wavelength of light and the fourth wavelength of light have the first frequency difference. In some variations, the light source unit is controllable, during a third period of time, to simultaneously output a fifth wavelength of light from the third output and a sixth wavelength of light from the fourth output. In some variations, the switch network is controllable, during the third period of time, to simultaneously route the fifth wavelength of light and the sixth wavelength of light to a third common selection of the plurality of outputs.

In some variations, the switch network includes a first passive optical combiner that is optically connected to the first output and the second output, wherein the first passive optical combiner is configured to combine light from the first output and second output having a first predetermined frequency difference into a first waveguide. Additionally or alternatively, the switch network includes a second passive optical combiner that is optically connected to the third output and the fourth output, wherein the second passive optical combiner is configured to combine light from the third output and fourth output having a second predetermined frequency difference into a second waveguide. In some variations, the switch network includes a first controllable switch optically connected to the first waveguide and the second waveguide.

In some variations, the switch network includes a first multiplexing optical switch that is optically connected to the first output and the second output, wherein the first multiplexing optical switch is configured to combine light from the first output and second output having a first predetermined frequency difference into a common selection of outputs of the first multiplexing photonic switch. In some variations, the switch network includes a second multiplexing optical switch that is optically connected to the third output and the fourth output, wherein the second multiplexing optical switch is configured to combine light from the third output and fourth output having a second predetermined frequency difference into a common selection of outputs of the second multiplexing photonic switch. In some variations, a first wavelength locking unit optically connected to the first output and the third output, and a second wavelength locking unit optically connected to the second output and the fourth output.

In other embodiments, a method of operating a photonic integrated circuit having a light source unit and a switch network. The method includes, during a first period of time, simultaneously outputting a first wavelength of light from a first output of a first multiplexer of the light source unit and a second wavelength of light from a second output of the first multiplexer, and routing, using the switch network, the first wavelength of light and the second wavelength of light to a first common selection of outputs of the switch network.

In some variations, the method includes, during a second period of time, simultaneously outputting a third wavelength of light from the first output and a fourth wavelength of light from the second output, and routing, using the switch network, the third wavelength of light and the fourth wavelength of light to a second common selection of outputs of the switch network.

In some variations, the method includes, during a third period of time, simultaneously outputting a fifth wavelength of light from a first output of a second multiplexer of the light source unit and a sixth wavelength of light from a second output of the second multiplexer, and routing, using the switch network, the fifth wavelength of light and the sixth wavelength of light to a third common selection of outputs of the switch network.

Still other embodiments are directed to an optical measurement system that includes a photonics integrated circuit, where the photonic integrated circuit includes a light source unit. The light source unit includes an Echelle grating multiplexer comprising a plurality of inputs, and a plurality of outputs positioned to receive light from the plurality of inputs. The light source unit also includes a plurality of light sources configured to generate a first plurality of wavelengths, wherein: each light source of the plurality of light sources is connected to a corresponding input of the plurality of inputs, the plurality of light sources comprises a first group of light sources operable to emit light of a first group of wavelengths of light, a launch group optically coupled to the light source unit and configured to emit light received from the light source unit. The optical measurement system also includes a detector group and a controller.

The controller configured is to perform a first series of encoded measurements using the light source unit, the launch group, and the detector group, wherein each encoded measurement of the first series of encoded measurements includes: (i) generating, using the light source unit, light at a corresponding plurality of wavelengths, wherein the corresponding plurality of wavelengths is a corresponding subset of the first group of wavelengths, (ii) simultaneously emitting the corresponding plurality of wavelengths of the generated light from the launch group, and (iii) measuring, using the detector group, return light received during the simultaneous emission of the corresponding plurality of wavelengths.

In some variations, the control is configured to generate, using the first series of encoded measurements, a derived measurement intensity for each wavelength of the first group of wavelengths. Additionally or alternatively, the plurality of light sources may include a second group of light sources operable to emit a second group of wavelengths of light, and the controller may be configured to perform a second series of encoded measurements using the light source unit, the launch group, and the detector group. Each encoded measurement of the second series of encoded measurements may include: (i) generating, using the light source unit, light at a corresponding plurality of wavelengths, wherein the corresponding plurality of wavelengths is a corresponding subset of the second group of wavelengths, (ii) simultaneously emitting the corresponding plurality of wavelengths of the generated light from the launch group, and (iii) measuring, using the detector group, return light received during the simultaneous emission of the corresponding plurality of wavelengths.

In some variations, the first group of wavelengths is selected from immediately adjacent wavelengths of the first plurality of wavelengths. The photonic integrated circuit comprises a passive optical combiner that is configured optically couple the plurality of outputs of the Echelle grating multiplexer to a common waveguide. Additionally or alternatively, the first group of light sources includes a first light source operable to emit light at a first wavelength, a second light source operable to emit light at a second wavelength, and a third light source operable to emit light at a second wavelength. In these variations, the plurality of outputs of the Echelle grating multiplexer may include a first output, a second output, and a third output, such that: i) the Echelle grating multiplexer is configured to route light of the first wavelength generated by the first light source to the first output, ii) the Echelle grating multiplexer is configured to route light of the second wavelength generated by the second light source to the second output, and iii) the Echelle grating multiplexer is configured to route light of the third wavelength generated by the third light source to the third output. In some variations, the optical measurement system includes a reference detector configured to measure an intensity of the light emitted by the launch group.

Some embodiments are directed to methods of performing a spectroscopic measurement using an optical measurement system that include performing, using a photonic integrated circuit and a detector group of the optical measurement system, a first series of encoded measurements for a first group of wavelengths to generate a first plurality of encoded measurement intensities. In these variations, the photonic integrated circuit may include a light source unit and a launch group, and the light source unit may include an Echelle grating multiplexer having a plurality of outputs. In these methods, performing the first series of encoded measurement may include, for each encoded measurement of the first series of encoded measurements: i) generating, at a corresponding subset of the plurality of outputs of the Echelle grating multiplexer, light at a corresponding plurality of wavelengths, wherein the corresponding plurality of wavelengths is a corresponding subset of the first group of wavelengths; ii) simultaneously emitting the corresponding plurality of wavelengths of the generated light from the launch group, and iii) measuring, using the detector group, return light received during the simultaneous emission of the corresponding plurality of wavelengths to generate a corresponding encoded measurement intensity of the first plurality of encoded measurement intensities.

In some variations, the method further includes decoding the first plurality of encoded measurement intensities to generate a corresponding derived measurement intensity for each wavelength of the first group of wavelengths. Additionally or alternatively, the plurality of outputs of the Echelle grating multiplexer includes a first output, a second output, and a third output, and the first group of wavelengths includes a first wavelength, a second wavelength, and a third wavelength. In some of these variations, the first series of encoded measurements includes a first encoded measurement. During the first encoded measurement of the first series of encoded measurements: light of the first wavelength is generated at the first output, light of the second wavelength is generated at the second output, light of the first wavelength and the second wavelength is simultaneously emitted from the launch group, and the detector group generates a first encoded measurement intensity of the first plurality of encoded measurement intensities. The first series of encoded measurements may also include a second encoded measurement. During the second encoded measurement of the first series of encoded measurements: light of the first wavelength is generated at the first output, light of the third wavelength is generated at the third output, light of the first wavelength and the third wavelength is simultaneously emitted from the launch group, and the detector group generates a second encoded measurement intensity of the first plurality of encoded measurement intensities.

In some variations, the method includes performing, using the photonic integrated circuit and the detector group, a second series of encoded measurements for a second group of wavelengths to generate a second plurality of encoded measurement intensities. In these variations, performing the second series of encoded measurement includes, for each encoded measurement of the second series of encoded measurements: i) generating, at a corresponding subset of the plurality of outputs of the Echelle grating multiplexer, light at a corresponding plurality of wavelengths, wherein the corresponding plurality of wavelengths is a corresponding subset of the second group of wavelengths, ii) simultaneously emitting the corresponding plurality of wavelengths of the generated light from the launch group; and iii) measuring, using the detector group, return light received during the simultaneous emission of the corresponding plurality of wavelengths to generate a corresponding encoded measurement intensity of the second plurality of encoded measurement intensities. In some of these variations, the method further includes decoding the second plurality of encoded measurement intensities to generate a corresponding derived measurement intensity for each wavelength of the second group of wavelengths. Additionally or alternatively, the first group of wavelengths and the second group of wavelengths have a common number of wavelengths. In some of these variations, the first group of wavelengths and the second group of wavelengths have a common set of frequency differences.

Other embodiments are directed to a method of performing a spectroscopic measurement using an optical measurement system, where the method includes performing, using the optical measurement system, a first series of encoded measurements for a group of wavelengths to generate a plurality of encoded measurement intensities. The method further includes decoding the plurality of encoded measurement intensities to generate a corresponding derived measurement intensity for each wavelength of the group of wavelengths and decoding the plurality of encoded references intensities to generate a corresponding derived reference intensity for each wavelength of the group of wavelengths. The method further includes generating, for each wavelength of the group of wavelengths, a corresponding reference-corrected derived measurement intensity using the corresponding derived measurement intensity and the corresponding derived reference intensity.

In some variations, the series of encoded measurements is performed using a photonic integrated circuit, a detector group, and a reference detector of the optical measurement system, the detector group generates the plurality of encoded measurement intensities, and the reference detector generates the plurality of encoded reference intensities. In some of these variations, the photonic integrated circuit comprises a light source unit and a launch group, the light source unit comprises an Echelle grating multiplexer having a plurality of outputs. In some of these variations, performing the series of encoded measurement includes, for each encoded measurement of the series of encoded measurements: i) generating, at a corresponding subset of the plurality of outputs of the Echelle grating multiplexer, light at a corresponding plurality of wavelengths, wherein the corresponding plurality of wavelengths is a corresponding subset of the group of wavelengths; ii) simultaneously emitting the corresponding plurality of wavelengths of the generated light from the launch group, and iii) measuring, using the detector group, return light received during the simultaneous emission of the corresponding plurality of wavelengths to generate a corresponding encoded measurement intensity of the plurality of encoded measurement intensities, and iv) measuring, using the reference detector, a portion of the generated light emitted from the launch group.

Other embodiments are directed to a photonic integrated circuit having a light source unit, where the light source unit includes a set of tunable light sources and an Echelle grating multiplexer that has a plurality of inputs, and a plurality of outputs positioned to receive light from the plurality of inputs. Each tunable light source of the set of tunable light sources is connected to a corresponding input of the plurality of inputs. Each tunable light source of the set of tunable light sources is operable to selectively emit light at a corresponding plurality of wavelengths that includes a first corresponding wavelength and a second corresponding wavelength, such that: i) light of the first corresponding wavelength emitted by each tunable light source of the set of tunable light sources is routed to a first output of the plurality of outputs, and ii) light of the second corresponding wavelength emitted by each tunable light source of the set of tunable light sources is routed to a second output of the plurality of outputs.

In some variations, the corresponding plurality of wavelengths of each of tunable light source of the set of tunable light sources comprises a third corresponding wavelength, and light of the third corresponding wavelength emitted by each tunable light source of the set of tunable light sources is routed to a third output of the plurality of outputs. Additionally or alternatively, the set of tunable light sources comprises a plurality of tunable light sources. In some of these variations, the corresponding first wavelength and the corresponding second wavelength emitted by each tunable light source of the plurality of tunable light sources have a common frequency difference.

Additionally or alternatively, the light source unit includes a set of groups of light sources, each group of light sources is operable to emit a corresponding plurality of wavelengths. In these variations, each light source of the set of groups of light sources may connected to a corresponding input of the plurality of inputs, and the plurality of inputs is positioned such that: i) light generated by a first light source of each of the set of groups of light sources is routed to the first output of the plurality of outputs, and ii) light generated by a second light source of each of the set of groups of light sources is routed to the second output of the plurality of outputs. In some variations, the photonic integrated circuit includes a passive optical combiner that is configured optically couple the plurality of outputs of the Echelle grating multiplexer to a common waveguide.

Still other embodiments are directed to a photonic integrated circuit having a light source unit that includes a set of tunable light sources and a plurality of light sources. The photonic integrated circuit includes a first multiplexer optically connected to the plurality of tunable light sources and comprising a first plurality of outputs and a second multiplexer optically connected to the plurality of light sources and comprising a second plurality of outputs, wherein. The light source unit is controllable, during a first period of time, to output a first wavelength of light from a first output of the first plurality of outputs, and is controllable, during a second period of time, to output a second wavelength of light from a second output of the first plurality of outputs. The first wavelength and the second wavelength are generated by a tunable light source of the set of tunable light sources. The light source unit is also controllable, during a third period of time, to simultaneously output a third wavelength of light from a first output of the second plurality of outputs and a second wavelength of light from a second output of the second plurality of outputs.

In some variations, the photonic integrated circuit includes a switch network optically connected to the first plurality of outputs and the second plurality of outputs, and including a third plurality of outputs. In some of these variations, the switch network is controllable, during the first period of time, to route the first wavelength of light to a first common selection of the third plurality of outputs, and is controllable, during the second period of time, to route the second wavelength of light to a second common selection of the third plurality of outputs. Additionally or alternatively, the switch network is controllable, during the third period of time, to simultaneously route the third wavelength of light and the fourth wavelength of light to a third common selection of the third plurality of outputs.

In some variations, the switch network includes a multiplexing photonic switch that is configured to: receive the third wavelength of light from the first output of the second plurality of outputs and the fourth wavelength of light from the second output of the second plurality of outputs, and combine the third wavelength of light and the fourth wavelength of light into a common selection of outputs of the multiplexing photonic switch.

In some variations, the switch network comprises a controllable switch that is optically connected to the first output of the first plurality of outputs and the second output of the first plurality of outputs. The first multiplexer and/or the second multiplexer may be an Echelle grating multiplexer. In some variations, the light source unit includes a set of wavelength locking units.

Some embodiments are directed method of operating a light source unit of a photonic integrated circuit that includes: i) emitting, using a first tunable light source, a first wavelength of light of during a first period, ii) receiving the first wavelength of light at a first input of an Echelle grating multiplexer during the first period, and iii) outputting the first wavelength of light from a first output of the Echelle grating multiplexer during the first period. The method also includes: i) emitting, using the first tunable light source, a second wavelength of light during a second period, ii) receiving the second wavelength of light at the first input of the Echelle grating multiplexer during the second period, and iii) outputting the second wavelength of light from a second output of the Echelle grating multiplexer during the second period.

In some variations, the method further includes: i) emitting, using a second tunable light source, a third wavelength of light of during a third period, ii) receiving the third wavelength of light at a second input of the Echelle grating multiplexer during the third period, and iii) outputting the third wavelength of light from the first output of the Echelle grating multiplexer during the first period. The method may further include: i)emitting, using the second tunable light source, a fourth wavelength of light during a fourth period, ii) receiving the fourth wavelength of light at the second input of the Echelle grating multiplexer during the fourth period, and iii) outputting the fourth wavelength of light from the second output of the Echelle grating multiplexer during the fourth period. In some of these variations, the first wavelength of light and the second wavelength of light have a first frequency difference, and the third wavelength of light and the fourth wavelength of light have the first frequency difference.

In some variations, a passive optical combiner optically couples the first output and the second output the Echelle grating multiplexer to a common waveguide. Additionally or alternatively, the method may include simultaneously emitting, using a first plurality of light sources, a fifth wavelength of light and a sixth wavelength of light during a fifth period. In these variations, the method may include: i) receiving the fifth wavelength of light and the sixth wavelength of light at the Echelle grating multiplexer during the fifth period, ii) outputting the fifth wavelength of light from the first output of the Echelle grating multiplexer during the fifth period, and iii) outputting the sixth wavelength of light from the second output of the Echelle grating multiplexer during the fifth period.

In addition to the exemplary aspects and embodiments described above, further aspects and embodiments will become apparent by reference to the drawings and by study of the following description.

### BRIEF DESCRIPTION OF THE DRAWINGS

The disclosure will be readily understood by the following detailed description in conjunction with the accompanying drawings, wherein like reference numerals designate like structural elements, and in which:
FIG. 1A shows a partial cross-sectional side view of a device incorporating an optical measurement system as described herein. FIG. 1B shows a top view of the device of FIG. 1A.
FIG. 2 shows a schematic diagram of a variation of an optical measurement system as described herein.
FIG. 3A shows a schematic diagram of a variation of a photonic integrated circuit that incorporates a light source unit with a single-output Echelle grating multiplexer. FIGS. 3B-3J show schematic diagrams of variations of photonic integrated circuits as described herein that incorporate a light source unit with multi-output Echelle grating multiplexers. FIG. 3K shows a schematic diagram of a variation of a photonic integrated circuit that incorporates a light source unit with a multi-output Echelle grating multiplexer and a set of tunable light sources.
FIGS. 4A and 4B shows schematic diagrams of variations of passive optical combiners that may be used with the photonic integrated circuits described herein.
FIGS. 5A-5C show schematic diagrams of variations of photonic switches that may be used with the photonic integrated circuits described herein.
FIGS. 6A and 6B shows a schematic diagram of variations of switch networks that include a photonic switch such as those described herein with respect to FIGS. 5A-5C.
FIGS. 7A and 7B show schematic diagrams of variations of photonic integrated circuits that may be used with the optical measurement systems described herein.
FIGS. 8A and 8B show schematic diagrams of variations of photonic integrated circuits that may be used with the optical measurement systems described herein.
FIG. 9A shows a schematic diagram of a variation of a photonic integrated circuit that may be used with the optical measurement systems described herein. FIG. 9B shows a schematic diagram of a variation of a switch network that may be used with the photonic integrated circuit of FIG. 9A.
FIG. 10 depicts an example wavelength encoding matrix that may be used with the optical measurement systems described herein to perform a series of encoded measurements.
FIG. 11 depicts a variation of a method of performing a spectroscopic measurement that includes one or more series of encoded measurements.
FIG. 12 shows a variation of an optical measurement system that utilizes both a detector group and a reference detector.
FIG. 13 depicts a variation of a method of performing a spectroscopic measurement that includes one or more series of encoded measurements.

It should be understood that the proportions and dimensions (either relative or absolute) of the various features and elements (and collections and subsettings thereof) and the boundaries, separations, and positional relationships presented therebetween, are provided in the accompanying figures merely to facilitate an understanding of the various embodiments described herein and, accordingly, may not necessarily be presented or illustrated to scale, and are not intended to indicate any preference or requirement for an illustrated embodiment to the exclusion of embodiments described with reference thereto.

Directional terminology, such as "top", "bottom", "upper", "lower", "front", "back", "over", "under", "above", "below", "left", "right", "vertical", "horizontal", *etc.* is used with reference to the orientation of some of the components in some of the figures described below, and is not intended to be limiting. Because components in various embodiments can be positioned in a number of different orientations, directional terminology is used for purposes of illustration to demonstrate the relative orientation between components of the systems and devices described herein. The directional terminology is intended to be construed broadly, and therefore should not be interpreted to preclude components being oriented in different ways. Also, as used herein, the phrase "at least one of" preceding a series of items, with the term "and" or "or" to separate any of the items, modifies the list as a whole, rather than each member of the list. The phrase "at least one of' does not require selection of at least one of each item listed; rather, the phrase allows a meaning that includes at a minimum one of any of the items, and/or at a minimum one of any combination of the items, and/or at a minimum one of each of the items. By way of example, the phrases "at least one of A, B, and C" or "at least one of A, B, or C" each refer to only A, only B, or only C; any combination of A, B, and C; and/or one or more of each of A, B, and C. Similarly, it may be appreciated that an order of elements presented for a conjunctive or disjunctive list provided herein should not be construed as limiting the disclosure to only that order provided.

### DETAILED DESCRIPTION

Reference will now be made in detail to representative embodiments illustrated in the accompanying drawings. It should be understood that the following descriptions are not intended to limit the embodiments to one preferred embodiment. To the contrary, it is intended to cover alternatives, modifications, and equivalents as can be included within the spirit and scope of the described embodiments as defined by the appended claims.

The following disclosure relates to optical measurement systems, as well as photonic integrated circuits and individual components thereof for use in optical measurement systems. The optical measurement systems described herein are configured to emit light from one or more launch sites that simultaneously includes multiple wavelengths of light. The optical measurement system may be configured to perform different individual measurements as part of spectroscopic measurement and may be configured to emit light at a different wavelength (or plurality of wavelengths) during different individual measurements. In this way, the optical measurement system may collect information on how a measured sample responds to light of different wavelengths and may use this information to determine one or more properties of the sample.

Accordingly, in some variations a photonic integrated circuit as described herein may include a light source unit that includes multiple outputs. The light source unit may be operated to simultaneously output different wavelengths of light, where each wavelength is outputted via a different output of the light source unit. The light source unit may incorporate one or more Echelle grating multiplexers that each have multiple outputs, such as described in more detail herein. Light from these outputs may be combined into a common output, such that it may be routed to and emitted from a set of launch locations (e.g., a single launch location or multiple launch locations) on the photonic integrated circuit. The light emitted from the photonic integrated circuit may be emitted from the optical measurement system and introduced into a sample being measured. One or more detector groups may measure the amount of light returned from the sample to the optical measurement system as part of a spectroscopic measurement or individual measurement thereof.

In some variations, a switch network may receive different wavelength of light generated from the light source unit and may both i) combine the different wavelengths of light and ii) selectively route the combined wavelengths of light to a common set of launch groups, where the common set of launch groups may include a single launch group or multiple launch group. In this way, each launch group of the common set of launch groups will emit light that simultaneously includes these different wavelengths. In some instances, a switch network may include a multiplexing photonic switch having multiple outputs and configured to selective route different wavelengths of light to the same selected outputs of the multiplexing photonic switch.

The optical measurement systems described herein may be used to perform, as part of a spectroscopic measurement, one or more series of encoded measurements. Each series of encoded measurement utilizes multiple individual encoded measurements, during which multiple wavelengths of light are simultaneously emitted from a launch site of the optical measurement system. Within a series of encoded measurements, different encoded measurements are performed using different combinations of wavelengths selected from a group of target wavelengths. The optical measurement system is configured to generate, for each series of encoded measurements, a corresponding plurality of encoded measurement intensities. Each encoded measurement intensity corresponds to the intensity of light measured by the optical measurement system for a combination of wavelengths emitted during the corresponding encoded measurement. The plurality of encoded measurement intensities may be analyzed to generate a derived measurement intensity for each wavelength of the group of target wavelengths. The derived measurement intensities may be used, alone or in combination with the results of other individual measurements performed as part of the spectroscopic measurement, in determining one or more properties of the sample.

In some variations, a light source unit may include a set of one or more tunable light sources and an Echelle grating multiplexer having multiple outputs. A tunable light source may be selectively operated to generate different wavelengths of light. In this way, the Echelle grating multiplexer may receive light from the tunable light source that has different wavelengths during different periods of time. The different wavelengths may be routed to different outputs of the Echelle grating multiplexer. When the light source unit is configured to output a particular plurality of wavelengths, the use of tunable light sources may reduce the number of light sources needed to output these wavelengths, which may reduce the number of electrical connections associated with the light source unit and/or the overall size of a photonic integrated circuit incorporating the light source unit.

It should be appreciated that when an optical measurement system or a component thereof (e.g., a photonic integrated circuit, a light source unit, or a light source) is discussed herein as being operated during different periods of time (e.g., to generate or emit different wavelengths of light), it should be appreciated that these periods of time may occur in any order as may be desired. For example, if a light source unit is discussed herein as generating light at a first wavelength during a first period and generating light at a second wavelength during a second period, the first period may occur before the second period or vice versa. Similarly, if the light source unit generates light at a third wavelength during a third period, this may occur before, after, or between the first and second periods.

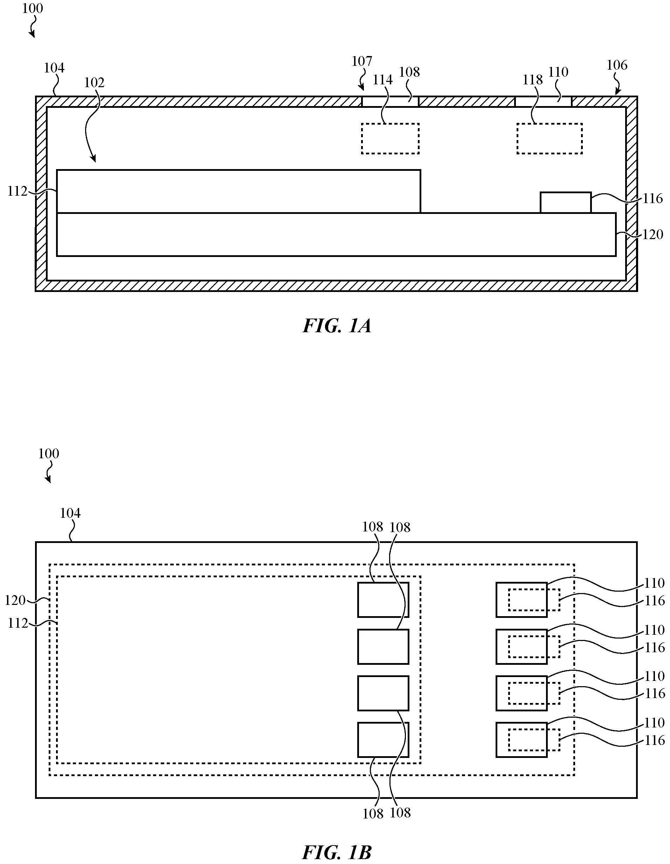

These and other embodiments are discussed with reference to FIGS. 1 A-13. However, those skilled in the art will readily appreciate that the detailed description given herein with respect to these figures is for explanatory purposes only and should not be construed as limiting.

The embodiments of the optical measurement systems described herein may be incorporated into a device having a housing. The device, which in some instances is wearable, may operate solely to take measurements using the optical measurement system or may be a multi-functional device capable of performing additional functions, as will be readily understood by someone of ordinary skill in the art. For example, in some instances the optical measurement system may be incorporated into a smart phone, tablet computing device, laptop or desktop computer, a smartwatch or other wearable, or other electronic device (collectively referred to herein as "electronic devices" for ease of discussion).

The device may include a display (which may be a touchscreen display) that provides a graphical output that is viewable through or at an exterior surface of the device. When the display is configured as a touchscreen, the display may be capable of receiving touch inputs at the exterior surface. The device may include a cover sheet (e.g., a cover glass) positioned over the display that forms at least a portion of the exterior surface. The display is capable of providing graphical outputs and, when configured as a touch screen, receiving touch inputs through the cover sheet. In some embodiments, the display includes one or more sensors (e.g., capacitive touch sensors, ultrasonic sensors, or other touch sensors) positioned above, below, or integrated with the display portion. In various embodiments, a graphical output of the display is responsive to inputs provided to the electronic device. The optical measurement systems described herein may, in some instances, be controlled in response to user inputs provided to the device (e.g., via a touchscreen display). Additionally or alternatively, the display may provide information about the progress and/or results of a spectroscopic measurement performed by the optical measurement system. The portable electronic device may include additional components typical of computing devices, including a processing unit, memory, input devices, output devices, additional sensors, and the like.

FIGS. 1A and 1B show an example of a device 100 that houses an optical measurement system 102 as described herein. FIG. 1A shows a side view of a device 100 that includes, for example, a housing 104 having a top exterior surface 106 (the housing 104 is depicted as a cross-section in FIG. 1A to reveal a side view of components of the optical measurement system 102 that are positioned within the housing 104). This top exterior surface 106 defines a sampling interface 107 for the optical measurement system 102, through which light emitted by the optical measurement system 102 can exit the device 100 and re-enter the device 100 to return to the optical measurement system 102. The sampling interface 107 includes at least one window that defines one or more emission regions 108 (through which light emitted by the optical measurement system 102 may exit the device 100) and one or more collection regions 110 (through which light entering the device 100 may reach a predetermined portion of the optical measurement system 102, such as a detector). In the variation shown in FIGS. 1A and 1B, the device includes a plurality of emission regions 108 and a plurality of collection regions 110. While FIGS. 1A and 1B depict an equal number of emission regions 108 and collection regions 110, in other instances the sampling interface 107 has an unequal number of emission regions 108 and collection regions 110.

Each emission region 108 acts as a corresponding launch site for the optical measurement system 102 from which light may be emitted from the optical measurement system 102. Similarly, each collection region 110 may act as a corresponding collection stie for the optical measurement system 102 from which light may be received and measured by the optical measurement system 102. Each emission region 108 and collection region 110 is transparent at any wavelength or wavelengths used by the optical measurement system 102 to perform the spectroscopic measurements discussed herein (collectively the "measurement wavelengths"). Each emission region 108 and collection region 110 may be defined by a corresponding window (transparent at the measurement wavelengths) that are separated from each other by one or more opaque portions of the housing (i.e., that absorb or otherwise block light transmission at the measurement wavelengths). In other variations, some or all of the emission regions 108 and/or collection regions 110 are defined in a common window (e.g., using a mask that is opaque at the measurement wavelengths). Additionally or alternatively, the device 100 may include barriers, baffles, or other light-blocking structures (not shown) that may at least partially define some or all of the emission regions 108 and collection regions 110. These light-blocking structures block stray light and act as a guide to limit the paths that light can take between the optical measurement system 102 and the sampling interface 107.

As shown in FIGS. 1A and 1B, the optical measurement system 102 includes a photonic integrated circuit 112. The photonic integrated circuit 112 includes a set of one or more launch groups and is able to selectively emit light from each launch group. In instances where the photonic integrated circuit 112 includes multiple launch groups, the photonic integrated circuit 112 is capable of emitting light from each of these launch groups. Light emitted from each launch group of the photonic integrated circuit 112 can exit the device 100 through the sampling interface 107 (e.g., via a corresponding emission region 108). In some variations, the optical measurement system 102 optionally includes one or more light modification components, shown schematically as box 114, positioned between the photonic integrated circuit 112 and the sampling interface 107, which alters the light emitted from the photonic integrated circuit 112 before it reaches the sampling interface 107. For example, the light modification components 114 may include one or more lenses (which change the divergence and/or direction of the light), one or more diffusers, mirrors, or the like. Additionally or alternatively, the sampling interface 107 itself may act as a light modification component (e.g., it may have an integrated lens or the like that can change the divergence and/or direction of the light passing therethrough). The light emitted from a given launch group interacts with the sampling interface 107 and any intervening components (such a light modification components 114) to control where that light exits from the device 100, and thus defines a launch site of the optical measurement system 102. In instances where the photonic integrated circuit 112 includes multiple launch groups, the optical measurement system 102 may include multiple different launch sites from which light may be emitted from the optical measurement system 102 (and thus emitted from the device 100 incorporating the optical measurement system 102 via the sampling interface 107).

The optical measurement system 102 further includes one or more detector groups 116, each of which includes a corresponding set of detector elements. Each detector group 116 is positioned within the device 100 to receive light that has entered the device 100 through the sampling interface 107 (e.g., via a corresponding collection region 110). In some variations the optical measurement system 102 comprises one or more light modification components, shown schematically as box 118, positioned between the sampling interface 107 and at least one detector group 116, which alters the light that enters the device 100 before it reaches the corresponding detector group (or groups). The light modification components 118 may include one or more lenses (which change the divergence and/or direction of the light), one or more diffusers, mirrors, or the like. Additionally or alternatively, the sampling interface 107 may act as a light modification component (e.g., it may have an integrated lens or the like that can change the divergence and/or direction of the light passing therethrough) that alters the light before it reaches a detector group 116.

In some instances, the photonic integrated circuit 112 and the one or more detector groups 116 are mounted to a common component. For example, in the variation shown in FIGS. 1A and 1B, the optical measurement system 102 comprises an interposer 120. In these instances, the photonic integrated circuit 112 and the one or more detector groups 116 are all mounted on the interposer 120, which in turn may act as an electrical interface for these components (e.g., to route signals to and/or from the components). In some instances, the interposer also acts as a heat sink. In other variations, the photonic integrated circuit 112 is mounted to a separate component than some or all of the detector groups 116. In still other variations, some or all of the detector groups 116 are directly mounted on (or otherwise integrated into) a portion the photonic integrated circuit 112.

Each detector group 116 may measure light received by the optical measurement system 102 (e.g., light that has been emitted from the optical measurement system toward a sample and returned to the optical measurement system) during a measurement. The light measured by the set of detector groups during a measurement may be analyzed to determine one or more properties of the environment surrounding the optical measurement system 102 (e.g., the presence, type, and/or one or more characteristics of an object measured by the optical measurement system). The optical measurement system may be configured to measure one or more properties of a particular type of object, material, or the like, which will collectively be referred to herein as a "sample". Light may be measured by a detector group while a corresponding launch group is emitting light (for determining how the emitted light interacts with the sample), and light may optionally also be measured while the corresponding launch group is not actively emitting light (for measuring background light which can assist in background correction operations).

Each detector group 116 may be associated with a corresponding launch group, such that each detector group 116 is positioned to measure light that has been emitted by the corresponding launch group and returned to the optical measurement system 102 (e.g., by interacting with a sample positioned external to the optical measurement system, such as placed in contact with the sampling interface 107). The optical measurement system 102 may be configured such that, when the optical systems is used to measure aspects of a predetermined type of sample, light emitted by one launch group will not reach detector groups associated with other launch groups. In this way, each launch group and its corresponding detector group may perform a measurement of a corresponding portion of a sample without interfering with other measurements being concurrently being performed by another launch group/detector group pair.

For example, the photonic integrated circuit 112 may include a plurality of launch groups that includes a first launch group and a second launch group, and a plurality of detector groups that includes a first detector group and the second detector group. Components of the optical measurement system 102 may be controlled (e.g., using a controller as described herein) to perform a first measurement using the first launch group and the first detector group and a second measurement using the second launch group and the second detector group. The first measurement and the second measurement may be performed concurrently, such that the first launch group and second launch group simultaneously emit light for at least of a portion of each of the first and second measurements.

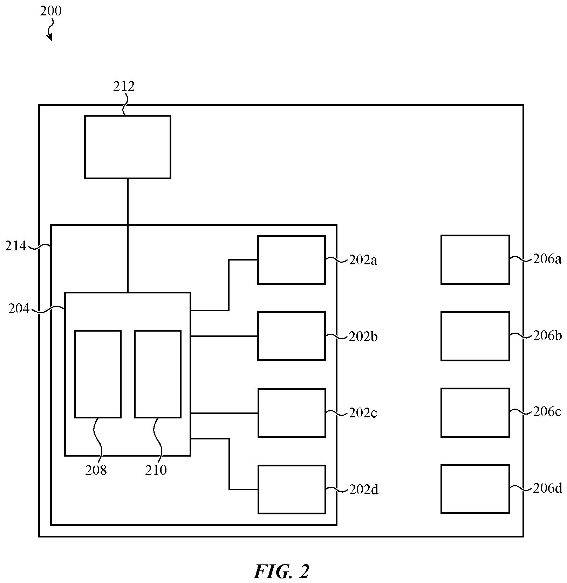

FIG. 2 shows a schematic diagram of an optical measurement system 200 as described herein. The optical measurement system 200 includes a set of launch groups 202a-202d, a light generation assembly 204, and a set of detector groups 206a-206d. The light generation assembly 204 is configured to generate light and route the light to the set of launch groups 202a-202d, thereby allowing some or all of the launch groups 202a-202d to emit light. Accordingly, light may exit the optical measurement system 200 via the set of launch groups 202a-202d, and the optical measurement system 200 may measure light returned to the optical measurement system 200 using some or all of the detector groups 206a-206d. While the optical measurement system 200 is shown in FIG. 2 as having four launch groups 202a-202d and four detector groups 206a-206d, it should be appreciated that the optical measurement system 200 may include any number of launch groups and detector groups. For example, some embodiments of the optical measurement systems described herein may include a single launch group and a single detector group. Indeed, certain concepts are discussed herein in the context of a single launch group/detector group pair of an optical measurement system, but these principles may be extended to any or all of the other launch groups and detector groups of a given optical measurement system.

The light generation assembly 204 may include a light source unit 208 having a set of light sources (not shown), each of which is selectively operable to emit light at a corresponding set of wavelengths. The set of light sources may be controlled to generate the light that is routed from the light generation assembly 204 to the set of launch groups 202a-202d. Each light source may be any component capable of generating light at one or more particular wavelengths, such as a light-emitting diode or a laser. A laser may include a semiconductor laser, such as a laser diode (e.g., a distributed Bragg reflector laser, a distributed feedback laser, an external cavity laser), a quantum cascade laser, or the like. A given light source may be single-frequency (fixed wavelength) or may be tunable to selectively generate one of multiple wavelengths (i.e., the light source may be controlled to output different wavelengths at different times). The set of light sources may include any suitable combination of light sources, and collectively may be operated to generate light at any of a plurality of different wavelengths.

For example, a tunable light source may, depending on its design, be operable to selectively adjust the wavelength of light emitted across a tuning range of the light source. Some light sources, such as distributed Bragg reflector lasers and distributed feedback lasers, may be configured to be tunable over a relatively small tuning range, such as on the order of single nanometers. Other light sources, such as sampled grating distributed brag reflector (SGDBR) lasers and reflective semiconductor optical amplifier (RSOA) lasers, may be tunable over a wider tuning range, such as on the order of tens or hundreds of nanometers.

In some variations, the light source unit 208 includes multiple sets of light sources, where each set of light sources is associated with a corresponding launch group of the set of launch groups 202a-202d. In these instances, each launch group may receive light generated from a different set of light sources of the light source unit 208. In other variations, multiple launch groups of the set of launch groups 202a-202d may receive light from a common set of light sources of the light source unit 208. For example, the light generation assembly 204 may include a switch network 210 that is configured to selectively route light generated by the light source unit 208 to any or all of the set of launch groups 202a-202d.

Specifically, the switch network 210 receives light from the light source unit 208 via one or more inputs, each of which is optically connected to a corresponding output of the light source unit 208 to receive light therefrom. The switch network 210 may include a plurality of outputs, each of which is connected to a corresponding launch group of the set of launch groups 202a-202d. The switch network 210 is controllable to take light received at one of its inputs and direct that light to some or all of its outputs simultaneously. For example, the switch network 210 may be configured in a first instance to route light from the light source unit 208 to a single launch group (e.g., a first launch group 202a), or may simultaneously route the light to multiple launch groups (e.g., all four launch groups 202a-202d). In these instances, the light source unit may include relatively fewer light sources, as a single set of light sources may be used to provide light to multiple launch groups.

It should be appreciated that, in some variations, the optical measurement systems described herein do not include a switch network 210. For example, the light source unit 208 may be optically connected to each of the set of launch groups 202a-202d such that the light generation assembly 204 does not select which launch groups 202a-202d receive light from the light source unit 208. For example, the light generation assembly 204 may include an M X N coupler (e.g., an M X N star coupler) or a cascaded array of optical couplers, such that light generated by the light source unit 208 is distributed between each of the set of launch groups 202a-202d.

The light source unit 208 may include additional components beyond the set of light sources. For example, the light source unit 208 may include one or more multiplexers (e.g., an Echelle grating multiplexer, an arrayed waveguide grating (AWG) multiplexer, a ring resonator multiplexer, or the like) that may be configured to reduce the number of outputs of the light source unit 208. Specifically, a multiplexer may include multiple inputs (each of which may be connected to a corresponding light source) and one or more outputs, and may be configured such that light received at a given input is routed to a corresponding out. The outputs of the multiplexer may be optically connected to corresponding inputs of the switching network. In this way, the switch network 210 may be able to receive light from several different light sources using a relatively small number of inputs.

In some variations the light source unit 208 includes one or more wavelength locking units. Each wavelength locking unit can output a corresponding set of output signals that is indicative of the wavelength or changes in wavelength of light received by that wavelength locking unit, which may be used by a controller (e.g., a controller 212 of the optical measurement system 200) to control the light source unit 208 (e.g., to control a light source within the light source unit that is generating the light) to stabilize or otherwise adjust the wavelength of light emitted by the light source unit 208. Even for fixed wavelength lasers, the precise emission wavelength may vary slightly with changes in temperature and/or injection current, and thus a wavelength locking unit may provide feedback to the controller 212 to set a stable wavelength output before or during a measurement. In instances where the light source unit 208 includes one or more multiplexers, wavelength locking units may receive light that is output by one or more multiplexers by tapping light from corresponding outputs of these multiplexers.

Each wavelength locking unit may include any components as may be needed to generate the corresponding set of output signals. For example, in some variations, a wavelength locking unit may include a set of interferometric components (e.g., a single interferometric component or multiple interferometric components) that is configured to generate a set of wavelength-dependent interference signals. Specifically, the set of interferometric components may include one or more Mach-Zehnder interferometers, multimode interference waveguides, or the like, which are configured to output one or more interference signals, where the intensity of each interference signal is dependent on the wavelength of the light received by the set of interferometric components. The wavelength locking unit may include a set of detector elements that are configured to measure the set of interference signals to generate the set of output signals. A controller (e.g., controller 212) may use the set of output signals to control a light source such that the light source outputs at a target wavelength.

Each detector group of the set of detector groups 206a-206d includes one or more sets of detector elements. Each detector element is capable of generating a corresponding signal representative of light incident thereon, which collectively may form a set of output signals for a detector group. Individual detector elements can either be a standalone detector or a single sensing element of a larger detector array (e.g., a photodiode of a photodiode array). It should be appreciated that different sensing elements of a single detector array may be associated with different detector groups. For example, a detector array may include a first subset of sensing elements associated with a first detector group and a second subset of sensing elements associated with a second detector group. It should also be appreciated that the detector elements within a given detector group of the set of detector groups 206a-206d need not be immediately adjacent to each other. Overall, the set of detector groups 206a-206d measure light that has been emitted from the optical measurement system 200 via the set of launch groups 202a-202d and returned to the optical measurement system 200 (e.g., after interacting with a sample), which may facilitate the various measurements described herein.

As discussed herein, each of the set of launch groups 202a-202d is formed as part of a photonic integrated circuit 214. Some or all of the light generation assembly 204 (e.g., the light source unit 208 and/or the switch network 210) may also be integrated into the photonic integrated circuit 214. For example, in some instances the light sources of the light source unit 208 are all integrated into the photonic integrated circuit 214, such as shown in FIG. 2. In other instances some or all of the light sources generate light externally from the photonic integrated circuit 214 and light from these light sources is coupled into the photonic integrated circuit 214 to reach the one or more launch group of the set of launch groups 202a-202d. It should be appreciated that the photonic integrated circuit 214 may include multiple photonic dies, such that different components of the photonic integrated circuit 214 are formed in different photonics dies. For example, the light sources of the light source unit 208 may be formed as part of one or more laser chips. Additionally or alternatively, other components of the photonic integrated circuit 214 may be distributed between different photonic dies if so desired.

The photonic integrated circuit 214 may utilize waveguides to optically connect the components on the photonic integrated circuit 214. For example, in the embodiment shown in FIG. 2, each launch group of the set of launch groups 202a-202d may be optically connected to the light generation assembly 204 via a corresponding waveguide. In these instances, each launch group of the set of launch groups 202a-202d is configured to emit at least one corresponding beam of light from the photonic integrated circuit 214. Specifically, each launch group includes one or more sets of emitters (e.g., a single emitter or multiple emitters), where each set of emitters is configured to emit a corresponding beam of light from the photonic integrated circuit 214. Each emitter may be configured as an outcoupler (e.g., an edge coupler, a vertical output coupler, or the like) that is configured to launch light from the photonic integrated circuit at a predetermined position and angle relative to the photonic integrated circuit 214. In instances where a launch group includes multiple emitters that are configured to generate a single beam of light, each of these emitters may emit a corresponding individual beam of light from the photonic integrated circuit 214. The individual beams of light generated by the set of emitters may at least partially overlap and thereby collectively form a larger overall beam of light emitted by that launch group (also referred to herein as a "launch beam").

Each emitter of a launch group is optically connected to the light source unit 208, such that the emitter may receive light that is generated by the light source unit 208. For example, a set of emitters of a launch group may be optically connected to a corresponding output (or outputs) of the switch network 210, such that the switch network 210 may route light from the light source unit 208 to the set of emitters. In some variations, the photonic integrated circuit 214 includes one or more optical splitters that are configured to receive light from an output of the switch network 210 and split the received light between some or all of the emitters of a launch group. For example, the one or more optical splitters may include a star coupler, a cascaded array of optical splitters (e.g., 1 × 2 splitters or the like), other 1 × N or M × N splitters, combinations thereof, or the like.

The optical measurement system 202 may be configured such that, when the optical systems is used to measure aspects of a predetermined type of sample, light emitted by one of the set of launch groups 202a-202d will not reach detector groups associated with other launch groups 202a-202d. For example, in some variations a first launch group 202a is paired with a first detector group 206a, while a second launch group 202b is paired with a second detector group 206b. In these instances, the optical measurement system 202 may be configured such that the first detector group 206a is positioned so that it will receive light that is generated by the first launch group 202a but will not receive light generated by the second launch group 202b during operation of the optical measurement system 202. Similarly, the second detector group 206b is positioned so that it will receive light that is generated by the second launch group 202b but will not receive light generated by the first launch group 202a during operation of the optical measurement system 200. In this way, the two launch group-detector group pairs may simultaneously perform measurements of different portions of a sample without crosstalk. Additionally, in these variations each launch-group-detector group pair may be associated with a different emission region 108 and collection region 110 as discussed herein, or may be associated with the same emission region 108 and collection region 110.

Also shown in FIG. 2 is a controller 212, which controls operation of the optical measurement system 200 to perform the various measurements as described herein. Specifically, the controller 212 may control the light generation assembly 204 to generate and route light to one or more launch groups of the set of launch groups 202a-202d. For example, in instances where the light generation assembly 204 includes the light source unit 208 and the switch network 210, the controller 212 may control one or more light sources of the light source unit 208 to generate a selected wavelength (or wavelengths) of light. The controller 212 may further control the switch network 210 to route light received from the light source unit 208 to a selected number of the launch groups 202a-202d. The controller 212 may further control the set of detector groups 206a-206d to generate sets of output signals from some or all of the detector groups 206a-206d, where these sets of output signals represent the light received by the detector elements of the detector groups 206a-206d. These sets of output signals may be processed and analyzed to determine one or more properties of a sample. The controller 212 may include any combination of software, hardware, and firmware as needed to perform these functions (including any of the method steps described below), including, for example, one or more processors and/or application-specific integrated circuits (ASICs).

As described herein, each launch group of a photonic integrated circuit may be used to emit light from the photonic integrated circuit, which may also be emitted from an optical measurement system to perform a measurement of a sample. When the light source of the light source units described herein include coherent light sources, such as lasers, measurements performed using coherent illumination may be subject to coherent noise (also referred to herein as "speckle" noise). Specifically, the interference of coherent light as it scatters through a sample may result in spatial intensity variations of light received by a detector group that may reduce the SNR of a given measurement.

Depending on what aspect or aspects of a sample are being measured by the optical measurement system, the SNR for individual measurements at different wavelengths can be limited by different noise sources, such as a fundamental noise source or a coherent noise source. When an individual measurement at a given wavelength is limited by coherent noise, the SNR will not be improved by increasing the amount of light introduced into the sample at this wavelength. When a measurement at a given wavelength is limited by fundamental noise, the SNR may be increased by increasing the amount of light introduced into the sample for this wavelength. In these instances, it may be desirable to increase the amount of light emitted at a given wavelength beyond what a single light source is capable of generating. Depending on how light is routed in an optical measurement system, it may be difficult to generate and combine light of the same wavelength without incurring optical losses or losing the ability to individually monitor the wavelength of light generated by each light source. Accordingly, some of the optical measurement systems described herein are configured to use multiple different wavelengths to improve the output power for one or more individual measurements of an optical measurement system.

For example, when performing a spectroscopic measurement, the optical measurement systems may perform a plurality of individual measurements, each of which is associated a different emission wavelength. During an individual measurement, a launch group (e.g., one of the launch groups 202a-202d of FIG. 2) may emit light corresponding to the emission wavelength. Each launch group is associated with a corresponding set of launch sites, such that light emitted from the photonic integrated circuit 214 from a given launch group will exit the optical measurement system via each of the corresponding set of launch sites. In instances where a launch group is associated with a plurality of launch sites, light emitted from the launch group may exit the optical measurement system at multiple locations. In some of these variations, a detector group associated with the launch group may include multiple sets of detector elements, where each set of detector elements is positioned to measure light collected from a different collection region of a sampling interface. In these variations, the different sets of detector elements may use light emitted by the launch group to measure multiple different regions of a sample. For ease of discussion, each launch group will be discussed as emitting light that exits the optical measurement system via a corresponding launch site, though it should be appreciated each launch group may also emit light that exits the optical measurement system via one or more additional launch sites if so desired.

Accordingly, during an individual measurement, light of an emission wavelength may be emitted from a launch group (e.g., one of the launch groups 202a-202d of FIG. 2) that exits the optical measurement system via a corresponding launch site, and a corresponding detector group (e.g., of the detector groups 206a-206d of FIG. 2) may measure return light (e.g., light that reenters the optical measurement system after interacting with a sample) that is received while the launch group emits light. This measurement, and the resulting intensity of return light that is measured by a detector group, may be indicative of how a given sample interacts with the emission wavelength. For example, a portion of light introduced into a sample may be absorbed as it travels through the sample. The amount of light absorbed depends at least in part on the contents of the sample (e.g., the presence and concentration of different substances within the sample) and the wavelength of the light. Accordingly, the intensity of light measured during a measurement may depend at least in part on the amount of light that is introduced into the sample and the amount of light that is absorbed by the sample. Multiple measurement may be performed at different emission wavelengths, and collectively these individual measurements may be analyzed to derive one or more properties of the sample (e.g., using spectroscopic analysis techniques). The optical measurement systems may facilitate a wide range of analytical techniques as will be readily understood by one of ordinary skill in the art.

For some individual measurements, the launch group may emit light at a single wavelength. In these instances, the launch group emits light at the emission wavelength for that individual measurement. Additionally or alternatively, the optical measurement systems described herein may be configured to perform one or more individual measurements in which a launch group simultaneously emits light of multiple different wavelengths, such that the optical measurement system simultaneously emits light of these wavelengths from a launch site corresponding to the launch group. For example, an optical measurement system may be configured to simultaneously emit light from a launch site that has a pair of different wavelengths. When two wavelengths of light are simultaneously emitted from a given launch group and its corresponding launch site, the detector group measuring the return light may be unable to distinguish between the different wavelengths. Accordingly, the output signals generated by the detector group represent the collective light measured at both wavelengths.

In some instances, the wavelength difference between a pair of wavelengths may be small enough such that the pair of wavelengths may be considered as a single wavelength for the purpose of performing a spectroscopic measurement. For example, when an optical measurement system performs a measurement using a particular emission wavelength, the optical measurement system may be able to tolerate some wavelength variations as part of this measurement without meaningfully impacting the accuracy of the spectroscopic measurement. Accordingly, the optical measurement system may be configured to simultaneously emit light of two wavelengths from a launch group and its corresponding launch site during an individual measurement, where the two wavelengths are sufficiently close in wavelength to be considered a single emission wavelength for the purpose of analyzing the individual measurement.

The same principle may be applied to multiple different emission wavelengths, such that the optical measurement system may be capable emitting light at different pairs of wavelengths. In these instances, each pair of wavelengths is treated as a corresponding single emission wavelength for the purpose of performing and analyzing an individual measurement. Accordingly, the optical measurement system may perform a series of individual measurement at a plurality of different emission wavelengths, and the optical measurement system may emit light for certain emission wavelengths that actually includes two wavelengths of light (e.g., a corresponding pair of wavelengths). In order for these different pairs of wavelengths to each be treated as a single emission wavelength, the allowable spacing between each pair of wavelengths may depend on the design of the optical measurement system and the type of sample that will be measured by the optical measurement system. For example, an optical measurement system may be configured such that the two wavelengths within each pair of wavelengths are separated by less than one nanometer. By emitting a pair of wavelengths in this manner, an optical measurement system may be able to increase the optical power of light emitted during an individual measurement. Additionally, depending on the spacing between a pair of wavelengths, simultaneously emitting the pair may reduce noise associated with an individual measurement as compared to instances where a similar optical power of a single wavelength is emitted by the optical measurement system.

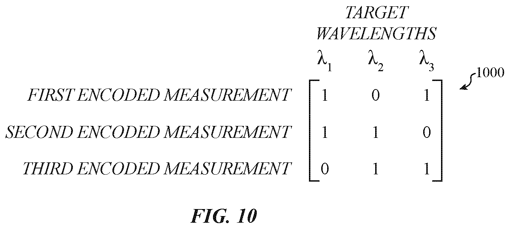

Additionally or alternatively, a spectroscopic measurement may include one or more series of encoded measurements. These series of encoded measurements, which are described in more detail herein with respect to FIGS. 10-13, may utilize measurements during which the optical measurement system emits multiple different wavelengths simultaneously. In these instances, the different wavelengths are sufficiently spaced in wavelength such that they are not considered a single emission wavelength for the purpose of analyzing these measurements. Instead, each encoded measurement is considered to include light of two or more different emission wavelengths. The encoded measurements may be analyzed to generate corresponding derived measurement intensities for the different emission wavelengths. The derived measurement intensity corresponding to an emission wavelength represents an estimate of the light measured by the optical measurement system for that emission wavelength. The optical measurement system may use a derived measurement intensity for a given measurement wavelength as if the optical measurement system had performed an individual measurement using only that emission wavelength.

As part of a spectroscopic measurement, the optical measurement system may obtain a plurality of intensities corresponding to a plurality of emission wavelengths. The relative intensities for different wavelengths may be indicative of one or more properties of the sample being measured, and thus may be analyzed using spectroscopic analysis techniques to determine one or more properties of the sample. Depending on the spectroscopic measurement, the plurality of intensities may include measured intensities (e.g., generated as part of an individual measurement during which the optical measurement system emits a single emission wavelength, which is formed from light having either a single wavelength or a pair of closely-spaced wavelengths) and/or derived measurement intensities (e.g., generated from a series of encoded measurements during which the optical measurement system emits multiple different emission wavelengths).

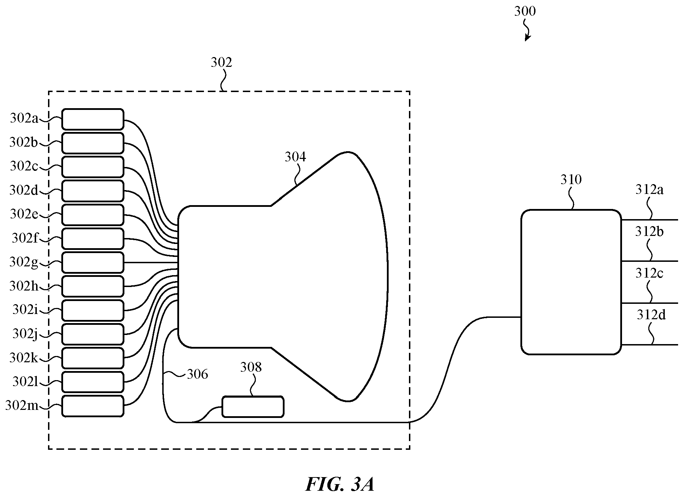

In order for a launch group of a photonic integrated circuit to simultaneously emit multiple wavelengths of light, a light source unit (e.g., light source unit 208 of FIG. 2) may be configured to simultaneously output multiple wavelengths of light. Specifically, it may be desirable for a light source unit to include a wavelength-selective multiplexer, such that multiplexer may simultaneously receive and output multiple different wavelengths of light. For example, FIG. 3A shows an example of photonic integrated circuit 300 that may be used with the optical measurement systems described herein. As shown, the photonic integrated circuit 300 includes a light source unit 301 in which an Echelle grating multiplexer 304 is configured to multiplex a plurality of inputs into a single output. In this example, the light source unit 301 includes a plurality of light sources 302a-302m, each of which is configured to generate light at a different corresponding wavelength and frequency, and the Echelle grating multiplexer 304 is configured to multiplex light received from the plurality of light sources 302a-302m into a single output 306.

For the purpose of illustration, when the light source units are described herein as having a plurality of light sources (e.g., such the light sources 302a-302m in FIG. 3A), these light sources will be labeled in a manner that represents a sequential, monotonic change in the wavelength between successively labeled light sources. In the various examples described in FIGS. 3A-3J, the light sources are labeled in a manner that represents increasing wavelength. For example, light source 302a is operable to emit light at a first wavelength that is the shortest wavelength of the wavelengths emitted by the plurality of light sources. Light source 302b is operable to emit light at a second wavelength that is longer than the first wavelength, light source 302c is operable to emit light at a third wavelength that is longer than the second wavelength, and so on. Accordingly, in the variation shown in FIG. 3A, a thirteenth light source 302m will emit light at a thirteenth wavelength that represents the longest wavelength emitted by the plurality of light sources 302a-302m.

In the light source unit 301 of FIG. 3A, each light source is optically connected to a corresponding input of the Echelle grating multiplexer 304. In this way, light emitted from a given light source of the plurality of light sources 302a-302m will be received at the corresponding input of the Echelle grating multiplexer. Because of the wavelength-dependent mapping between an input and output of an Echelle grating multiplexer, the positioning of each of the plurality of inputs will depend on the wavelength of light that it will receive (e.g., from the corresponding light source of the plurality of light sources 302a-302m). For example, a first input of the Echelle grating multiplexer 304 may receive light of the first wavelength from the light source 302a, and the first input may be positioned to maximize transmission between the first input and the output 306 for the first wavelength. Similarly, a second input of the Echelle grating multiplexer 304 may be positioned to maximize transmission of light at the second wavelength received from the light source 302b, and so on. In this way, light generated by any of the plurality of light sources 302a-302m will be routed to the first output 306.

By simultaneously operating two or more of the plurality of light sources 302a-302m to generate light, the first output 306 may include light having multiple different wavelengths. Accordingly, the photonic integrated circuit 300 may include a switch network 310 that is positioned to receive this light from the first output 306. The switch network 310 may route this light to one or more launch groups of a set of launch groups 312a-312d, thereby allowing each of these launch group to emit light that simultaneously includes multiple wavelengths. Combining these wavelengths into a single output 306 of an Echelle grating multiplexer 304 may provide a single input to the switch network 310 (which may reduce complexity associated with the switch network 310). However, a wavelength locking unit 308, such as described in more detail herein, that monitors light in the output 306 will receive all of the wavelengths of light that are carried in the output 306 at a given time, which may make it difficult to control the operation of individual light sources. Additionally, the Echelle grating multiplexer 304 may have limitations when the plurality of light sources 302a-302m is configured to emit light with pairs of wavelengths having small wavelength differences.

For a given size and configuration of an Echelle grating multiplexer 304, there may be constraints on how close two inputs waveguides may be positioned next to each other. This may similarly constrain the wavelength separation between different pairs of light sources within the plurality of light sources 302a-302m. For example, if the wavelength separation between the first and second wavelengths (generated by the first light source 302a and the second light source 302b, respectively) is sufficiently small, it may not be possible to position the first and second inputs at respective positions that would maximize transmission of both wavelengths to the output 306. In these situations, one or both of these inputs may be positioned at positions that result in increased optical loss, or the size of the Echelle grating multiplexer 304 may be increased to better facilitate placement of the first and second inputs.

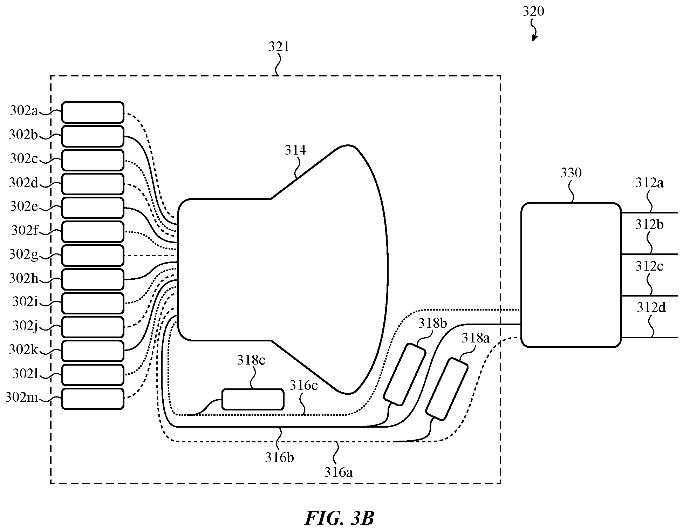

To address this, some variations of the light source units described herein include an Echelle grating multiplexer that has multiple outputs. In these variations, the light source unit may be operated to simultaneously output light having multiple wavelengths during a first period of time, such that multiple outputs of the Echelle grating multiplexer simultaneously output light. In these instances, each output may carry a different wavelength of light. For example, FIG. 3B shows a variation of a photonic integrated circuit 320 that includes a light source unit 321 that incorporates a multi-output Echelle grating multiplexer 314. Specifically, the Echelle grating multiplexer 314 that has a plurality of inputs and a plurality of outputs. The light source unit includes a plurality of light sources 302a-302m, each of which is configured to emit light at a different wavelength, such as described with respect to FIG. 3A, and is optically connected to a corresponding input of the Echelle grating multiplexer 314.

In the variation shown in FIG. 3B, the plurality of light sources 302a-302m includes a plurality of groups of light sources. Each light source within a given group of light sources is configured to emit a different corresponding wavelength and frequency of light and is optically connected to a corresponding input of the Echelle grating multiplexer 314. These inputs are positioned such that light generated by different light sources within a group of light sources is routed to different outputs of the plurality of outputs. Additionally, each group of light sources may include a plurality of light sources that generate immediately adjacent wavelengths, such that the multiplexer is not optically connected to another light source that emits light at an intervening wavelength.

For example, in the variations shown in FIG. 3B, the Echelle grating multiplexer 314 includes three outputs (e.g., a first output 316a, a second output 316b, and a third output 316c). In these instances, each group of the plurality of groups of light sources includes three light sources. For example, the plurality of light sources 302a-302m may include a first group that includes light sources 302a-302c, a second group that includes light sources 302d-302f, a third group that includes light sources 302g-302i, and a fourth group that includes light sources 302j-3021. It should be appreciated that the plurality of light sources 302a-302m may include one or more light sources (e.g., light source 302m) that is not part of a group of light sources, or is part of a group that includes only two light sources. Light generated by these light sources may still be routed to a corresponding output of the Echelle grating multiplexer 314 (e.g., the light source 302m is routed to the first output 316a of the Echelle grating multiplexer 314), and may be used to generate light as part of one or more individual measurements performed by the optical measurement systems described herein.

The plurality of inputs of the Echelle grating multiplexer 314 is positioned such that light generated by a first light source of each of the plurality of groups of light sources is routed to the first output 316a, light generated by a second light source of each of the plurality of groups of light sources is routed to the second output 316b, and light generated by a third light source of each the plurality of the light sources is routed to the third output 316c. For example, within the first group of light sources 302a-302c, light generated by a first light source 302a is routed to the first output 316a, light generated by a second light source 302b is routed to the second output 316b, and light generated by a third light source 302c is routed to the third output 316c. Similarly, within the second group of light sources 302d-302f, light generated by a first light source 302d is routed to the first output 316a, light generated by a second light source 302e is routed to the second output 316b, and light generated by a third light source 302e is routed to the third output 316c. For the purposes of illustration, inputs that are positioned to route light to a particular output of a multiplexer (such as those described herein with respect to FIGS. 3A-3J) are depicted using the same type of line (e.g., a particular dashed line or a solid line).

It should be appreciated that the relative locations of the inputs and outputs of the echelle grating multiplexer 314 (as well as the other Echelle grating multiplexers depicted in the figures) are not shown to scale. For example, if the plurality of light sources 302a-302m are configured to emit the same wavelengths in the light source unit 301 of FIG. 3A and the light source unit 321 of FIG. 3B, there will be different spacing between the inputs for a given size of the corresponding Echelle grating multiplexers 304, 314. For example, the inputs associated with the light sources 302a and 302b may be farther apart for the Echelle grating multiplexer 304 of FIG. 3A as compared to the input associated with the same light sources 302a, 302b for the Echelle grating multiplexer 314 of FIG. 3B.

By routing different light sources within a given group to different outputs of the Echelle grating multiplexer 314, these light sources may be able to emit different wavelengths having relatively small wavelength separation without needing to increase the size of the Echelle grating multiplexer 314. For example, the first and second light sources 302a, 302b of the first group may emit light having a wavelength different less than a first threshold amount, and the second and third light sources 302b, 302c of the first group may emit light having a wavelength difference less than a second threshold amount. Similarly, the first and second light sources 302d, 302e of the second group may emit light having a wavelength different less than the first threshold amount, and the second and third light sources 302e, 302f of the second group may emit light having a wavelength difference less than the second threshold amount. The first and second threshold amounts may be the same or different, and may depend on the requirements of the optical measurement system that incorporates the light source unit 321. In some variations, the first threshold amount and the second threshold amount are each one nanometer.

In some instances, such as will be described in more detail herein, it may be desirable for each of the plurality of groups of light sources to have light sources that are separated by particular frequency differences. This may facilitate routing of the various groups of light sources to the same set of outputs of the Echelle grating multiplexer. Specifically, the plurality of groups of light sources may be configured such that a first light source of each group and a second light source of each group has a first common frequency difference. For example, in the variation shown in FIG. 3B, the first and second light sources 302a, 302b of the first group may emit light at corresponding wavelengths having the first common frequency difference, the first and second light sources 302d, 302e of the second group may emit light at corresponding wavelengths having the first common frequency difference, and so on. In instances where one or more groups has a third light source, the plurality of groups of light sources may be configured such that a second light source of each group and a third light source of each group has a second common frequency difference. For example, in the variation shown in FIG. 3B, the second and third light sources 302b, 302c of the first group may emit light at corresponding wavelengths having the second common frequency difference, the second and third light sources 302e, 302f of the second group may emit light at corresponding wavelengths having the second common frequency difference, and so on. In some variations, the first common frequency difference may be the same as the second common frequency difference.

A given group of light sources may be operated such that multiple light sources within the group simultaneously generate light. In these instances, the Echelle grating multiplexer 314 may simultaneously output light at multiple outputs of the plurality of outputs 316a-316c. Using the first group of light sources 302a-302c as an example, during a first period of time the first and second light sources 302a, 302b may simultaneously generate light, during which the Echelle grating multiplexer 314 will simultaneously output light at the first and second outputs 316a, 316b. At other times, different combinations of the first group of light sources (e.g., the second and third light sources 302b, 302c, the first and the third light sources 302a, 302c, or all three light sources 302a-302c) may be simultaneously operated such that the Echelle grating multiplexer 314 simultaneously outputs light at two or more of its outputs 316a-316c. Accordingly, the light source unit 321 may be operated such that the Echelle grating multiplexer 314 (and thereby the light source unit 321) simultaneously outputs multiple wavelengths of light.

The multiple wavelengths of light may be routed to a common set of a launch groups, which may allow an optical measurement system to emit light that simultaneously includes multiple wavelengths. For example, the photonic integrated circuit 320 may include a switch network 330 that is positioned to receive light from the light source unit 321. In these instances, the switch network 330 includes three inputs. Each of the plurality of outputs 316a-316c of the Echelle grating multiplexer 314 is optically connected to a respective input of the switch network 330. Accordingly, the outputs 316a-316c of the Echelle grating multiplexer 314 may thereby act as respective outputs of the light source unit 321.

When the Echelle grating multiplexer 314 is simultaneously emitting different wavelengths of light at different respective outputs of the Echelle grating multiplexer 314, the switch network 330 may simultaneously receive the different wavelengths of light, such that each wavelength is received at a different corresponding input of the switch network 330. The switch network 330 may be configured to both i) combine the different wavelengths of light and ii) route the combined wavelengths to one or more of a set of launch groups 312a-312d. Accordingly, the one or more launch groups may each emit light that simultaneously includes multiple different wavelengths. In some variations, the switch network 330 is configured to selectively route the combined wavelengths to a target selection of the set of launch groups 312a-312d, such that different launch groups (or combinations of launch groups) receive light from the light source unit 321 at different times.

Because the light source unit 321 includes a plurality of outputs, the photonic integrated circuit 320 may include a plurality of wavelength locking units 318a-318c. For example, the photonic integrated circuit 320 may include a first wavelength locking unit 318a that is configured to monitor light traveling through the first output 316a of the Echelle grating multiplexer 314. Specifically, a portion of light travelling through the first output 316a may be tapped off and routed to the first wavelength locking unit 318a. Signals generated by the first wavelength locking unit 318a may be used (e.g., by a controller as described herein) to control a corresponding light source (e.g., a first light source of a group of light sources) that is currently being used to generate light along the first output 316a, such as described in more detail with respect to FIG. 2. Similarly, a second wavelength locking unit 318b may monitor light travelling through the second output 316b (e.g., to control a second light source of a group of light sources), and a third wavelength locking unit 318c may monitor light travelling through the second output 316c (e.g., to control a third light source of a group of light sources). By monitoring light in each of the outputs 316a-316c of the Echelle grating multiplexer 314 before the different outputs (and thereby the different wavelengths of light) are combined, the light source unit 321 may be able to individually monitor and control the light sources that are actively generating light.

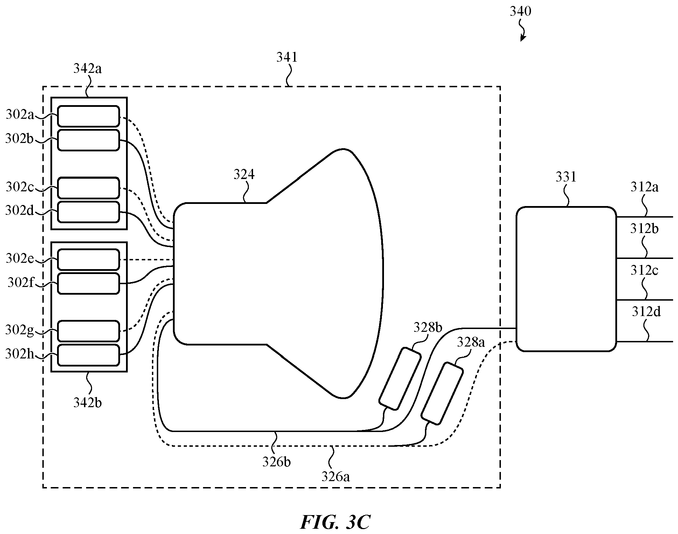

While the light source unit 321 of FIG. 3B utilizes an Echelle grating multiplexer 314 having three outputs, it should be appreciated that in other variations the Echelle grating multiplexer may instead have two or four or more outputs if so desired. For example, FIG. 3C shows a variation of a photonic integrated circuit 340 that includes a light source unit 341 that incorporates a dual output Echelle grating multiplexer 324. In these variations, the dual output Echelle grating multiplexer 324 includes a plurality of inputs and two outputs (e.g., a first output 326a and a second output 326b). The light source unit 341 includes a plurality of light sources 302a-302h, each of which is configured to emit light at a different wavelength, such as described with respect to FIG. 3B.

The plurality of light sources 302a-302h includes a plurality of groups of light sources, wherein each group of light sources includes a pair of light sources (e.g., a first light source and a second light source). Each light source within a given group of light sources is configured to emit a different corresponding wavelength and frequency of light and is optically connected to a corresponding input of the Echelle grating multiplexer 314. These inputs are positioned such that light generated by a first light source of each group is routed to the first output 326a and light generated by a second light source of each group is routed to the second output 326b.

For example, the plurality of light sources 302a-302h may include a first group that includes light sources 302a and 302b, a second group that includes light sources 302c and 302d, a third group that includes light sources 302e and 302f, and a fourth group that includes light sources 302g and 302h. It should be appreciated that the plurality of light sources 302a-302h may include one or more light sources (not shown) that is not part of a group of light sources. Light generated by these unpaired light sources may still be routed to a corresponding output (e.g., the first output 326a or the second output 326b) of the Echelle grating multiplexer 324, and may be used to generate light as part of one or more individual measurements performed by the optical measurement systems described herein.

The plurality of inputs of the Echelle grating multiplexer 324 is positioned such that light generated by a first light source of each of the plurality of groups of light sources is routed to the first output 326a and light generated by a second light source of each of the plurality of groups of light sources is routed to the second output 326b. For example, within the first group of light sources 302a-302b, light of the first wavelength generated by the first light source 302a is routed to the first output 326a and light of the second wavelength generated by the second light source 302b is routed to the second output 326b. Similarly, within the second group of light sources 302c-302d, light of the third wavelength generated by the first light source 302c is routed to the first output 326a and light of the fourth wavelength generated by a second light source 302d is routed to the second output 326b.

As with the Echelle grating multiplexer 314 of FIG. 3B, the Echelle grating multiplexer 324 of FIG. 3C may allow for pairs of light sources to emit closely spaced wavelengths without needing to increase the size of the Echelle grating multiplexer 324. For example, the first and second light sources of each group may be configured to emit light having a wavelength difference less than a threshold amount. In this way, the wavelengths emitted by light sources 302a and 302b of the first group may be separated by less than the threshold amount, the wavelengths emitted by light sources 302c and 302d of the second group may be separated by less than the threshold amount, and so on. In some variations, the threshold amount is one nanometer.

Additionally, to facilitate routing of the first and second light source of each group to the respective first and second outputs, the first and second light sources of each group may be configured to emit light having a common frequency difference. For example, the wavelengths emitted by light sources 302a and 302b of the first group may be separated by a first common frequency difference, the wavelengths emitted by light sources 302c and 302d of the second group may be separated by the first common frequency difference, and so on.

A given group of light sources may be operated such that both light sources of the group simultaneously generate light. In these instances, the Echelle grating multiplexer 324 may simultaneously output light from the first and second outputs 326a, 326b. For example, during a first period of time, the first and second light sources 302a, 302b of the first group may simultaneously generate light, in which case the Echelle grating multiplexer 324 will simultaneously output light at the first and second outputs 326a, 326b. Specifically, the first output 326a will output light at the first wavelength emitted by the first light source 302a of the first group, and the second output 326b will output light at the second wavelength emitted by the second light source 302b of the first group. Similarly, during a second period of time, the first and second light sources 302c, 302d of the second group may simultaneously generate light, in which case the first output 326a will output light at the third wavelength emitted by the first light source 302c of the second group, and the second output 326b will output light at the fourth wavelength emitted by the second light source 302d of the second group. Accordingly, the light source unit 341 may be configured to simultaneously output (via the first and second outputs 326a, 326b of the Echelle grating multiplexer 324) two wavelengths of light, and may change the two wavelengths of light by controlling different groups to emit light.

The photonic integrated circuit 340 may include a switch network 331 that is positioned to receive light from the light source unit 341. In these instances, the switch network 331 includes two inputs, each of which receive light from a corresponding output of the light source unit 341. When the light source unit 341 is operated to simultaneously output two wavelengths of light, the switch network 331 may simultaneously receive both wavelengths of light, such that each wavelength is received at a different corresponding input of the switch network 331. The switch network 331 may be configured to both i) combine the pair of wavelengths of light into a common set of waveguides and ii) route the pair of wavelengths to one or more of a set of launch groups 312a-312d. In this way, the one or more launch groups may each emit light that includes multiple wavelengths. In some variations, the switch network 331 is configured to selectively route the combined wavelengths to a target selection of the set of launch groups 312a-312d, such that different launch groups (or combinations of launch groups) receive light from the light source unit 321 at different times.

In some of these variations, the photonic integrated circuit 340 may include a first wavelength locking unit 328a and a second wavelength locking unit 328b. The first wavelength locking unit 328a may be configured to monitor light traveling through the first output 326a of the Echelle grating multiplexer 324 (e.g., to control a second light source of a group of light sources) to control a first light source of a group of light sources, and the second wavelength locking unit 328b may monitor light travelling through the second output 326b (e.g., to control a second light source of a group of light sources). In these instances, the light source unit 341 may be able to individually control each light source of a group of light sources that is actively generating light.

In instances where the light sources of a light source unit are lasers, the various light sources may be formed as part of one or more laser chips that may be incorporated into a photonic integrated circuit as part of the light source unit. As used herein, a "laser chip" refers a set of lasers that are formed on a common substrate (e.g., via epitaxial growth). Distribution of a plurality of light sources between multiple laser chip may improve yield, and may allow for improved thermal isolation between light sources that are positioned on different laser chips. The various light sources may be divided across different light source bars in any suitable manner.

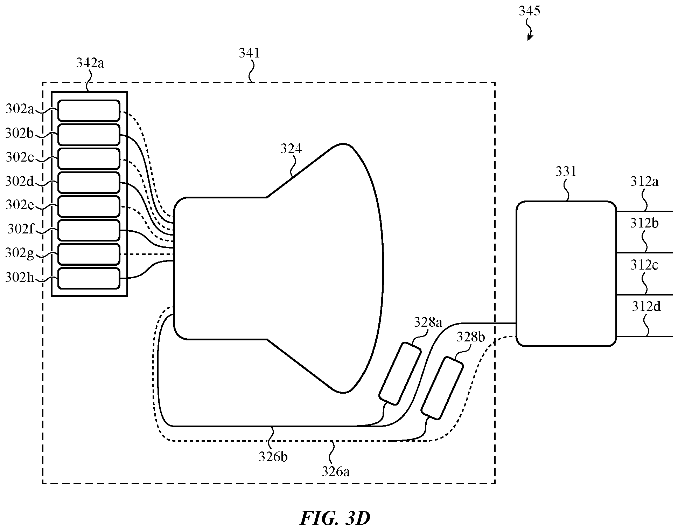

For example, in the variation of the light source unit 341 shown in FIG. 3C, the plurality of light sources 302a-302h are distributed between two laser chips (e.g., a first laser chip 342a and a second laser chip 342b). As shown there, light sources 302a-302d are positioned on the first laser chip 342a, while light source 302e-302h are positioned on the second laser chip 342b. In this instance, the first and second laser chips 342a, 342b each include four light sources. FIG. 3D shows another variation of a photonic integrated circuit 345, which may be configured the same as the photonic integrated circuit 340 of FIG. 3C except that the plurality of light sources 302a-302h of the light source unit 341 are all positioned on the first laser chip 342a. Accordingly, the first laser chip 342a in this instance includes eight light sources. Overall, the number of laser chips, as well as the distribution of the light sources between these laser chips, may depend at least in part on the overall number of light sources, the wavelengths generated by these light sources, and how the light sources are connected to the Echelle grating multiplexer 324.

Additionally, when an Echelle grating multiplexer is used to route light from a plurality of light sources to a plurality of outputs, there light sources may be connected to the Echelle grating multiplexer in any suitable manner. For example, in some variations, the light sources of a given group of light sources may be connected to immediately adjacent inputs of an Echelle grating multiplexer. Two inputs of a multiplexer are considered to be "immediately adjacent" if there are no intervening inputs to that multiplexer. For example, in the variation of the light source unit 321 shown in FIG. 3B, the first, second, and third light sources 302a-302c of the first group of light sources are connected to three immediately adjacent inputs of the Echelle grating multiplexer 314. Specifically, the first and second light sources 302a, 302b of the first group are connected to a first pair of immediately adjacent inputs, and the second and third light sources 302b, 302c of the first group are connected to a second pair of immediately adjacent inputs. Similarly, in the variation of the light source unit 341 show in FIG. 3C, the first and second light sources 302a, 302b of the first group of light sources are connected to immediately adjacent inputs of the Echelle grating multiplexer 324.

In some of these variations, the inputs of an Echelle grating multiplexer may be configured such that, for some of the groups of light sources, the wavelength associated with each input changes monotonically along a given direction. In other words, the light sources connected to the multiplexer are ordered such that light sources that emit immediately adjacent pairs of wavelengths (e.g., the multiplexer does not receive an intervening wavelength from another light source) are connected to immediately adjacent inputs.

In the variation of the light source unit 321 shown in FIG. 3B, the plurality of light sources 302a-302m are arranged such that the wavelength of light received by the echelle grating multiplexer 314 increase monotonically across the inputs. Similarly, in the variation of the light source unit 341 shown in FIG. 3C, the plurality of light sources 302a-302h are arranged such that the wavelength of light received by the echelle grating multiplexer 324 increase monotonically across the inputs. Specifically, in these variations, light source 302a (which emits the shortest first wavelength) is connected to a first input, light source 302b (which emits the next longest wavelength) is connected to a second input immediately adjacent to the first input, light source 302c is connected to a third input immediately adjacent to the second input, light source 302d is connected to a fourth input immediately adjacent to the second input, and so on. In this way, each input is positioned to receive light at a wavelength that is between the wavelengths received by both of its neighboring (e.g., immediately adjacent) inputs.

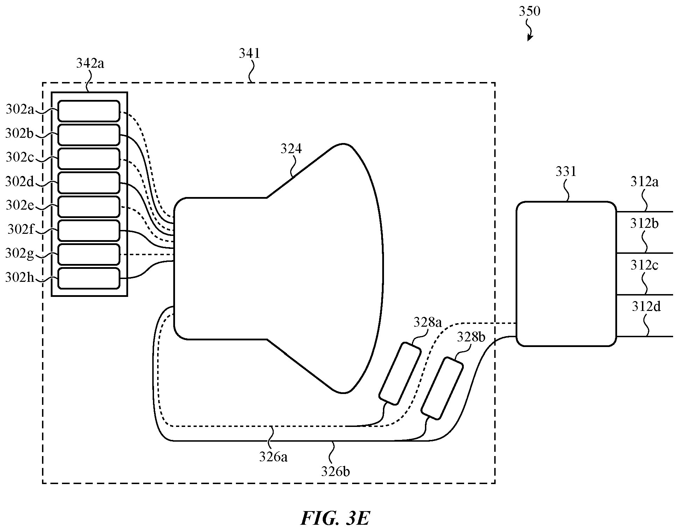

The frequency difference between the wavelengths of a given group may determine the relative spacing between the outputs of the multiplexer. For example, in the variation of the light source unit 341 shown in FIG. 3D, the first output waveguide 326a may be positioned closer to the plurality of inputs as compared to the second output 326b, such that the longer wavelength emitted by emitted by each group of light sources is routed to the second output waveguide 326b. If the common frequency difference between wavelengths emitted by each group is sufficiently small, however, the order of the outputs may switch. For example, FIG. 3E shows a variation of a photonic integrated circuit 350 that is configured the same as the photonic integrated circuit 345, except that the common frequency difference between the wavelengths emitted by each group is smaller. In these instances, the first output waveguide 326a may be positioned farther from the plurality of inputs as compared to the second output 326b. The longer wavelength emitted by emitted by each group of light sources is still routed to the second output waveguide 326b, which is instead positioned closer to the plurality of inputs as compared to the first output 326a.

In some instances, it may be desirable to change the order of light sources within a given group. For example, if the wavelength difference between different groups of light sources (e.g., between the longest wavelength generated by one light source group and the shortest wavelength generated by another light source group) is sufficiently small, it may be difficult to place the corresponding input waveguides in a manner that maximizes transmission for the light sources of both groups. Accordingly, in some variations the inputs of an Echelle grating multiplexer may be arranged such that, for some of the groups of light sources, the light sources are arranged such the wavelength of light decreases along a given direction within the light source groups, but increases along the same direction between different light source groups.

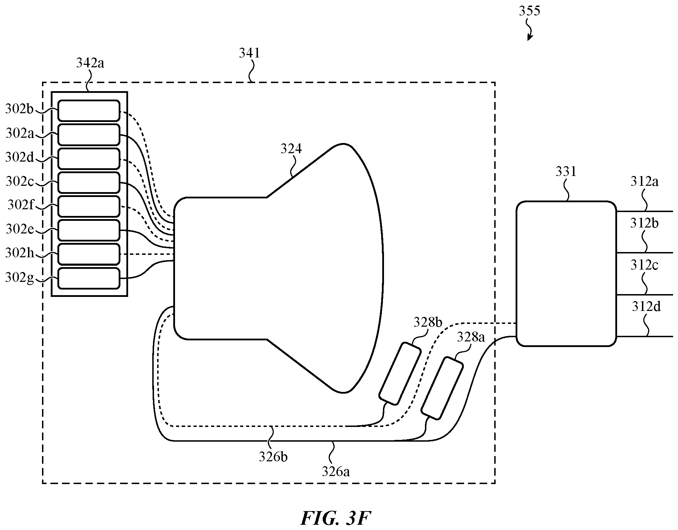

FIG. 3F shows one such example of a photonic integrated circuit 355. The photonic integrated circuit 355 may be configured the same as the photonic integrated circuit 345 of FIG. 3D, except that the order of the plurality of light sources has changed. Specifically, the plurality of light sources 302a-302h are arranged such that, in a direction from the input connected to light source 302a to the input connected to light source 302h, the wavelength of light decreases between adjacent inputs associated with light sources of the same group and increases between adjacent inputs associated with different groups.

Specifically, the second light source 302b of the first group is connected to a first input, and the first light source 302a of the first group is connected to a second input immediately adjacent to the first input. The second light source 302d of the second group is connected to a third input that is immediately adjacent to the second input, the first light source 302c of the second group is connected to a fourth input that is immediately adjacent to the third input, and so on. In this way, the second input receives light of the first wavelength, which is shorter than the wavelengths of light received at either of its immediately adjacent inputs. Similarly, the third input receives light of the fourth wavelength, which is longer than the wavelengths of light received at either of its immediately adjacent inputs. Arranging the plurality of light sources in this manner may provide for more uniform spacing between the inputs of the Echelle grating multiplexer 324.

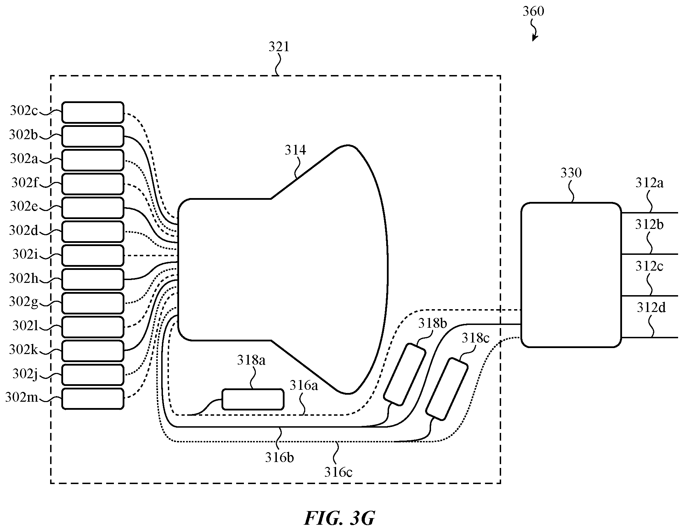

FIG. 3G shows the same principle applied to the photonic integrated circuit 320 of FIG. 3B. Specifically, FIG. 3G shows a photonic integrated circuit 360 that may be configured the same except as the photonic integrated circuit 320 of FIG. 3B, except that the order of the plurality of light sources has changed. Specifically, the plurality of light sources 302a-302m are arranged such that, in a direction from the input connected to light source 302a to the input connected to light source 302m, the wavelength of light decreases between adjacent inputs associated with light sources of the same group and increases between adjacent inputs associated with different groups.

Specifically, the third light source 302c of the first group is connected to a first input, the second light source 302b of the first group is connected to a second input immediately adjacent to the first input, and the first light source 302a of the first group is connected to a third input immediately adjacent to the second input. The third light source 302f of the second group is connected to a fourth input immediately adjacent to the third input, the second light source 302e of the second group is connected to a fifth input immediately adjacent to the fourth input, the first light source 302d of the second group is connected to a sixth input immediately adjacent to the fifth input, and so on. Accordingly, the wavelengths received by the input may sequentially decrease from the first input to third input, may increase from the third input to the fourth input, may sequentially decrease from the fourth input to the sixth input, and so on.

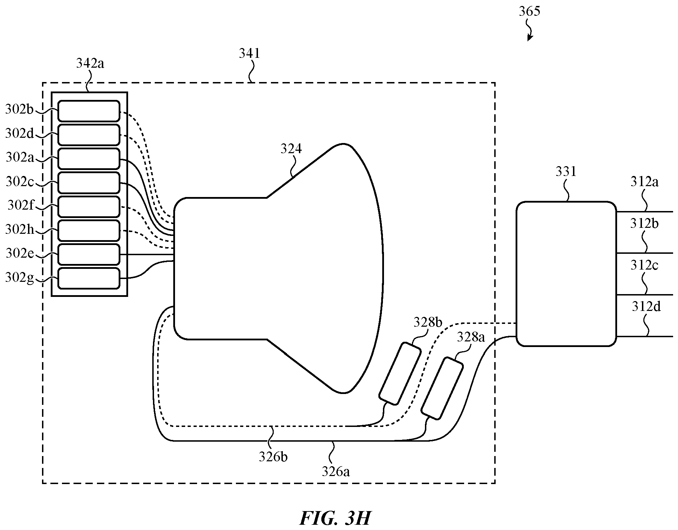

When the plurality of light sources of a light source unit are ordered as shown in FIGS. 3E and 3F, different groups of light sources may be interleaved with each other. For example, FIG. 3H shows a variation of a photonic integrated circuit 365, which may be configured the same as the photonic integrated circuit 355 of FIG. 3E except that the plurality of light sources 302a-302h of the light source unit 341 are arranged such that the first and second groups of light sources are interleaved. In these instances, the second light source 302d of the second group of light sources 302c, 302d is connected to a corresponding input that is positioned between a first pair of inputs that is connected to the first group of light sources 302a, 302b. Similarly, the first light source 302a of the first group of light sources 302a, 302b is connected to a corresponding input that is positioned between a second pair of inputs that are connected to the second group of light sources 302c, 302d.

In other words, the second light source 302b of the first group may be connected to a first input of the Echelle grating multiplexer 324, the second light source 302d of the second group may be connected to a second input that is immediately adjacent to the first input, the first light source 302a of the first group is connected to a third input that is immediately adjacent to the second input, and the first light source 302c of the second group is connected to a fourth input that is immediately adjacent to the third input. In this way, the wavelength of light received by the inputs will increase from the first to the second input, decrease from the second input to the third input, and increase from the third input to the fourth input. The third and fourth groups of light sources may be similarly interleaved as shown in FIG. 3E. Increasing the spacing between the light sources of a given group to accommodate the interleaving may result in an increased spacing between the first and second outputs 326a, 326b.

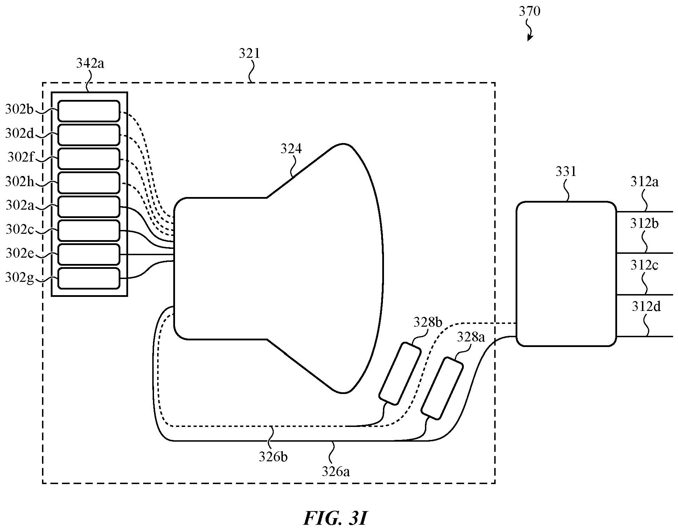

FIG. 3I shows a variation of a photonic integrated circuit 370, which may be configured the same as the photonic integrated circuit 365 of FIG. 3H except that the plurality of light sources 302a-302h of the light source unit 341 are arranged such that the first, second, third, and fourth groups of light sources are all interleaved with each other. As shown there, the second light source from each of the second, third, and fourth groups of light sources (e.g., light sources 302d, 302f, and 302h, respectively) are connected to corresponding inputs that are each positioned between a first pair of inputs that is connected to the first group of light sources 302a, 302b. Additionally, a first light source from each of the first, second, and third groups of light sources (e.g., light sources 302a, 302c, and 302e) are connected to corresponding inputs that are each positioned between a second pair of inputs that is connected to the fourth group of light sources 302g, 302h.

In other words, the second light source 302b of the first group may be connected to a first input, the second light source 302d of the second group may be connected to a second input that is immediately adjacent to the first input, the second light source 302f of the third group may be connected to a third input that is immediately adjacent to the second input, and the second light source 302h of the fourth group may be connected to a fourth input that is immediately adjacent to the third input. Similarly, the first light source 302a of the first group may be connected to a fifth input that is immediately adjacent to the fourth input, the first light source 302c of the second group may be connected to a sixth input that is immediately adjacent to the fifth input, the first light source 302e of the third group may be connected to a seventh input that is immediately adjacent to the sixth input, and the first light source 302g of the fourth group may be connected to a eighth input that is immediately adjacent to the seventh input. In this way, the wavelength of light received by the plurality of inputs may increase from the first to the fourth inputs, decrease between the fourth and the fifth inputs, and increase from the fifth to the eight inputs.

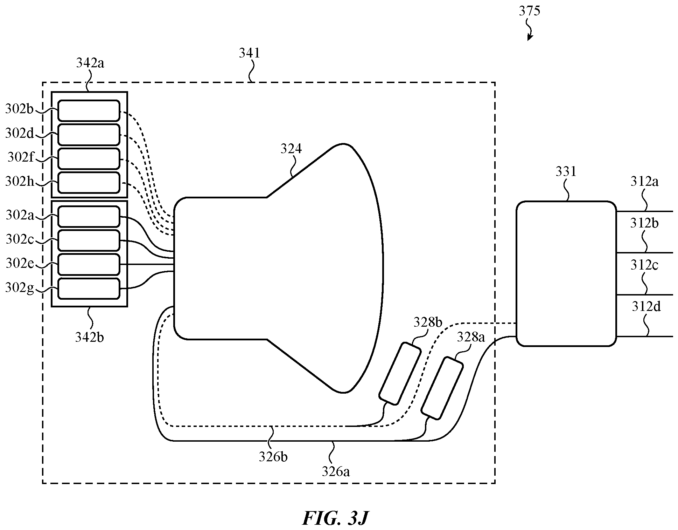

While the plurality of light sources 302a-302h are shown in FIG. 3I as being positioned on a single laser chip 342a, interleaving multiple groups of light sources may allow different light sources from a given group to be positioned on different laser chips. For example, FIG. 3J shows a variation of a photonic integrated circuit 375, which may be configured the same as the photonic integrated circuit 370 of FIG. 3I except that the plurality of light sources 302a-302h are separated between two laser chips. Specifically, the first light source from each of the first through fourth groups (e.g., light sources 302a, 302c, 302e, and 302g, respectively) are positioned on the second laser chip 342b, and the second light source from each of the first through fourth groups (e.g., light sources 302b, 302d, 302f, and 302h, respectively) are positioned on the first laser chip 342a. In instances where only one of the groups of light sources is used to generate light at a given time, only one light source will generate light on each laser chip during this time. This may reduce thermal crosstalk that may otherwise occur when multiple light sources on the laser chip are simultaneously emitting light.

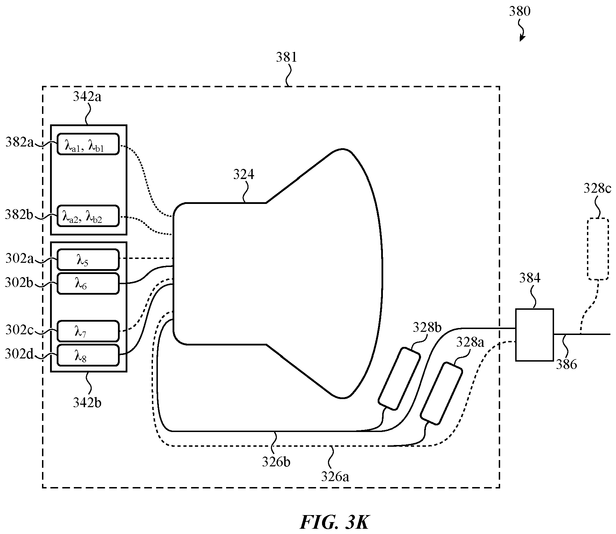

In some variations, a light source unit may include a multi-output Echelle grating multiplexer and a set of one or more tunable light sources. In these instances, a tunable light source may be operable to selectively emit multiple wavelengths of light, such that light emitted by the tunable light source may, depending on the wavelength of light currently being emitted, be routed to different outputs of the Echelle grating multiplexer. For example, FIG. 3K shows a variation of a photonic integrated circuit 380 that includes a light source unit 381. The light source unit 381 is shown in FIG. 3K as including a dual output Echelle grating multiplexer 324, such as described herein with respect to the light source unit 341 of FIG. 3C. It should appreciated the Echelle grating multiplexer 324 may include a plurality of outputs having a different number of outputs (e.g., three or four or more outputs).

The light source unit 381 includes a set of tunable light sources 382a-382b, each of which is connected to a corresponding input of the plurality of inputs of the Echelle grating multiplexer 324. The set of tunable light sources 382a-382b may include a single tunable light source or a plurality of tunable light sources. For example, in the variation shown in FIG. 3K, the set of tunable light sources 382a-382b includes a first tunable light source 382a and a second tunable light source 382b. Each tunable light source of the set of tunable light sources 382a-382b is operable to emit selectively light at a corresponding plurality of wavelengths that includes at least a first corresponding wavelength and a second corresponding wavelength. The input corresponding to each tunable light source is positioned such that i) light of the first corresponding wavelength emitted by a tunable light source of the set of tunable light sources 382a-382b is routed to a first output 326a of the Echelle grating multiplexer 324, and ii) light of the second corresponding wavelength emitted by a tunable light source of the set of tunable light sources 382a-382b is routed to a second output 326b of the Echelle grating multiplexer 324. This principle may be applied to additional outputs of the Echelle grating multiplexer 324. In some variations where the Echelle grating multiplexer 324 includes a third output (e.g., the third output 316c of the Echelle grating multiplexer 314 of FIG. 3B), the corresponding plurality of wavelengths for each tunable light source of the set of tunable light sources 382a-382b may further include a third corresponding wavelength. In these instances, light of the third corresponding wavelength emitted by a tunable light source of the set of tunable light sources 382a-382b is routed to the third output.

Each tunable light source of the set of tunable light sources 382a-382b may be operable to emit a single wavelength of light at a given moment in time, such that light generated by a given tunable light source is be routed to a single output of the Echelle grating multiplexer 324. For example, in the variation shown in FIG. 3K, the first tunable light source 382a may be tunable to selectively emit light at a corresponding plurality of wavelengths that includes at least a corresponding first wavelength λₐ₁ and a corresponding second wavelength λ_{b1}. The first tunable light source 382a may be controlled to emit light at the first wavelength λₐ₁ during a first period of time. During the first period of time, light of the first wavelength λₐ₁ is received at a first input of the Echelle grating multiplexer 324 and outputted from the first output 326a of the Echelle grating multiplexer 324. During a second period of time, the first tunable light source 382a may be controlled to emit light at the second wavelength λ_{b1}. During the second period of time, light of the second wavelength λ_{b1} is received at the first input of the Echelle grating multiplexer 324 and outputted from the second output 326b of the Echelle grating multiplexer 324. It should be appreciated that the first tunable light source 382a may be capable of emitting light at wavelengths different than the first wavelength λₐ₁ and the second wavelength λ_{b1}, but these wavelengths may not be routed to an output of the Echelle grating multiplexer 324.

Similarly, the second tunable light source 382b may be tunable to selectively emit light at a corresponding plurality of wavelengths that includes at least a corresponding first wavelength (referred to herein as a "third wavelength λₐ₂") and a corresponding second wavelength (referred to herein as a "fourth wavelength λ_{b2}"). The second tunable light source 382b may be controlled to emit light at the third wavelength λₐ₂ during a third period of time. During the third period of time, light of the third wavelength λₐ₂ is received at a second input of the Echelle grating multiplexer 324 and outputted from the first output 326a of the Echelle grating multiplexer 324. During a fourth period of time, the second tunable light source 382b may be controlled to emit light at the fourth wavelength λ_{b2}. During the fourth period of time, light of the fourth wavelength λ_{b1} is received at the second input of the Echelle grating multiplexer 324 and outputted from the second output 326b of the Echelle grating multiplexer 324.

Accordingly, in the variation shown in FIG. 3K, the light source unit 381 can generate four different wavelengths using two tunable light sources, which may reduce the number of light sources associated the light source unit 381 as compared to light source units that utilize a different light source for every wavelength outputted by the light source unit. This may reduce the number of electrical connections required to operate the light source unit 381.

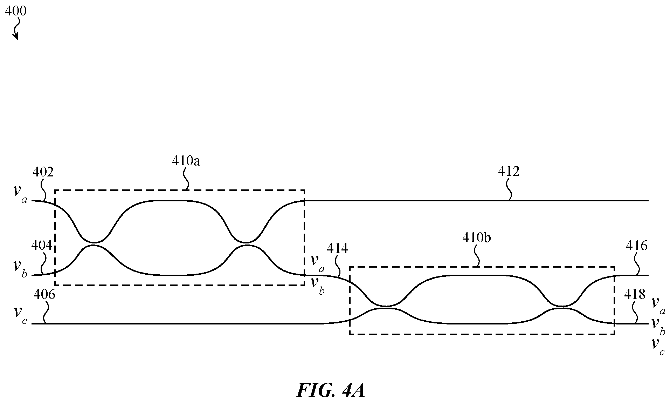

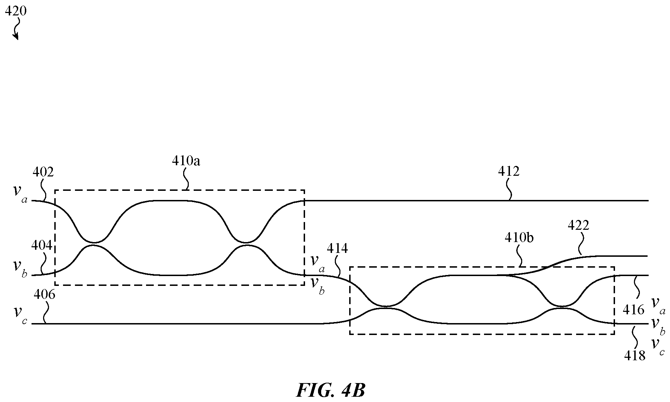

In some variations, a difference between the corresponding first wavelength and the corresponding second wavelength emitted by each tunable light sources is less than ten nanometers. Additionally or alternatively, the corresponding first and second wavelengths for each of the set of tunable light sources 382a-382b may have a common frequency difference. For example, in some variations the first wavelength λₐ₁ and the second wavelength λ_{b1} may be separated by a first frequency difference, and the third wavelength λₐ₂ and the fourth wavelength λ_{b2} may be separated by the first frequency difference. Accordingly, in some variations a passive optical combiner 384, such as described herein with respect to FIGS. 4A and 4B, may be configured to optically couple the plurality of outputs 326a-326b of the Echelle grating multiplexer 324 to a common waveguide 386. The passive optical combiner 384 may, in some variations, be part of a switch network as described herein. The switch network may be controllable to route light generated by the light source unit 381 to a target selection of a set of launch groups (e.g., the set of 312a-312d of FIG. 3B), such that different launch groups (or combinations of launch groups) receive light from the light source unit 381 at different times.

In some variations, the light source unit 381 may further include one or more additional light sources that are optically connected to the Echelle grating multiplexer 324. Each additional light source is operable to generate light at a corresponding wavelength and frequency, and is optically connected to a corresponding input of the Echelle grating multiplexer 324. These inputs are positioned such that, when each additional light source generates light at its corresponding wavelength, the Echelle grating multiplexer 324 routes that light to one of its outputs.

In some variations, the additional light sources may include one or more groups of light sources, such that light generated by different light sources within a group of light sources is routed to different outputs of the plurality of outputs. For example, the light source unit 381 is shown in FIG. 3K as including a plurality of light sources 302a-302d, such as described herein with respect to the light source unit 321 of FIG. 3B. The plurality of light sources 302a-302d may include a set of groups of light sources, where each group of light sources is operable to emit a corresponding plurality of wavelengths. Each light source within a given group of light sources is configured to emit a different corresponding wavelength and frequency of light, and is optically connected to a corresponding input of the Echelle grating multiplexer 324. These inputs are positioned such that light generated by different light sources within a group of light sources is routed to different outputs of the plurality of outputs 326a-326b. Additionally, each group of light sources may include a plurality of light sources that generate immediately adjacent wavelengths, such that the Echelle grating multiplexer 324 is not optically connected to another light source that emits light at an intervening wavelength.

For example, the plurality of light sources 302a-302d may include a plurality of groups that includes a first group that includes light sources 302a and 302b, a second group that includes light sources 302c and 302d. The plurality of inputs of the Echelle grating multiplexer 324 is positioned such that light generated by a first light source of each of the plurality of groups of light sources is routed to the first output 326a and light generated by a second light source of each of the plurality of groups of light sources is routed to the second output 326b. For example, within the first group of light sources 302a-302b, light generated by the first light source 302a at a corresponding wavelength (referred to as "fifth wavelength λ₅" for the discussion of FIG. 3K) is routed to the first output 326a and light generated by the second light source 302b at a corresponding wavelength (referred to as "sixth wavelength λ₆" for the discussion of FIG. 3K) is routed to the second output 326b. Similarly, within the second group of light sources 302c-302d, light generated by the first light source 302c at a corresponding wavelength (referred to as "seventh wavelength λ₇" for the discussion of FIG. 3K) is routed to the first output 326a and light generated by a second light source 302d at a corresponding wavelength (referred to as "eighth wavelength λ₈" for the discussion of FIG. 3K) is routed to the second output 326b. For the purposes of illustration, the input associated with each the plurality of light sources 302a-302d is depicted using the same type of line (e.g., a particular dashed line or a solid line) that is used to depict the output to which the corresponding wavelength is routed. Because light from each of the tunable light sources 382a-382b may be routed to different outputs depending on what wavelength it is currently emitting, the inputs associated with the tunable light sources 382a-382b are depicted with a different type of line that those that are used to depict the outputs 326a-326b.

In some variations, two or more light sources of a group of light sources may be operated to simultaneously emit light, such that the Echelle grating multiplexer 324 may simultaneously output light from multiple outputs. For example, during a fifth period of time, the first light source 302a and the second light source 302b of the first group of light sources 302a-302b may be operated to simultaneously emit the fifth wavelength λ₅ and sixth wavelength λ₆. The Echelle grating multiplexer 324 may receive these wavelengths at different inputs during the fifth period, and may output the fifth wavelength λ₅ from the first output 326a and output the sixth wavelength λ₆ from the second output 326b. Similarly, during a sixth period of time, the first light source 302c and the second light source 302d of the second group of light sources 302c-302d may be operated to simultaneously emit the seventh wavelength λ₇ and eighth wavelength λ₈. The Echelle grating multiplexer 324 may receive these wavelengths at different inputs during the sixth period, and may output the seventh wavelength λ₇ from the first output 326a and output the eighth wavelength λ₈ from the second output 326b.

It should be appreciated that, if desired, two or more of the tunable light sources 382a-382b may be operated to simultaneously emit light during a corresponding period of time. Additionally or alternatively, a tunable light source of the tunable light sources 382a-382b and a light source of the plurality of light sources 302a-302d may be operated to simultaneously emit light during a corresponding period of time. In these instances, the Echelle grating multiplexer 324 may simultaneously output multiple wavelengths of light. In some of these variations, the multiple wavelengths may be emitted as part of a series of encoded measurements as described in more detail herein.

It should also be appreciated that, in variations where the Echelle grating multiplexer 324 includes a plurality of outputs that includes three or more outputs, different tunable light sources and/or groups of light sources may be operated to route light to different subsets of the plurality of outputs. For example, in some variations the first tunable light source 382a may be operable to selectively emit different wavelengths that are routed to a first subset of the outputs of the Echelle grating multiplexer 324 (e.g., a first corresponding wavelength generated by the first tunable light source 382a may be routed to a first output of the Echelle grating multiplexer 324 and a second corresponding wavelength generated by the first tunable light source 382a may be routed to a second output of the Echelle grating multiplexer 324). Conversely, the second tunable light source 382b may be operable to selectively emit different wavelengths that are routed to a different second subset of the outputs of the Echelle grating multiplexer 324 (e.g., a first corresponding wavelength generated by the second tunable light source 382b may be routed to the second output of the Echelle grating multiplexer 324 and a second corresponding wavelength generated by the second tunable light source 382b may be routed to a third output of the Echelle grating multiplexer 324).

Additionally or alternatively, one or more tunable light sources (e.g., the set of tunable light sources 382a-382b) may each be operable to select a corresponding plurality wavelengths that are routed to a first subset of the outputs of the Echelle grating multiplexer 324, and one or more groups of the plurality of light sources 302a-302d may each generate light that is routed to a different second subset of outputs of the Echelle grating multiplexer 324. For example, the first tunable light source 382a may be operable to generate a corresponding plurality of wavelengths that are routed to the first subset of outputs (e.g., a first corresponding wavelength generated by the first tunable light source 382a may be routed to a first output of the Echelle grating multiplexer 324 and a second corresponding wavelength generated by the first tunable light source 382a may be routed to a second output of the Echelle grating multiplexer 324). Conversely, a first group of light sources (e.g., the first group of light sources 302a-302b) may be configured such that light generated by a first light source of the first group (e.g., light source 302a) is routed to the second output of the Echelle grating multiplexer 324 and light generated by a second light source of the first group (e.g., light source 302b) is routed to a third output of the Echelle grating multiplexer 324.

It should also be appreciated that the various light sources associated with the Echelle grating multiplexer 324 may distributed across any number of laser chips as may be desired. In instances where the light source unit includes a plurality of tunable light sources optically connected to the Echelle grating multiplexer 324, the plurality of tunable light sources may be positioned on a single laser chip or distributed between multiple laser chips. When the light source unit includes a set of tunable light sources and one or more additional light sources, these light sources may be positioned on a single laser chip or distributed between multiple laser chips. For example, in the variation shown in FIG. 3K, the set of tunable light sources 382a-382b is positioned on a first laser chip 342a and the plurality of light sources 302a-302d is positioned on a second laser chip 324b.

In some variations, the photonic integrated circuit 380 includes one or more wavelength locking units that are used to monitor light generated by the light source unit 381. In some variations, the photonic integrated circuit 380 includes a plurality of wavelength locking units, wherein each wavelength locking unit is configured to monitor light traveling through a corresponding output of the Echelle grating multiplexer 324. For example, in the variation shown in FIG. 3K, the photonic integrated circuit 380 may include a first wavelength locking unit 328a and a second wavelength locking unit 328b, such as described in more detail with respect to the photonic integrated circuit 340 of FIG. 3C. In these instances, the first wavelength locking unit 328a and the second wavelength locking unit 328b may be simultaneously operated to control light sources that are simultaneously emitting light that is respectively routed to the first output 326a and the second output 326b of the Echelle grating multiplexer 324.

In some variations where the light source unit 381 is operated to output a single wavelength of light from the Echelle grating multiplexer 324 at a given time, the photonic integrated circuit 380 may include a single wavelength locking unit 328c (e.g., instead of the first wavelength locking unit 328a and the second wavelength locking unit 328b). The wavelength locking unit 328c may be configured to monitor light outputted by the Echelle grating multiplexer 324 regardless of which output waveguide is currently emitting light. For example, in the variation shown in FIG. 3K, the wavelength locking unit 328c may be positioned to monitor light traveling through the common waveguide 386 (e.g., after it has been combined by the passive optical combiner 384). In other variations, the wavelength locking unit 328c may be positioned to monitor light traveling through the passive optical combiner 384, such as described herein with respect to FIG. 4B. During certain periods of time, the wavelength locking unit 328c may monitor light that is routed to the first output 326a of the Echelle grating multiplexer 324, such that a controller may control the wavelength of light generated by a corresponding light source during these periods. During other periods of time, the wavelength locking unit 328c may monitor light that is routed to the second output 326b of the Echelle grating multiplexer 324, such that a controller may control the wavelength of light generated by a corresponding light source during these periods.

When a switch network of an optical measurement system is configured to simultaneously receive multiple wavelengths of light across different inputs, it may be desirable to combine these wavelengths into a common set of waveguides. For example, in some variations, a photonic integrated circuit as described herein may be configured to include a passive optical combiner that combines the outputs of a light source into a single waveguide without needing to be actively controlled. The passive optical combiner may be included as part of a switch network, such that additional components downstream of the passive optical combiner may receive light from the light source unit along a single waveguide. FIG. 4A shows one such variation of a passive optical combiner 400. The passive optical combiner 400 may include a first input 402, a second input 404, and third input 406. The first, second, and third inputs 402, 404, 406 may each be optically connected to a respective outputs of a light source unit.

Specifically, the first input 402 may receive first light having a first frequency *vₐ*, the second input 404 may receive second light having a second frequency *v_{b}*, and the third input 406 may receive third light having a third frequency *v_{c}*, and may combine the first, second, and third light into a single output of the passive optical combiner 400. The first and second inputs 402, 404 may be connected to corresponding inputs a first interferometer 410a. The first interferometer 410a, which in the passive optical combiner 400 of FIG. 4A is configured as a Mach-Zehnder interferometer, has a first output 412 and a second output 414. The first interferometer 410a may have a first free spectral range Δv*₁* that is selected such that light of the first frequency *vₐ* that is received at the first input 402 will be routed to the second output 414 of the first interferometer 410a. Additionally, the first free spectral range Δv*₁* is selected such that light of the second frequency *v_{b}* that is received at the second input 404 will be routed to the second output 414 of the first interferometer 410a. In this way, the first interferometer 410a may route the first and second light to a common waveguide (e.g., the second output 414 of the first interferometer 410a).

Additionally, the third input 406 of the passive optical combiner 400 and the second output 414 of the first interferometer 410a may be connected to corresponding inputs of a second interferometer 410b. The second interferometer 410b, which in the passive optical combiner 400 of FIG. 4A is configured as a Mach-Zehnder interferometer, has a first output 416 and a second output 418. Accordingly, the first output 412 of the first interferometer 410a, the first output 416 of the second interferometer 410b, and the second output 418 of the second interferometer 410b form respective first, second, and third outputs of the passive optical combiner 400. The second interferometer 410b may have a second free spectral range Δ*v₂* that is selected such that light of each of the first and second frequencies *vₐ, v_{b}* (when received from the second output 414 of the first interferometer 410a) will be routed to the second output 418 of the second interferometer 410b. Additionally, the first free spectral range Δ*v₂* is selected such that light of the third frequency *v_{c}* that is received by the second interferometer 410b via the third input 406 will be routed to the second output 418 of the second interferometer 410b. In this way, light received at any or all of the first, second, and third inputs 402-406 and having the respective frequencies *vₐ*-*v_{c}* will be routed to a common output (e.g., output 418).

In some instances, to allow the second interferometer 410b to route light of both the first and second frequencies *vₐ*, *v_{b}* to output 418, the first and second free spectral ranges Δ*v₁*, Δ*v₂* may be selected such that a ratio of these free spectral ranges (e.g., Δ*v₁*/Δ*v₂*) is an even integer. In these instances, the third frequency *v_{c}* may be evenly spaced between the first and second frequencies *vₐ, v_{b}.* Accordingly, the first and third frequencies may be separated by a first frequency difference, and the second and third frequencies may also be separated by the first frequency difference.

For example, the passive optical combiner 400 may be incorporated into the photonic integrated circuit 320 of FIG. 3C, the first input 402 may be positioned to receive light from the first output 316a of the Echelle grating multiplexer 314, the second input 404 may be positioned to receive light from the third output 316c of the Echelle grating multiplexer 314, and the third input 406 may be positioned to receive light from the second output 316b of the Echelle grating multiplexer 314. Accordingly, a two or more light sources of a given group of light sources may be simultaneously controlled to generate different wavelengths of light. If the frequencies generated by these light sources correspond to the three frequencies *vₐ*-*v_{c}* of the passive optical combiner 400, passive optical combiner 400 will combine the different wavelengths of light to a common output 418.

It should be appreciated that there may be multiple sets of frequencies that, assuming a first common frequency difference and a second common frequency difference between the frequencies (such as described herein with respect to FIG. 3B), will be routed by the passive optical combiner 400 to a common output 418. Accordingly, the passive optical combiner 400 may be used to combine light generated by multiple different groups of light sources of a given light source unit (e.g., the light source unit 321 of FIG. 3B). Once the passive optical combiner 400 has combined multiple wavelengths into a single output (e.g., a single waveguide), a switch network incorporating the passive optical combiner 400 may include one or more switches that are configured to route the combined wavelengths of light to one or more launch sites.

In some variations, the passive optical combiner 400 may be configured to tap a portion of light received by the passive optical combiner 400, which may be received by a wavelength locking unit as described herein. For example, FIG. 4B shows a variation of a passive optical combiner 420, which may be configured and labeled the same as the passive optical combiner of FIG. 4A except that the passive optical combiner 420 includes a tap 422 that is positioned to tap light from a waveguide of the second interferometer 410b. Specifically, the tap 422 may be positioned such that it receives a portion of the light received by the second interferometer 410b, regardless of whether the light is received by the second output 414 of the first interferometer 410a or the third input 406.

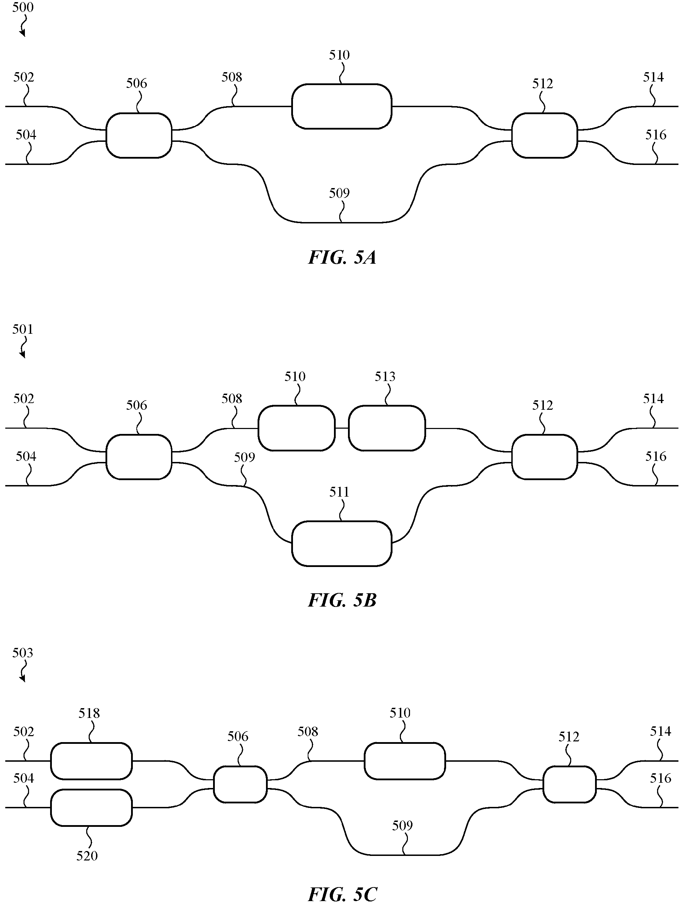

In other variations, it may be desirable to provide a single optical component that acts to both i) combine multiple wavelengths of light and ii) selectively routes the combined light to different outputs. For example, FIG. 5A shows a schematic view of a multiplexing photonic switch 500 suitable for use with the photonic integrated circuits described herein. The multiplexing photonic switch 500 is configured to receive different wavelengths of light at respective inputs of the multiplexing photonic switch 500 and selectively send both wavelengths to a common set of outputs of the multiplexing photonic switch 500. Specifically, the multiplexing photonic switch 500 is configured to receive two wavelengths of light having a predetermined frequency difference.

The multiplexing photonic switch 500 includes two inputs (e.g., first input 502 and a second input 504) and two outputs (e.g., first output 514 and a second output 516), each of which may be formed as a corresponding waveguide. The multiplexing photonic switch 500 may be incorporated into a photonic integrated circuit, such as those described herein, such that the multiplexing photonic switch 500 is positioned to concurrently receive light having a first wavelength at the first input 502 and light having a second wavelength at the second input 504, where the first frequency and the have a predetermined frequency difference.

The multiplexing photonic switch 500 includes a first coupler 506, and a second coupler 512. Each of these couplers may include any suitable coupler that is capable of splitting light received at one or more inputs between two outputs, including, but not limited, to multimode interferometer couplers, adiabatic couplers, co-directional couplers, or the like. The first coupler 506 is optically connected to the second coupler 512 via a pair of waveguides. Specifically, a first waveguide 508 (also referred to herein as a first leg) connects a first output of the first coupler 506 to a first input of the second coupler 512, and a second waveguide 509 (also referred to herein as a second leg) connects a second output of the first coupler 506 to a second input of the second coupler 512. The first and second waveguides 508, 509 may have different lengths, such that light traveling between the first and second couplers 506, 512 travel a different path length. This path length difference Δl may at least partially define a free spectral range of the multiplexing photonic switch 500. The free spectral range of the multiplexing photonic switch 500 may be selected based on the predetermined frequency. Specifically, the free spectral range is selected such that, if light of two wavelengths having the predetermined frequency difference is introduced into different inputs of the multiplexing photonic switch 500, they will be routed to a common selection of outputs of the multiplexing photonic switch 500.

The multiplexing photonic switch 500 includes a first phase shifter 510 that is positioned on the first waveguide 508 and is operable to change the phase of light traveling through the first waveguide 508. The first phase shifter 510 may be controllable to selectively route the first and second wavelengths between a common selection of outputs of the multiplexing photonic switch 500. For example, the multiplexing photonic switch 500 may be configured such that, when the first phase shifter 510 is not actively changing the phase of light in the first leg (e.g., providing a phase shift of 0), the first wavelength of light received at the first input 502 will be routed to the second output 516 and the second wavelength of light received at the second input 504 will also be routed to the second output 516. In this way, when the first and second wavelengths are received simultaneously at the inputs 502, 504, both wavelengths are simultaneously routed to a first common selection of the outputs (e.g., the second output 516).

The first phase shifter 510 may be operated to apply a phase shift to light travelling through the first waveguide 508, which may change the common selection of the common selection of the outputs. Assuming the predetermined frequency difference is sufficiently small, the first phase shifter 510 will provide a nearly identical phase shift to light of the first and second wavelengths. In this way, changing the phase shift provided by the first phase shifter 510 will similarly change how light of each wavelength is routed between the outputs. In some variations, the frequency difference may be selected such that, for any pair of wavelengths simultaneously routed by the multiplexing photonic switch 500, the first and second wavelengths are separated by less than one nanometer.

For example, the first phase shifter 510 may provide a phase shift of π to light traveling through the first waveguide 508, in which instance light of the first wavelength received at the first input 502 will be routed to the first output 514 and light of the second wavelength received at the second input 504 will also be routed to the second output 516. Accordingly, by changing the amount of phase shift provided by the first phase shifter 510 (e.g., between 0 and π), the first phase shifter 510 may at least partially control what outputs or outputs are currently selected as the common selection of outputs.

Accordingly, the multiplexing photonic switch 500 may be controllable to selectively change the common selection of outputs, which in turn will control where the first and second wavelengths of light are routed. The number of different phase shifts that may be applied by the first phase shifter 510 may at least partially determine the candidate outputs to which the first and second wavelengths of light may be routed. For example, the first phase shifter 510 may be configured to have two states (e.g., an "off" state in which the phase shifter applies a first phase shift, such as a zero phase shift, and an "on" state in which the phase shifter applies a second phase shift, such as a phase shift of π). In these instances the first phase shifter 510 may be operated to change the multiplexing photonic switch 500 between two different common selections of outputs (e.g., from the first output 514 to the second output 514). In other instances, the first phase shifter 510 may be controllable to provide a wider range of possible phase shifts, which may allow the phase shifter 510 to change the multiplexing photonic switch 500 between three of more different common selections of outputs.

In some instances the multiplexing photonic switch 500 may be controllable to select one or more common selections of outputs that include a single output (e.g., either the first output 514 or the second output 516). Additionally or alternatively, the multiplexing photonic switch 500 may be controllable to select one or more common selections of outputs that include both outputs, such that light is split between the first and second output 514, 516 according to a splitting ratio. In some of these variations, the multiplexing photonic switch 500 may be controllable to change the splitting ratio. In these instances, changing the splitting ratio is considered changing the common selection of outputs. It should be appreciated that while the multiplexing photonic switch 500 is designed to simultaneously route light having two different wavelengths, it may be appreciated that the multiplexing photonic switch 500 may also be operable to route a single wavelength of light received that is received at either the first input 502 or the second input 504.

In some instances, the multiplexing photonic switch 500 may be designed to have a first common selection of outputs when the first phase shifter 510 is not actively being operated. Fabrication tolerances, however, may cause slight deviations from the intended first common selection of outputs. For example, in instances where the first common selection is designed to be a single output (e.g., both the first wavelength and the second wavelengths are routed to the second output 516 when the first phase shifter 510 is not actively being operated), the multiplexing photonic switch 500 as manufactured may actually split a small portion of the first and/or second wavelengths to the other output. In these instances, it may be desirable to provide an additional phase adjustment to correct for this.

As a non-limiting example, a variation of a multiplexing photonic switch 500 may be designed such that the first phase shifter 510 will provide a phase shift of changes between 0 and π, such that a phase shift of 0 will route the two wavelengths to a first common selection of outputs and a phase shift of π will route the two wavelengths to a second common selection of outputs. When manufactured, there may be a positive or negative phase error between the legs. As an example of a negative phase error, a phase shift of 0.05*π (instead of 0) may be required to route the two wavelengths to the first common selection outputs and a phase shift 1.05*π (instead of π) to route the two wavelengths to the second common selection outputs. For a positive phase error of the same magnitude, a phase shift of -0.05*π is instead required to route the two wavelengths to the first common selection outputs and a phase shift 0.95*π is required to route the two wavelengths to the second common selection outputs. Because phase shifters are generally not able to provide both a positive phase shift and a negative phase shift, this may require the first phase shifter 510 to provide a 1.95*π phase shift to route the two wavelengths to the first common selection outputs, which may increase power consumption and/or optical loss associated with operation the first phase shifter 510.

In some variations, if the range of fabrication tolerances are known in advance, the path length difference Δl between the legs may be slightly adjusted, such that a single phase shifter 510 is able to account for the maximum possible positive and negative phase errors with a smaller average phase shift. Using the non-limited example above, the path length difference Δl may be selected such that the phase shifter 510 may be controlled to provide 0 and π phase in instances where manufacturing results in the maximum positive phaser error and may be controlled to provide 0.1 and 1.1*π phase shifts when manufacturing results in the maximum negative phase error. In other variations, such as when the range of fabrication tolerances is not known in advance, the multiplexing photonic switch may include a second phase shifter that may be operated to account for fabrication tolerances. For example, FIG. 5B shows a variation of a multiplexing photonic switch 501, which may be configured the same as the multiplexing photonic switch 500 of FIG. 5B, except that the multiplexing photonic switch 501 includes a second phase shifter 511 and a third phase shifter 513. In some variations, the second phase shifter 511 may be positioned on the second waveguide 509, such that the second phase shifter 511 is operable to change a phase of light traveling through the second waveguide 509.

For example, during operation of the multiplexing photonic switch 501, the first phase shifter 510 may apply a first phase shift to light traveling through the first waveguide 508 to change the common selection of outputs. If the multiplexing photonic switch 501 is manufactured with a positive phase error, the second phase shifter 511 may apply a second phase shift to the second leg 509 that may account for this positive phase error. Conversely, if the multiplexing photonic switch 501 is manufactured with a negative phase error, the first phase shift may be adjusted to account for this negative phase error. In some of these variations, the multiplexing photonic switch 501 may not include the third phase shifter 513.

Alternatively, in other variations the third phase shifter 513 is positioned in the same leg as the first phase shifter 510. In these instances, the first phase shifter 510 may provide the first phase shift to control the common selection of the outputs, and the third phase 513 shifter may provide a smaller third phase shift that corrects for any negative phase error. This may simplify the design of the first phase shifter, but requires the addition of another phase shifter. Each phase shifter of the multiplexing photonic switches described herein may include any suitable type of phase shifter, such as, for example, a thermo-optic phase shifter, a carrier-based phase shifter, an optomechanical phase shifter, or the like. When a multiplexing photonic switch as described herein includes multiple phase shifters, some or all of the phase shifters may be the same type, or each phase shifter may be a different type.

Because the phase shift provided by the first phase shifter 510 is slightly different for the first wavelength and the second wavelength, there may be some level of optical loss associated with combining the first and second wavelengths into a common selection of outputs. In other words, the first phase shifter 510 may not be able to, when operated to provide a non-zero phase shift, provide a phase shift that results in identical routing between the first and second wavelengths to the common set of inputs. In some variations, it may be desirable to balance this loss between the first and second wavelengths. This may be advantageous in instances where it is important for the multiplexing photonic switches described herein to output the first and second wavelengths with equal power. For example, during a series of encoded measurement such as described herein, it may be desirable to maintain a predetermined power ratio between wavelengths that are simultaneously emitted as part of a given encoded measurement.

For example, in some variations the path length difference Δl between the legs may be adjusted such that there will always be a predetermined amount loss associated with combining the first and second wavelengths, regardless of whether the first phase shifter 510 (or any other phases shifters positioned on the legs of the multiplexing photonic switch 500) is actively applying a non-zero phase shift. In these instances, when the multiplexing photonic switch 500 is combining light into a given common selection of outputs, an additional phase shift may be applied (e.g., by the first phase shifter 510 or another phase shifter positioned on a leg of the multiplexing photonic switch 500) to control whether the predetermined amount of loss is experience by the first wavelength, the second wavelength, or is split between the first and second wavelength. Such an arrangement may not require any additional components, but the multiplexing photonic switch 500 will experience the predetermined amount of loss regardless of whether power balancing between the first and second wavelengths is currently needed.

In other instances, the multiplexing photonic switch 500 may include one or more variable optical attenuators connected to one or both of the inputs 502, 504 of the multiplexing photonic switch. For example, FIG. 5C shows a variation of a multiplexing photonic switch 503, which may be configured the same as the multiplexing photonic switch 500 of FIG. 5A except that the multiplexing photonic switch 503 includes a first variable optical attenuator (VOA) 518 and a second VOA 520. The first VOA 518 is optically connected to the first input 502 of the multiplexing photonic switch 503, and may be controlled to selectively attenuate light of the first wavelength received by the first input 502. Similarly, the second VOA 520 is optically connected to the second input 504 of the multiplexing photonic switch 503. The second VOA 520 may be controlled to selectively attenuate light of the second wavelength received by the second input 504. While the multiplexing photonic switch 503 is configured in FIG. 5C as having both the first and second VOAs 518, 520, in some variations the multiplexing photonic switch 503 may the first VOA 518 but not the second VOA 520 (or vice versa), depending on how the multiplexing photonic switch 503 may be used in an optical measurement system.

Accordingly, the first VOA 518 and/or the second VOA 520 may be controlled at a given time to induce optical loss in the first and/or second wavelength, respectively. Accordingly, when a phase shift applied by the phase shifter(s) of the multiplexing photonic switch 503 creates a relative loss in one wavelength of light received at one input, the VOA corresponding to the other input may be activated to cause a corresponding loss in the other wavelength of light. For example, the first VOA 518 may be operated to create a loss in the first wavelength of light in instances where a phase shift in the legs causes a loss in the second wavelength. Accordingly, the first and second VOAs 518, 520 may be used to balance power between the first and second wavelengths, but may also remain inactive in instances when power balancing is not needed. In this way, the multiplexing photonic switch 521 may be operated to prioritize minimizing loss in these instances.

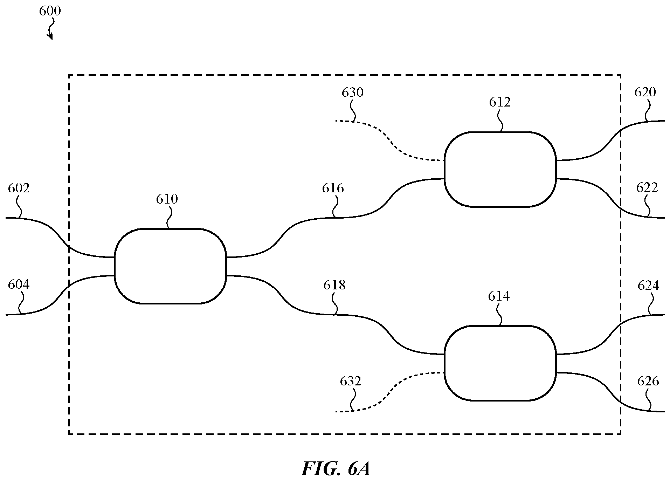

The multiplexing photonic switches described with respect to FIGS. 5A-5C may be incorporated into a photonic integrated circuit as described herein, and may be used to simultaneously route two wavelengths of light. For example, one or more of these multiplexing photonic switches may be incorporated into one or more of the switch networks described herein with respect to FIGS. 3B-3I. FIG. 6A shows one such example of a switch network 600 that incorporates a multiplexing photonic switch 610, which may be configured in any manner such as described with respect to the multiplexing photonic switches 500, 501, and 521 of FIGS. 5A-5C.

The switch network 600 may include a plurality of inputs and a plurality of outputs. The plurality of inputs may be optically connected to corresponding outputs of a light source unit (not shown), and the plurality of outputs may be optically connected to a corresponding plurality of launch groups. In the variation shown in FIG. 6A, the switch network has two inputs (e.g., a first input 602 and a second input 604) and four outputs (e.g., a first output 620, a second output 622, a third output 624, and a fourth output 626). The first input 602 may be optically connected to a first output of a light source unit, and the second input 604 may be optically connected to a second output of the light source unit. The light source unit may simultaneously output a first wavelength of light along its first output and a second wavelength of light along its second output, such as described herein with respect to the light source units of FIGS. 3B-3K. In this way, the switch network 600 may simultaneously receive the first wavelength of light at its first input 602 and the receive the second wavelength of light at its second input 604.

Similarly, each output is optically connected to a different launch group (e.g., the first output 620 is optically connected to a first launch group, the second output 622 is optically connected to a second launch group, the third output 624 is optically connected to a third launch group, and the fourth output 626 is optically connected to a fourth launch group). The switch network 600 may be controlled selectively route the first and second wavelengths to a common selection of the plurality of outputs. In this way, when the switch network 600 simultaneously receives the first and second wavelengths at its respective first and second inputs 602, 604, and each launch group that receives light from the switch network will receive and emit light that simultaneously includes both the first and second wavelengths.

To route the light between the plurality of inputs and the plurality of outputs, the switch network 600 includes the multiplexing photonic switch 610, a first controllable switch 612, and a second controllable switch 614. The multiplexing photonic switch 610 may be configured in any manner as described with respect to the multiplexing photonic switches of FIGS. 5A-5C. The inputs 602, 604 of the switch network may form the inputs of the multiplexing photonic switch 610. A first waveguide 616 optically connects a first output of the multiplexing photonic switch 610 to a first input of the first controllable switch 612, and a second waveguide 618 optically connects a second output of the multiplexing photonic switch 610 to a first input of the second controllable switch 614. The first and second controllable switches 612, 614 may be any suitable photonic switch that is able selectively route light received at an input between one or both a set of outputs.

The multiplexing photonic switch 610 is operable to selectively control whether light of the first and second wavelengths are routed to the first controllable switch 612, the second controllable switch 614, or split between the first controllable switch 612 and the second controllable switch 614. For example, during a first period of time, the multiplexing photonic switch 610 may be controlled to route both the first and second wavelengths to the first controllable switch 612. During this time, the multiplexing photonic switch 610 will output the first and second wavelengths simultaneously along the first waveguide 616. The first controllable switch 612 may selectively route the first and second wavelengths to either the first output 620 (which is optically connected to a first output of the first controllable switch 612), the second output 622 (which is optically connected to a second output of the first controllable switch 612), or split between the first and second outputs 620, 622. In this way, the switch network 600 may be controlled to route the first and second wavelengths simultaneously to the first launch group, simultaneously to the second launch group, or simultaneously split both wavelengths between the first and second launch groups. It should be appreciated that the first controllable switch 612 may include a second input 630 that may be configured to receive light from a different portion the switch network 600 (e.g., from a second multiplexing photonic switch).

Similarly, during a second period of time, the multiplexing photonic switch 610 may be controlled to route both the first and second wavelengths to the second controllable switch 612. During this time, the multiplexing photonic switch 610 will output the first and second wavelengths simultaneously along the second waveguide 618. The second controllable switch 614 may selectively route the first and second wavelengths to either the third output 624 (which is optically connected to a first output of the second controllable switch 614), the fourth output 626 (which is optically connected to a second output of the second controllable switch 614), or split between the third and fourth outputs 624, 626. In this way, the switch network 600 may be controlled to route the first and second wavelengths simultaneously to the third launch group, simultaneously to the fourth launch group, or simultaneously split both wavelengths between the third and fourth launch groups. It should be appreciated that the second controllable switch 614 may include a second input 632 that may be configured to receive light from a different portion the switch network (e.g., from a second multiplexing photonic switch).

In still other instances, the multiplexing photonic switch 610 may be controlled to split the first and second wavelengths simultaneously between the first and second waveguides 616, 618. In these instances, the first and second controllable switches 612, 614 may be controlled to route the first and second wavelengths to two or more of the outputs (e.g., one or both of the first and second outputs 620, 622 and one or both of the third and fourth outputs 624, 626. It should also be appreciated that the switch network may be capable of routing light having different pairs of wavelengths (e.g., having the same common frequency different) at different times. In these instances, the first and second controllable switches 612, 614 may each be adjustable to account for the different wavelengths received by each switch at different times.

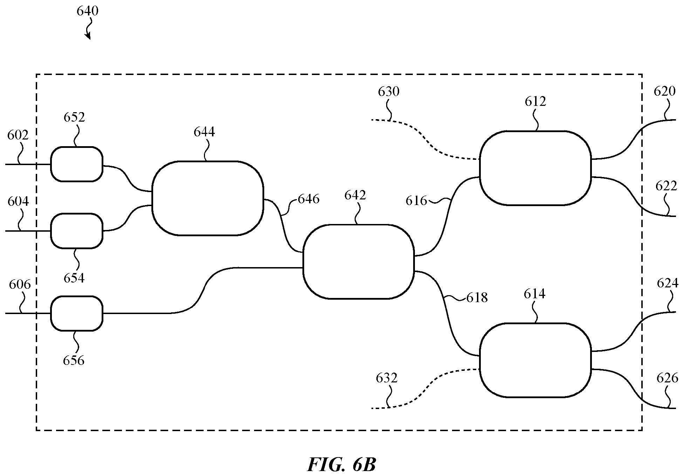

FIG. 6B shows another variation of a switch network 640 that includes three inputs (e.g., a first input 602, a second input 604, and a third input 604) and a plurality of outputs (e.g., the four outputs described herein with respect to FIG. 6A). In this variation, the switch network 640 includes a plurality of cascaded multiplexing photonic switches that includes a first multiplexing photonic switch 642 and a second multiplexing photonic switch 644. Each of the first multiplexing photonic switch 642 and a second multiplexing photonic switch 644 may be configured in any manner such as described with respect to the multiplexing photonic switches 500, 501, and 521 of FIGS. 5A-5C.

The first and second inputs 602, 604 of the switch network 640 may form the inputs of the second multiplexing photonic switch 644. The first input 602 may be optically connected to a first output of a light source unit and the second input 604 may be optically connected to a second output of the light source unit. Accordingly the second multiplexing photonic switch 644 may be operable to route light received light received at the first input 602 and the second input 604 to a first output 646 of the second multiplexing photonic switch 644. The first output 646 of second multiplexing photonic switch 644 may form a first input of the first multiplexing photonic switch 642, and the third input 606 of the switch network 640 may form a second input of the first multiplexing photonic switch 642. The third input 606 of the switch network 640 may be optically connected to a third output of a light source unit. For example, the first input 602, the second input 604, and the third input 606 may be connected to corresponding first, second, and third outputs of an Echelle grating multiplexer as described herein.

The switch network 640 may simultaneously receive light of different wavelengths at multiple inputs of the switch network 640, and may route this light to a common selection of the outputs. Specifically, a first waveguide 616 optically connects a first output of the first multiplexing photonic switch 642 to a first input of a first controllable switch 612, and a second waveguide 618 optically connects a second output of the first multiplexing photonic switch 642 to a first input of a second controllable switch 614. The first controllable switch 612 and the second controllable switch 614 may be configured in any manner as described with respect to the switch network 600 of FIG. 6A.

For example, when light of two different wavelengths is simultaneously received at the first input 602 and the second input 604 of the switch network 640 (e.g., as part of an encoded measurement as described herein), the second multiplexing photonic switch 644 may combine the different wavelengths into the first output 646 of the second multiplexing photonic switch 644. The first multiplexing photonic switch 642 may simultaneously receive both wavelengths of light at a corresponding input of the first multiplexing photonic switch 642, and may be operable to simultaneously route both wavelengths to one or both of the first and second controllable switches 612, 614. Similarly, the controllable switches 612, 614 may be operated to distribute the light between the plurality of outputs of the switch network 640.

Similarly, light of two different wavelengths may simultaneously received at the third input 606 and of the one of the first input 602 or the second input 604 of the switch network 640. In these instances, the second multiplexing photonic switch 644 route the light received at its corresponding input to the first input of the first multiplexing switch 642. Accordingly, the first multiplexing photonic switch 642 may receive the different wavelengths at different inputs of the first multiplexing photonic switch 642 (e.g., one wavelength is received from the third input 606 of the switch network 640, while the other wavelength is received via the first output 646 of the second multiplexing photonic switch 644), and may be operated to simultaneously route both wavelengths to one or both of the first and second controllable switches 612, 614.

In some variations, the switch network 640 may include a plurality of VOAs corresponding to the plurality of inputs to the switch network 640. For example, the switch network 640 may include a first VOA 652 optically connected to the first input 602 of the switch network (and thereby optically connected to a first input of the second multiplexing photonic switch 644), a second VOA 654 optically connected to the second input 604 of the switch network (and thereby optically connected to a second input of the second multiplexing photonic switch 644), and a third VOA 656 optically connected to the third input 606 of the switch network (and thereby optically connected to the second input of the second multiplexing photonic switch 644). Depending on which inputs of the switch network 640 are simultaneously receiving light, the corresponding VOAs may be controlled to perform power balancing between the wavelengths of light generated at the inputs of the switch network 640.

In some variations, the second multiplexing photonic switch 644 may be replaced by an interferometer, such as the first interferometer 410a of the passive optical combiner 400 of FIG. 4A, such that the first and second inputs 602, 604 of the switch network 640 act as inputs to the interferometer and the first output 646 acts an output of the interferometer. In these variations, the wavelengths generated by the light source unit and a free spectral range of the first interferometer may be selected such that i) wavelengths of light that are received by the first input 602 are routed to the first output 646 and ii) wavelengths of light that received by the second input 604 are also routed to the first output 646.

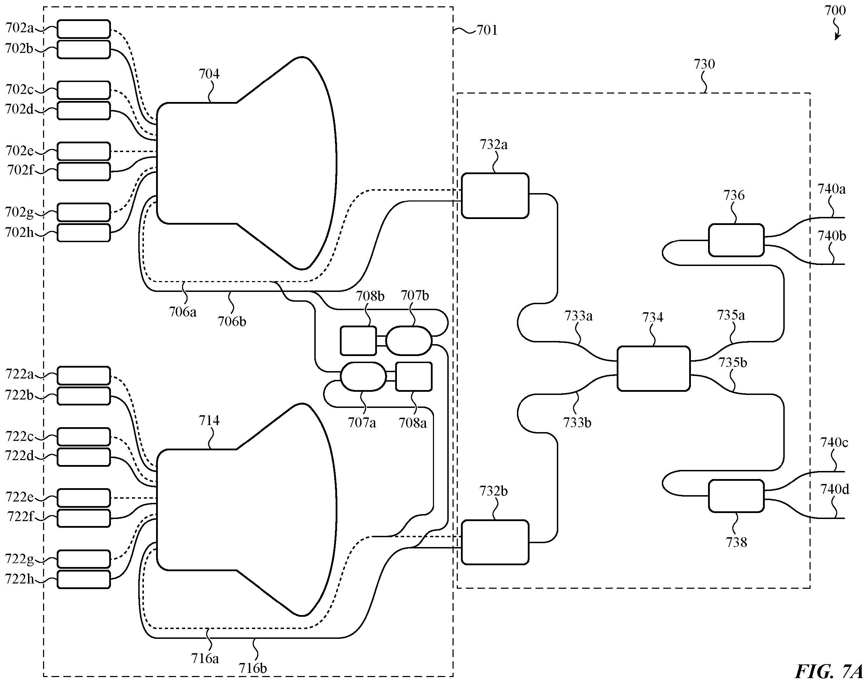

FIG. 7A shows a schematic view of a photonic integrated circuit 700 that may be used with the optical measurement systems described herein. The photonic integrated circuit 700 includes a light source unit 701 and a switch network 730 having a plurality of outputs 740a-740d. The light source unit 701 includes a plurality of outputs and is optically connected to the switch network 730. The light source unit 701 is operable (e.g., controllable by a controller as described herein) to simultaneously output light of multiple wavelengths at different outputs of the light source unit 701. The switch network 730 is configured to receive the different wavelengths of light simultaneously from multiple outputs of the light source unit 701, and to route the multiple wavelengths to a common selection of the plurality of outputs 740a-740d. Each of the plurality of outputs may be connected to a launch group of a plurality of launch groups. Accordingly, one or more the launch groups may receive light that simultaneously contains multiple wavelengths, and may emit this light from the photonic integrated circuit 700. In the variation shown in FIG. 7A, the switch network 730 is shown as four outputs (e.g., a first output 740a, a second output 740b, a third output 740c, and a fourth output 740d), each of which may be connected to a different launch group.

In the variation shown in FIG. 7A, the light source unit 701 includes multiple pluralities of light sources and multiple multiplexers, each having a corresponding plurality of outputs. For example, the light source unit 701 of FIG. 7A includes a first plurality of light sources 702a-702h and a first multiplexer 704. The first multiplexer 704, which may be an Echelle grating multiplexer, has a first plurality of inputs and a first plurality of outputs 706a-706b. Each of the first plurality of light sources 702a-702h is optically connected to a different input of the first plurality of inputs, and the first multiplexer 704 is configured to multiplex light from the first plurality inputs to the first plurality of outputs. The first plurality of light sources 702a-702h and the first multiplexer 704 may be configured in any manner such as described herein with respect to FIGS. 3B-3K.

The first plurality of light sources 702a-702h may include one or more groups of light sources, each having a set of light sources having a common set of frequency differences. In this way, the first multiplexer 704 may output light via multiple of its outputs simultaneously. For example, during a first period of time, a first group of light sources (e.g., light sources 702a, 702b,) may be operated to simultaneously generate a first wavelength of light and a second wavelength of light that are separated by a first frequency difference. The first multiplexer 704 may simultaneously output the first wavelength via a first output 306a of the first multiplexer 704 and the second wavelength via a second output 306b of the first multiplexer 704. During a second period of time, a second group of light sources (e.g., light sources 702c, 702d) may be operated to simultaneously generate a third wavelength of light and a fourth wavelength of light that are separated by the first frequency difference. The first multiplexer 704 may simultaneously output the third wavelength via the first output 306a of the first multiplexer 704 and the fourth wavelength via the second output 306b of the first multiplexer 704. Accordingly, the light source unit 701 may utilize the first multiplexer 704 to output certain wavelengths (e.g., multiple wavelengths separated by the first frequency difference and/or individual wavelengths) at various times.

Additionally, in some variations, the light source unit 701 of FIG. 7A includes a second plurality of light sources 722a-722h and a second multiplexer 714. The second multiplexer 714, which may be an Echelle grating multiplexer, has a second plurality of inputs and a second plurality of outputs 716a-716b. Each of the second plurality of light sources 722a-722h is optically connected to a different input of the second plurality of inputs, and the second multiplexer 714 is configured to multiplex light from the second plurality inputs to the second plurality of outputs 716a-716b. The second plurality of light sources 722a-722h and the second multiplexer 714 may be configured in any manner such as described herein with respect to FIGS. 3B-3K.

The second plurality of light sources 722a-722h may include one or more groups of light sources, each having a set of light sources having a common set of frequency differences. In this way, the second multiplexer 714 may output light via multiple of its outputs simultaneously. For example, during a third period of time, a third group of light sources (e.g., light sources 722a, 722b,) may be operated to simultaneously generate a fifth wavelength of light and a sixth wavelength of light that are separated by a second frequency difference. It should be appreciated that in some instances the first frequency difference may be the same as the second frequency difference, while in other instances the first frequency difference may be different than the second frequency difference. The second multiplexer 714 may simultaneously output the fifth wavelength via a third output 716a of the second multiplexer 714 and the sixth wavelength via a fourth output 716b of the second multiplexer 714.

During a fourth period of time, a fourth group of light sources (e.g., light sources 722c, 722d) may be operated to simultaneously generate a seventh wavelength of light and an eighth wavelength of light that are separated by the second frequency difference. The second multiplexer 714 may simultaneously output the seventh wavelength via the third output 716a of the second multiplexer 714 and the eighth wavelength via the fourth output 716b. Accordingly, the light source unit 701 may utilize the second multiplexer 714 to output other wavelengths (e.g., multiple wavelengths separated by the first frequency difference and/or individual wavelengths) at various times.

In some instances, the light source unit 701 includes one or more wavelength locking units that are shared between the first and second multiplexers 704, 714. For example, in the variation shown in FIG. 7A, the light source unit 701 includes a first wavelength locking unit 708a and a second wavelength locking unit 708b. The first wavelength locking unit 708a is optically connected to the first output 706a and the third output 716a, and the second wavelength locking unit 708b is optically connected to the second output 706b and the fourth output 716b. In this way, the first wavelength locking unit 708a may receive light from either the first multiplexer 704 or the second multiplexer 714, depending on which multiplexer is currently outputting light. If the first multiplexer 704 is emitting light along the first output 706a, the first wavelength locking unit 708a may be used to control a corresponding light source of the first plurality of light sources 702a-702h. Similarly, if the second multiplexer 714 is emitting light along the third output 716a, the first wavelength locking unit 708a may be used to control a corresponding light source of the second plurality of light sources 722a-722h. In some instances, the light received by the first and third outputs 706a, 716a may pass through a first coupler 707a, such that light received from either output is routed to a common set of waveguides before reaching the first wavelength locking unit 708a.

Similarly, the second wavelength locking unit 708b may receive light from either the first multiplexer 704 or the second multiplexer 714, depending on which multiplexer is currently outputting light. If the first multiplexer 704 is emitting light along the second output 706b, the second wavelength locking unit 708b may be used to control a corresponding light source of the first plurality of light sources 702a-702h. Similarly, if the second multiplexer 714 is emitting light along the fourth output 716b, the second wavelength locking unit 708b may be used to control a corresponding light source of the second plurality of light sources 722a-722h. In some instances, the light received by the second and fourth outputs 706b, 716b may pass through a second coupler 707b, such that light received from either output is routed to a common set of waveguides before reaching the second wavelength locking unit 708b.

Overall, the light source unit 701 includes a first plurality of outputs corresponding to the first plurality of outputs 706a-706b of the first multiplexer 704 and a second plurality of outputs corresponding to the second plurality of outputs 716a-716b of the second multiplexer 704. The switch network 730 is optically connected to the first and second pluralities of outputs, such that the switch network 730 may simultaneously receive light of different wavelengths from multiple outputs of the light source unit 701. The switch network 730 is configured to route the different wavelengths to a common selection of the plurality of outputs 740a-740d. In this way, one or more launch groups may receive and emit light that simultaneously includes multiple wavelengths.

The variation of the switch network 730 shown in FIG. 7A includes passive optical combiners that are each configured to receive light of different wavelengths from multiple inputs of a corresponding multiplexer, and combine the different wavelengths into a single common output of the passive optical combiner. When it is desirable to combine light from three outputs of a multiplexer into a single waveguide, a passive optical combiner may be configured as described herein with respect to the passive optical combiner 400 of FIG. 4A. When it is desirable to combine light from two outputs of a multiplexer into a single waveguide, a passive optical combiner may be configured, for example, as the first interferometer 410a of the passive optical combiner 400 of FIG. 4A. Specifically, the first interferometer may receive light of a first frequency *vₐ* at a first input (e.g., the first input 402 of FIG. 4A) and light of a second frequency *v_{b}* at a second input (e.g., the second input 404 of FIG. 4A). The first free spectral range Δv*₁* of the first interferometer 410a is selected such that the light of the first and second frequencies *vₐ*, *vₐ*, when received at the corresponding inputs, will be routed to a common waveguide (e.g., the second output 414 of FIG. 4A).

As shown in FIG. 7A, the switch network 730 includes a first passive optical combiner 732a that is optically connected to the first and second outputs 706a, 706b of the first multiplexer 704. In other words, the first passive optical combiner 732a has a first input that receives light from the first output 706a and a second input that receives light from the second output 706b. The first passive optical combiner 732a has a first free spectral range that is selected based on the first common frequency difference of the groups of light sources associated with the first plurality of light sources 702a-702h. Specifically, when a group of light sources is operated to emit light having a pair of wavelengths separated by the first common frequency difference (e.g., light sources 702a, 702b during the first period of time, light sources 702c, 702d during the second period of time, etc.), the first passive optical combiner 732a will combine the pair of wavelengths into a first waveguide 733a.

The first waveguide 733a may be optically connected to a first controllable switch 734. Specifically, a first input of the first controllable switch 734 may receive light from the first waveguide 733a when the first multiplexer 704 is outputting light. The first controllable switch 734 has a first output 735a and a second output 735b. When light is received by the first controllable switch 734 via the first waveguide 733a, the first controllable switch 734 may be controlled to selectively route this light to only the first output 735a, only the second output 735b, or split the light between the first output 735a and the second output 735b. The switch network 730 may further include a second controllable switch 736 that is optically connected to the first output 735a of the second controllable switch 736. The second controllable switch 736 may be controlled to selectively route light received from the first output 735a of the second controllable switch 736 to either the first output 740a of the switch network 730, the second output 740b of the switch network, or split the light between the first output 740a and the second output 740b.

Similarly, the switch network 730 may further include a third controllable switch 738 that is optically connected to the second output 735b of the second controllable switch 736. The third controllable switch 738 may be controlled to selectively route light received from the second output 735b of the second controllable switch 736 to either the third output 740c of the switch network 730, the fourth output 740d of the switch network, or split the light between the third output 740c and the fourth output 740d. Overall, the switch network 730, by operating the first, second, and third controllable switches 734-738 may selectively route light received by the first passive optical combiner 732a to a first common selection of outputs of the plurality of outputs 740a-740d of the switch network. In this way, although the switch network 730 receives light of different wavelengths from different outputs, the switch network 730 will simultaneously output these wavelengths to each output of the first common selection of outputs. In this way, each launch group that emits light from the photonic integrated circuit 700 may be able to emit light that simultaneously includes multiple wavelengths.

The switch network 730 may further include a second passive optical combiner 732b that is optically connected to the third and fourth outputs 716a, 716b of the second multiplexer 714. In other words, the second passive optical combiner 732b has a third input that receives light from the third output 716b and a fourth input that receives light from the fourth output 716c. The second passive optical combiner 732b has a second free spectral range that is selected based on the second common frequency difference of the groups of light sources associated with the second plurality of light sources 722a-722h. Specifically, when a group of light sources is operated to emit light having a pair of wavelengths separated by the second common frequency difference (e.g., light sources 722a, 722b during the third period of time, light sources 722c, 722d during the fourth period of time, etc.), the second passive optical combiner 732b will combine the pair of wavelengths into a second waveguide 733b.

The second waveguide 733b may be optically connected to the first controllable switch 734. Accordingly, when the first controllable receives light from the second waveguide 733b (e.g., at a second input of the first controllable switch), the first, second, and third controllable switches 734-738 may be operated to selectively route light received by the second passive optical combiner 732b to a second common selection of outputs of the plurality of outputs 740a-740d of the switch network. Accordingly, the switch network 730 may have flexibility to combine light from different sets of outputs, and controllably combine light into a common selection of the plurality of outputs 740a-740d. It should be appreciated that the number and arrangement of passive optical combiners and controllable switches may be adjusted to accommodate different numbers of multiplexers in the light source unit 701 and/or different numbers of the plurality of outputs 740a-740d of the switch network 730.

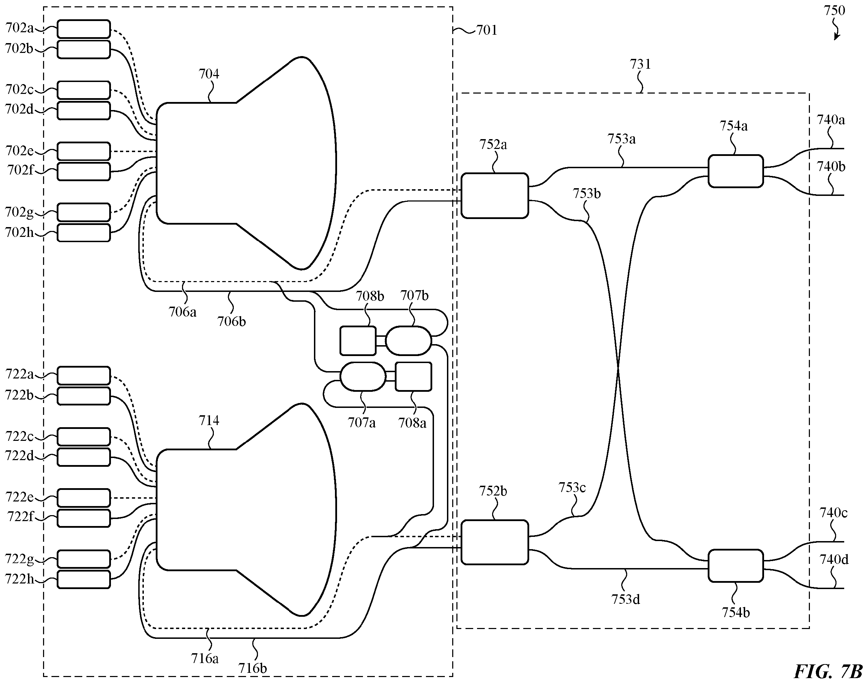

FIG. 7B shows another variation of a photonic integrated circuit 750, which may be configured the same as the photonic integrated circuit 700 of FIG. 7A except that the switch network 730 of FIG. 7A has been replaced by another switch network 731. Specifically, the switch network 731, which includes a plurality of outputs 740a-740d as described herein with respect to FIG. 7A, includes a first multiplexing photonic switch 752a that is optically connected to the first and second outputs 706a, 706b of the first multiplexer 704. In other words, the first multiplexing photonic switch 752a has a first input that receives light from the first output 706a and a second input that receives light from the second output 706b. The first multiplexing photonic switch 752a is configured to receive light of a first wavelength at the first input and light of a second wavelength at the second input, where the first and second wavelengths have a first common frequency difference. When the first multiplexing photonic switch 752a simultaneously receives a light of a pair of wavelengths having the first common frequency difference, the first multiplexing photonic switch 752a may selectively route both wavelengths of light to a first common selection of outputs of the first multiplexing photonic switch 752a.

Specifically, the first multiplexing photonic switch 752a has a first output 753a and a second output 753b. The first common selection of the outputs may include only the first output 753a, only the second output 753b, or both the first and second outputs 753a, 753b. In this way, the first multiplexing photonic switch 752a may be controlled to simultaneously route light to only the first output 753a, only the second output 753b, or split the light between the first and second outputs 753a, 753b. Specifically, when a group of light sources is operated to emit light having a pair of wavelengths separated by the first common frequency difference (e.g., light sources 702a, 702b during the first period of time, light sources 702c, 702d during the second period of time, etc.), the first multiplexing photonic switch 752a will combine the pair of wavelengths into a common selection of the first and second outputs 753a, 753b of first multiplexing photonic switch 752a.

The switch network 731 may further include a first controllable switch 754a that is optically connected to the first output 753a of the first multiplexing photonic switch 752a. The first controllable switch 754a be controlled to selectively route light received from the first output 753a of the first multiplexing photonic switch to either the first output 740a of the switch network 731, the second output 740b of the switch network 731, or split the light between the first output 740a and the second output 740b. Similarly, the switch network 731 may further include a second controllable switch 754b that is optically connected to the second output 753b of the first multiplexing photonic switch 752a. The second controllable switch 754b may be controlled to selectively route light received from the second output 753b of the first multiplexing photonic switch 752a to either the third output 740c of the switch network 731, the fourth output 740d of the switch network 731, or split the light between the third output 740c and the fourth output 740d. Overall, the switch network 731, by operating the first multiplexing photonic switch 752a and the first and second controllable switches 754a, 754b may selectively route light received by the first multiplexing photonic switch 752a to a first common selection of outputs of the plurality of outputs 740a-740d of the switch network.

The switch network 731 may also include a second multiplexing photonic switch 752b that is optically connected to the third and fourth outputs 716a, 716b of the second multiplexer 714. In other words, the second multiplexing photonic switch 752b has a third input that receives light from the third output 716a and a fourth input that receives light from the fourth output 716b. The second multiplexing photonic switch 752b is configured to receive light of a third wavelength at the third input and light of a fourth wavelength at the fourth input, where the third and fourth wavelengths have the second common frequency difference. When the second multiplexing photonic switch 752b simultaneously receives a light of a pair of wavelengths having the second common frequency difference, the second multiplexing photonic switch 752b may selectively route both wavelengths of light to a second common selection of outputs of the second multiplexing photonic switch 752b.

Specifically, the second multiplexing photonic switch 752b has a third output 753c and a fourth output 753d. The second common selection of the outputs may include only the third output 753c, only the fourth output 753d, or both the third and fourth outputs 753c, 753d. In this way, the second multiplexing photonic switch 752b may be controlled to simultaneously route light to only the third output 753c, only the fourth output 753d, or split the light between the third and fourth outputs 753c, 753d. Specifically, when a group of light sources is operated to emit light having a pair of wavelengths separated by the second common frequency difference (e.g., light sources 722a, 722b during the third period of time, light sources 722c, 722d during the fourth period of time, etc.), the second multiplexing photonic switch 752b will combine the pair of wavelengths into a common selection of the third and fourth outputs 753c, 753d of second multiplexing photonic switch 752b.

The third and fourth outputs 753c, 753d may also be optically connected to the first and second controllable switches 754a, 754d. In this way, by operating the second multiplexing photonic switch 752b and the first and second controllable switches 754a, 754b may selectively route light received by the second multiplexing photonic switch 752b to a second common selection of outputs of the plurality of outputs 740a-740d of the switch network 731. Accordingly, in the variations shown in FIG. 7A and 7B, the first multiplexer 704 may output multiple wavelengths at certain points in time, during which the first and second wavelength locking units 708a, 708b may be used to control light sources of the first plurality of light sources 702a-702h and a switch network (e.g., switch network 730 or switch network) may combine these wavelengths into a first common selection of outputs of the plurality of outputs 740a-740d. During other points in time, the second multiplexer 714 may output multiple wavelengths, and the first and second wavelength locking units 708a, 708b may be used to control light sources of the second plurality of light sources 722a-722h, and the switch network may combine these wavelengths into a first common selection of outputs of the plurality of outputs 740a-740d. Accordingly, an optical measurement system incorporating one these photonic integrated circuits may have substantial flexibility in outputting, for any given individual measurements, one or more wavelengths of light (which may change between different individual measurements) from a common set of launch groups (which may change between different individual measurements).

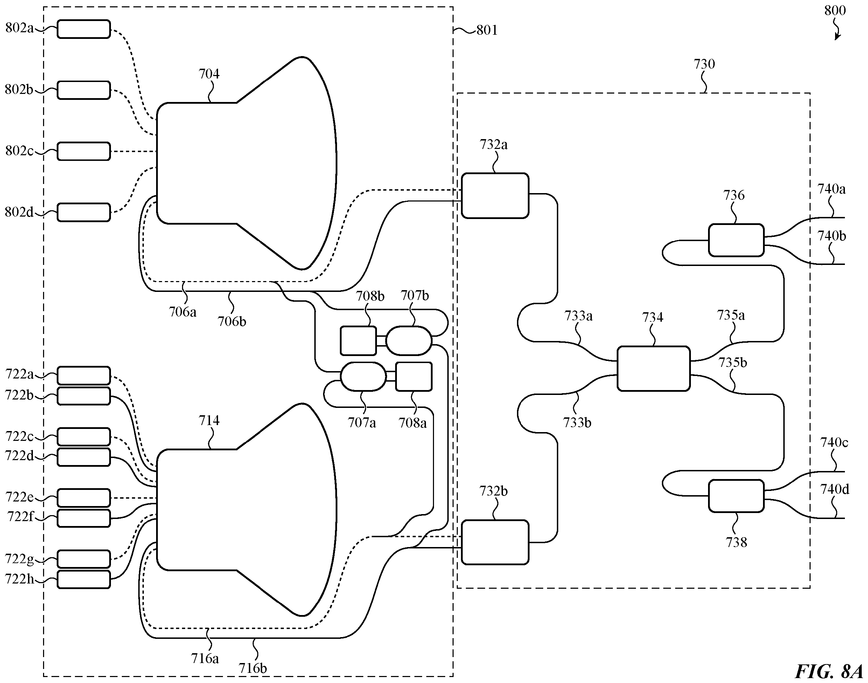

FIG. 8A shows another variation of a photonic integrated circuit 800 that may be used with the optical measurement systems described herein. The photonic integrated circuit 800 includes a light source unit 801 that includes a set of tunable light sources 802a-802d, a plurality of light sources 722a-772h, and multiple multiplexers. Specifically, the light source unit 801 may include the first multiplexer 704 and the second multiplexer 714 such as described with respect to the photonic integrated circuit 700 of FIG. 7A. The set of tunable light sources 802a-802d is optically connected to the first multiplexer 704. The set of tunable light sources 802a-802d may include a single tunable light source or a plurality of tunable light sources. For example, the set of tunable light sources 802a-802d depicted in FIG. 8A includes four tunable light sources (e.g., a first tunable light source 802a, a second tunable light source 802b, a third tunable light source 802c, and a fourth tunable light source 802d).

Each tunable light source of the set of tunable light sources 802a-802d is connected to a corresponding input of the first multiplexer 704, and is operable to emit a plurality of corresponding wavelengths of light. The light source unit 801 is configured such that different corresponding wavelengths emitted by a tunable light source 802a-802d are routed to different corresponding outputs of the first plurality of outputs 706a-706b of the first multiplexer 704, such as described herein with respect to the light source unit 381 of FIG. 3K. For example, the first tunable light source 802a may be operated at different times to generate a first wavelength and a second wavelength, where the first and second wavelengths are routed to different outputs of the first plurality of outputs 706a-706b. Accordingly, the first tunable light source 802a may be operated during a first period of time to generate the first wavelength and may be operated during a second period of time to generate the second wavelength. In this way, the light source unit is controllable to output the first wavelength from the first output 706a of the first plurality of outputs 706a-706b during the first time period. Similarly, the light source unit is controllable to output the second wavelength from the second output 706b of the first plurality of outputs 706a-706b during the second time period.

The light source unit 801 may be configured to output additional wavelengths of light from the first multiplexer 704. For example, the tunable light sources of the set of tunable light sources 802a-802d may generate additional wavelengths (e.g., a third corresponding wavelength, and so on) that are routed to additional corresponding outputs of the first plurality of outputs 706a-706b of the first multiplexer 704. In some variations, the light source unit 801 includes a set of additional light sources that is optically connected to the first multiplexer 704, such as the plurality of light sources 302a-302d described herein with respect to FIG. 3K. These additional light sources may be operated to generate additional wavelengths that are routed to corresponding outputs the first plurality of outputs 706a-706b of the first multiplexer 704.

The plurality of light sources 722a-722h may be operated as described herein with respect to the light source unit 701 of FIG. 7A, such that the second multiplexer 714 may output light via multiple of its outputs simultaneously. For example, the light source unit 801 may be controllable to, during a third period of time, to simultaneously output a third wavelength of light from a first output of the second plurality of outputs 716a-716b (e.g., the third output 716a) and a second wavelength of light from a second output of the second plurality of outputs 716a-716b (e.g. the fourth output 716b). For example, a first pair of light sources of the plurality of light sources 722a-722h may be operated during the third period of time to simultaneously emit the third wavelength and the fourth wavelength.

When the photonic integrated circuit 800 is incorporated into an optical measurement system as described herein, the optical measurement system may perform a spectroscopic measurement that includes different individual measurements. During different individual measurements, the photonic integrated circuit 800 may emit either a single wavelength of light or multiple wavelengths of light simultaneously. When the photonic integrated circuit 800 emits multiple wavelengths of light simultaneously, the multiple wavelengths may be treated as a single emission wavelength (e.g., to increase the optical power and/or reduce noise associated with the measurement) or may be treated as different emission wavelengths (e.g., as part of a series of encoded measurements).

For example, the light source unit 801 may be operated, during certain individual measurements, to generate a single wavelength of light from the first multiplexer 704 (e.g., from one of the first plurality of outputs 706a-706b). During other individual measurements, the light source unit 801 may be operated to generate multiple wavelengths of light from the second multiplexer 714 (e.g., from different outputs of the second plurality of outputs 716a-716b). In some variations, the light source unit 801 may be operated to generate light at multiple wavelengths as part of a series of encoded measurement as described herein.

In the variation of the photonic integrated circuit 800 shown in FIG. 8A, the photonic integrated circuit 800 includes the switch network 730 described herein with respect to FIG. 7A. The switch network 730 may be operable to route light generated by the light source unit 801 to a selection of the outputs 740a-740d of the switch network 730. For example, during the first period of time, the switch network may be controlled to route the first wavelength of light to a first common selection of the plurality of outputs 740a-740d. During the second period of time, the switch network may be controlled to route the second wavelength of light to a second common selection of the plurality of outputs 740a-740d. Similarly, during the third period of time, the switch network may be controlled to route the third wavelength of light and the fourth wavelength of light simultaneously to a second common selection of the plurality of outputs 740a-740d. It should be appreciated that the photonic integrated circuit 800 may include any suitable switch network 730 as described herein, such as the switch network 731 described herein with respect to FIG. 7B.

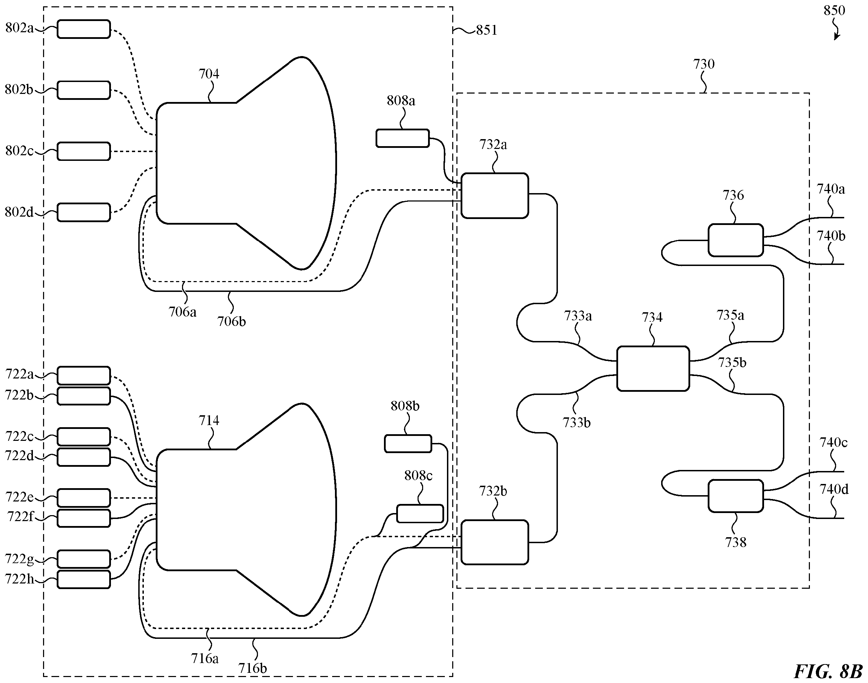

In the variation shown in FIG. 8A, the light source unit 801 includes one or more wavelength locking units that are shared between the first and second multiplexers 704, 714. For example, the light source unit 801 may include first and second wavelength locking units 708a, 708b, as well as first and second couplers 707a, 707b, which are configured as described herein with respect to FIG. 7A. FIG. 8B shows another variation of a photonic integrated circuit 850 which may be configured the same as the photonic integrated circuit 800 of FIG. 8A, except that the light source unit 801 has been replaced with another light source unit 851.

The light source unit 851 is configured the same as the light source unit 801 of FIG. 8A, except that the light source unit 851 includes a plurality of wavelength locking units that are not shared between the first and second multiplexers 704, 714. Specifically, the light source unit 851 includes a first wavelength locking unit 808a that is configured to monitor light that is outputted from any of the first plurality of outputs 706a-706b of the first multiplexer 704. Accordingly, the wavelength locking unit 808a may be used to control the wavelength emitted by a single light source (e.g., one of the tunable light sources 802a-802d) when the first multiplexer 704 is outputting a single wavelength. Additionally the light source unit 851 includes a second wavelength locking unit 808b and a third wavelength locking unit 808c that are positioned to monitor light traveling through the respective first and second outputs 716a, 716b of the second multiplexer 706. The second and third wavelength locking units 808b, 808c may be used to simultaneously control the wavelengths emitted by multiple light sources (e.g., two of the plurality of light sources 722a-772h) when the second multiplexer 714 is simultaneously outputting two wavelengths.

In the variation shown in FIG. 8B, the first wavelength locking unit 808a is positioned to monitor light traveling through the first passive optical combiner 732a, such as described herein with respect to FIG. 4B. In other variations, the wavelength locking unit 808a is positioned to monitor light traveling through the first waveguide 733a.

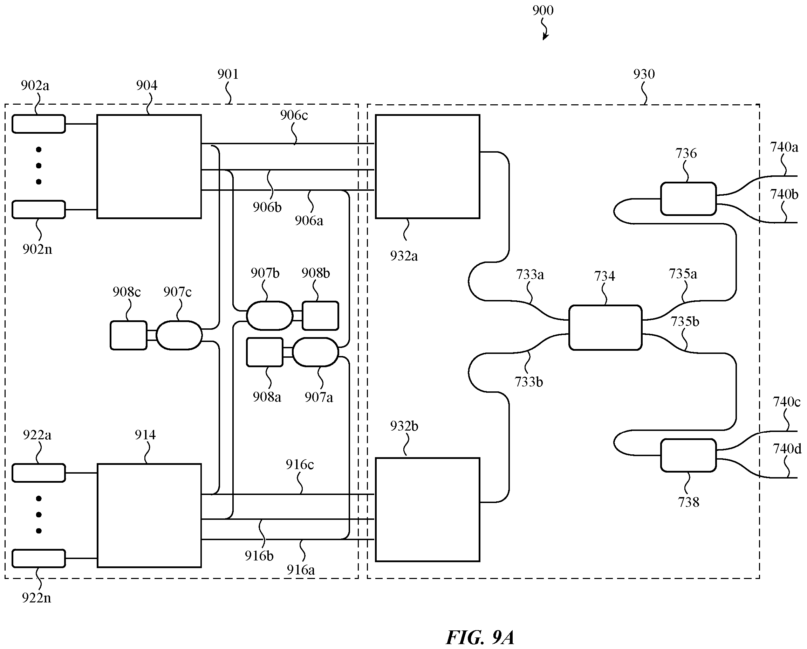

While the first multiplexer 704 and the second multiplexer 714 of the light source units described herein with respect to FIGS. 7A-8B are each shown as having two outputs, it should be appreciated that similar principles may be applied to light sources in which the fist multiplexer 704 and/or the second multiplexer 714 include three or more corresponding outputs. For example, FIG. 9A shows a schematic view of a photonic integrated circuit 900 that may be used with the optical measurement systems described herein. The photonic integrated circuit 900 includes a light source unit 901 and a switch network 930 having a plurality of outputs 740a-740d, such as described herein with respect to the switch network 730 of FIG. 7A. The light source unit 901 includes a plurality of outputs and is optically connected to the switch network 930. The light source unit 901 is operable (e.g., controllable by a controller as described herein) to output light of a single wavelengths or multiple wavelengths simultaneously, and the switch network 930 is configured to route the light to a common selection of the plurality of outputs 740a-740d.

In the variation shown in FIG. 9A, the light source unit 901 includes a first plurality of light sources 902a-902n (some or all of which may be tunable light sources) that is optically connected to a first multiplexer 904 and a second plurality of light sources 922a-922n (some or all of which may be tunable light sources) that is optically connected to a second multiplexer 914. In some variations, the first multiplexer 904 and/or the second multiplexer 914 is an Echelle grating multiplexer. The first multiplexer 904 includes a first plurality of outputs 906a-906c that includes three outputs (e.g., a first output 906a, a second output 906b, and a third output 906c). The first multiplexer 904 may route light generated by the first plurality of light sources 902a-902n, depending on the selection of light sources used to generate the light (and the choice of wavelength being generated in the instance of a tunable light source), to some or all of the first plurality of outputs 906a-906c. Similarly, the second multiplexer 914 includes a second plurality of outputs 916a-916c that includes three outputs (e.g., a first output 916a, a second output 916b, and a third output 916c). The second multiplexer 904 may route light generated by the second plurality of light sources 922a-922n, depending on the selection of light sources used to generate the light (and the choice of wavelength being generated in the instance of a tunable light source), to some or all of the second plurality of outputs 916a-916c.

In some instances, the light source unit 901 may include one or more wavelength locking units such as described herein. In some variations, the light source unit 901 includes a set of one or more wavelength locking units that are not shared between the first and second multiplexers 904, 914, such as described herein with respect to FIG. 8B. Additionally or alternatively, the light source unit 901 may includes a set of one or more wavelength locking units that are shared between the first and second multiplexers 904, 914. For example, in the variation shown in FIG. 9A, the light source unit 901 includes a first wavelength locking unit 908a, a second wavelength locking unit 908b, and a third wavelength locking unit 908c. The first wavelength locking unit 908a is optically connected to the first output 906a of the first multiplexer 904 and the first output 916a of the second multiplexer 914. Similarly, the second wavelength locking unit 908b is optically connected to the second output 906b of the first multiplexer 904 and the second output 916b of the second multiplexer 914, and the third wavelength locking unit 908c is optically the third output 906c of the first multiplexer 904 and the third output 916b of the second multiplexer 914.

In this way, each of the first wavelength locking unit 908a, the second wavelength locking unit 908b, and the third wavelength locking unit 908c may receive light from either the first multiplexer 904 or the second multiplexer 914, depending on which multiplexer is currently outputting light. If the first multiplexer 904 is emitting light along its first output 906a, the first wavelength locking unit 908a may be used to control a corresponding light source of the first plurality of light sources 902a-902n. Similarly, if the second multiplexer 914 is emitting light along its first output 916a, the first wavelength locking unit 908a may be used to control a corresponding light source of the second plurality of light sources 922a-922n. In some instances, the light received by first wavelength locking unit 908a may first pass through a first coupler 907a, such as described in more detail herein. Similarly, light received by the second wavelength locking unit 908b may pass through a second coupler 907b, and light received by the third wavelength locking unit 908c may first pass through a third coupler 907c.

In some variations, the switch network 930 may include the first controllable switch 734, the second controllable switch 736, and the third controllable switch 738 described herein with respect to the switch network 730 of FIG. 7A. Specifically, the first controllable switch 734 may receive light from a first waveguide 733a at a first input of the first controllable switch 734 and may receive light from a second waveguide 733b at a second input of the first controllable switch 734. The switch network 730 may be configured to combine light from the first plurality of wavelengths into the first waveguide 733a. For example, in some variations the switch network 930 includes a first passive optical combiner 932a, which may be configured as described herein with respect to the passive optical combiner 400 of FIG. 4A, that is configured to combine light from the first output 906a, the second output 906b, and the third output 906c of the first multiplexer 904 into the first waveguide 733a. Similarly, the switch network 930 may include a second passive optical combiner 932b, which may be configured as described herein with respect to the passive optical combiner 400 of FIG. 4A, that is configured to combine light from the first output 916a, the second output 916b, and the third output 916c of the second multiplexer 914 into the second waveguide 733b. In other variations, the switch network 930 may utilize one or more multiplexing photonic switches to combine light from the first multiplexer 904 into the first waveguide 733a and/or to combine light from the second multiplexer 914 into the second waveguide 733b, such as described herein with respect to the switch network 640 of FIG. 6B.

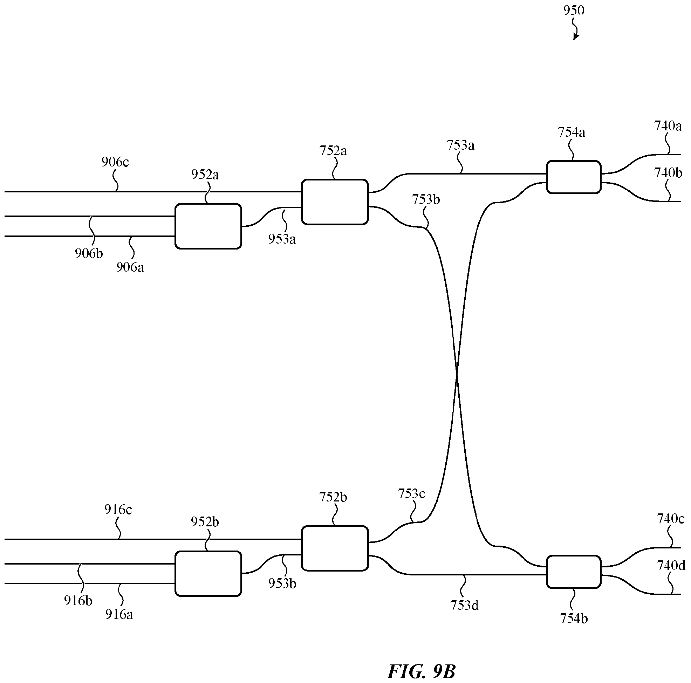

FIG. 9B shows another variation of a switch network 950 that has a plurality of outputs 740a-740d and may be used with the photonic integrated circuit 900 of FIG. 9A (e.g., in the place of switch network 930) to route light generated by the light source unit 901 to a common selection of the plurality of outputs 740a-740d. Specifically, the switch network 950 may include a first multiplexing photonic switch 752a, a second multiplexing photonic switch 752b, a first controllable switch 754a, and a second controllable switch 754b, such as described herein with respect to the switch network 731 of FIG. 7B. Accordingly, light received by the first multiplexing photonic switch 752a may be selectively routed to a selection of the plurality of outputs 740a-740d via the first controllable switch 754a and/or the second controllable switch 754b. Similarly, light received by the second multiplexing photonic switch 752b may be selectively routed to a selection of the plurality of outputs 740a-740d via the first controllable switch 754a and/or the second controllable switch 754b.

The first multiplexing photonic switch 752a may be configured to receive light from the first plurality of outputs 906a-906c of the first multiplexer 904 (only the outputs 906a-906c are depicted in FIG. 9B) as corresponding inputs of the switch network 950. Specifically, the switch network 950 further includes a first combiner 952a that is configured to combine light from the first output 906a and the second output 906b of the first multiplexer 904 into a first common waveguide 953a. In some variations, the first combiner 952a may be an interferometer, such as the first interferometer 410a of the passive optical combiner 400 of FIG. 4A. In other variations, the first combiner 952a may be a multiplexing photonic switch, such as those described herein with respect to FIGS. 5A-5C.

The first multiplexing photonic switch 752a is optically connected to the third output 906c of the first multiplexer 904 and the first common waveguide 953a. In other words, the first multiplexing photonic switch has a first input that receives light from the first combiner 952a and a second input that receives light from the third output 906c. In instances where multiple outputs of the first plurality of outputs 906a-906c are simultaneously emitting different wavelengths of light, the first multiplexing photonic switch 752a may simultaneously receive a different wavelength at each of its inputs (e.g., when the first output 906a or the second output 906b is emitting light along with the third output 906c) or may simultaneously receive multiple wavelengths of light at one of its inputs (e.g., when the first output 906a and the second output 906b are simultaneously emitting light).

Similarly, the second multiplexing photonic switch 752b may be configured to receive light from the second plurality of outputs 916a-916c of the second multiplexer 914 (only the outputs 916a-916c are depicted in FIG. 9B) as corresponding inputs of the switch network 950. Specifically, the switch network 950 further includes a second combiner 952b that is configured to combine light from the first output 916a and the second output 916b of the second multiplexer 914 into a second common waveguide 953b. In some variations, the second combiner 952b may be an interferometer, such as the first interferometer 410a of the passive optical combiner 400 of FIG. 4A. In other variations, the second combiner 952b may be a multiplexing photonic switch, such as those described herein with respect to FIGS. 5A-5C.

The second multiplexing photonic switch 752b is optically connected to the third output 916c of the second multiplexer 914 and the second common waveguide 953b. In other words, the second multiplexing photonic switch 752b has a first input that receives light from the second combiner 952b and a second input that receives light from the third output 916c. In instances where multiple of the second plurality of outputs 916a-916c are simultaneously emitting different wavelengths of light, the second multiplexing photonic switch 752b may simultaneously receive a different wavelength at each of its inputs (e.g., when the first output 916a or the second output 916b is emitting light along with the third output 916c) or may simultaneously receive multiple wavelengths of light at one of its inputs (e.g., when the first output 916a and the second output 916b are simultaneously emitting light). In some variations, the switch network may include a plurality of VOAs corresponding to the first plurality of outputs 906a-906c and/or the second plurality of outputs 916a-916c, such as discussed with respect to the switch network 640 of FIG. 6B.

In some variations, the optical measurement systems described herein may be used to perform, as part of a spectroscopic measurement, one or more series of encoded measurements that utilize encoded multiplexing techniques. The optical measurement system is configured to, for each of encoded measurement of the series of encoded measurements, emit light from a launch site having a corresponding subset of wavelengths selected from a group of target wavelengths. Each corresponding subset of wavelengths includes multiple wavelengths, such that the optical measurement system emits light from the launch site that simultaneously includes multiple wavelengths. During each encoded measurement, a detector group measuring the return light may be unable to distinguish between the different wavelengths. Collectively, however, the series of encoded measurements may be analyzed to determine the relative intensities of light returned for each of the group of target wavelengths.

Specifically, the series of encoded measurements may be performed according to a wavelength encoding matrix. For example, FIG. 10 shows an example of a wavelength encoding matrix 1000 that may be used to perform a series of encoded measurements for a group of target wavelengths that includes three target wavelengths (e.g., a first target wavelength λ₁, a second target wavelength λ₂, and a third target wavelength λ₃). The columns of the wavelength encoding matrix 1000 correspond to different wavelengths of the group of target wavelengths. For example, the first column corresponds to the first target wavelength λ₁, the second column corresponds to the second target wavelength λ₂, and the third column corresponds to the third target wavelength λ₃. The rows of the wavelength encoding matrix 1000 correspond to different encoded measurements of the series of target measurements. For example, the first row corresponds to a first encoded measurement, the second row corresponds to a second encoded measurement, and the third row corresponds to a third encoded measurement. It should be appreciated that the number of rows and/or columns of the wavelength encoding matrix 1000 may change with corresponding changes to the number of target wavelengths and/or encoded measurements.

Each matrix element of the wavelength encoding matrix 1000 represents whether a given target wavelength is emitted during a given encoded measurement. In the example shown in FIG. 10, each matrix element has a value of 0 or 1, where 0 represents that the corresponding target wavelength is not emitted during a corresponding encoded measurement and 1 represents that the corresponding target wavelength is emitted during a corresponding encoded measurement. In the example of the wavelength encoding matrix 1000 of FIG. 10, each encoded measurement may include a corresponding subset of wavelengths that includes two wavelengths selected from the group of target wavelengths. During the first encoded measurement, a first subset (e.g., including the first target wavelength λ₁ and the third target wavelength λ₃) of the target wavelengths is simultaneously emitted by the optical measurement system. During the second encoded measurement, a different second subset (e.g., including the first target wavelength λ₁ and the second target wavelength λ₂) is simultaneously emitted by the optical measurement system. During the third encoded measurement, still another third subset (e.g., including the second target wavelength λ₂ and the third target wavelength λ₃) is simultaneously emitted by the optical measurement system.

During each encoded measurement, a detector group may measure a corresponding intensity that represents the relative amount of light of the corresponding subset of wavelengths that is returned to the optical measurement system. Overall, the series of encoded measurements may be associated with a corresponding plurality of measurement intensities, where each of the plurality of measurement intensities corresponds to a different encoded measurement. In some variations, the plurality of measurement intensities may be analyzed to generate a plurality of derived measurement intensities that correspond to the group of target wavelengths. In these instances, each derived measurement intensity represents an estimate of the intensity of light measured, as part of the series of encoded measurements, for a corresponding target wavelength of the group of wavelengths.

Using the wavelength encoding matrix 1000 of FIG. 10 as an example, the first encoded measurement may be associated with a first measurement intensity (e.g., that represents the combined amount of the first target wavelength λ₁ and the third target wavelength λ₃ measured by a detector group during the first encoded measurement). Similarly, the second encoded measurement may be associated with a second measurement intensity (e.g., that represents the combined amount of the first target wavelength λ₁ and the second target wavelength λ₂ measured by the detector group during the second encoded measurement) and the third encoded measurement may be associated with a third measurement intensity (e.g., that represents the combined amount of the second target wavelength λ₂ and the third target wavelength λ₃ measured by the detector group during the third encoded measurement). The first, second, and third measurement intensities may be analyzed to generate a first derived measurement intensity that represents the intensity of light measured for the first target wavelength λ₁, a second derived measurement intensity that represents the intensity of light measured for the second target wavelength λ₂, and a third derived measurement intensity that represents the intensity of light measured for the third target wavelength λ₃. As compared to an example where intensities for the group of target wavelengths are directly measured by sequentially emitting the target wavelengths (e.g., a first measurement emitting only the first target wavelength λ₁, a second measurement emitting only the second target wavelength λ₂, and a third measurement emitting only the third target wavelength λ₃), the use of encoded measurements to generate derived measurement intensities may allow for faster overall measurements for a given level of SNR (or higher SNR for a given measurement time).

The derived measurement intensities may be calculated in any suitable manner. In some instances, the plurality of measurement intensities may be decoded to generate the plurality of derived measurement intensities. For example, a decoding matrix, which may be an inverse of the wavelength encoding matrix (e.g., wavelength encoding matrix 1000) may be used to generate the derived measurement intensities. In these instances, the plurality of derived measurement intensities may be generated by taking a dot product between the measurement intensities of the series of encoding measurements and the decoding matrix.

The optical measurement systems described herein may be configured such that, during an encoded measurement, the light emitted from a launch site is emitted from a launch group of a photonic integrated circuit. In some of these variations, a light source unit that includes a multi-output Echelle grating multiplexer as described herein may be used to simultaneously generate the multiple wavelengths of light that are emitted as part of the encoded measurements. For example, an optical measurement system may include a photonic integrated circuit and a detector group, such as described in more detail herein. The photonic integrated circuit includes a light source unit and a launch group that is optically coupled to the light source unit and is configured to emit light received from the light source unit. The light source unit may include a plurality of light sources, an Echelle grating multiplexer comprising a plurality of inputs and a plurality of outputs positioned to receive light from the plurality of inputs (such as described herein with respect to FIGS. 3B-3K). Each light source of the plurality of light sources is connected to a corresponding input of the plurality of inputs. In some variations, the light source unit may include multiple pluralities of light sources and multiple multiplexers, such as the light source unit 901 described herein with respect to FIG. 9A. In some of these variations, different pluralities of light sources (and their corresponding multiplexers) may be used to perform different series of encoded measurements.

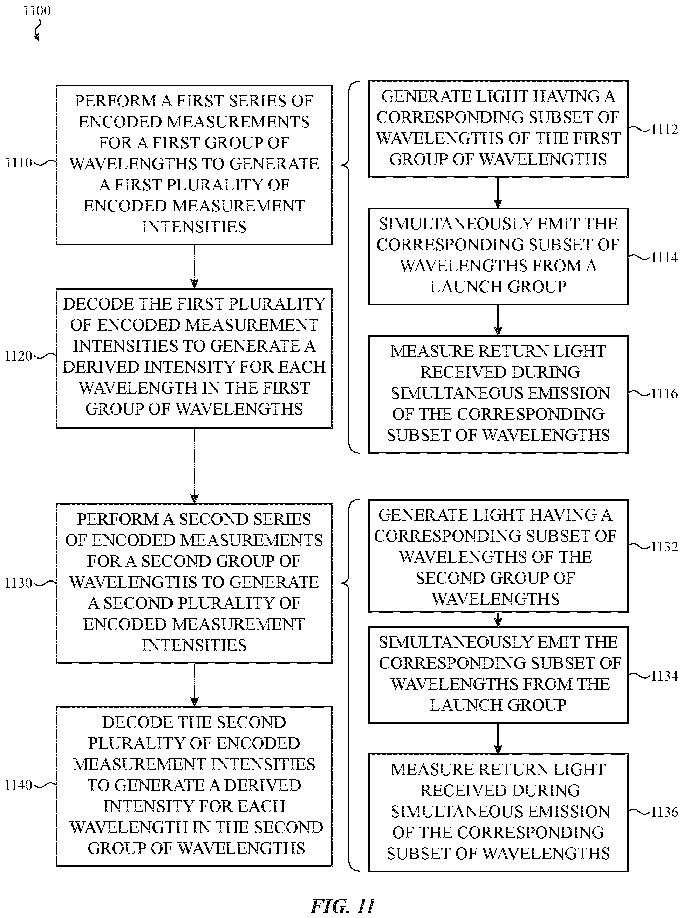

The optical measurement system may further include a controller that is configured to perform one or more series of encoded measurements using the light source unit, the launch group, and the detector group. For example, FIG. 11 depicts a method 1100 of performing a spectroscopic measurement that includes one or more series of encoded measurements. For the purpose of illustration, the method 1100 of FIG. 11 is discussed using a variation of an optical measurement system that includes the light source unit 321 of the photonic integrated circuit 320 of FIG. 3B. It should be appreciated that a controller (e.g., controller 212) of the optical measurement system may control the various components of the optical measurement system to perform the steps of method 1100.

At step 1110, the optical measurement system performs a first series of encoded measurements for a first group of wavelengths to generate a first plurality of encoded measurement intensities. For each encoded measurement of the first series of encoded measurements, the optical measurement system is configured to simultaneously generate, at step 1112, light at a corresponding subset of the first group of wavelengths. Each subset may include a corresponding plurality of wavelengths selected from the first group of wavelengths. The wavelengths generated during the first series of encoded measurements may be determined using a first encoding matrix, such as described herein with respect to the wavelength encoding matrix 1000 of FIG. 10.

For example, in some variations the first set of wavelengths includes three wavelengths (e.g., a first wavelength, a second wavelength, and a third wavelength), and the first series of encoded measurements includes three encoded measurements (e.g., a first encoded measurement, a second encoded measurement, and a third encoded measurement). In these variations, each encoded measurement of the first series of encoded measurements includes a different subset of the first set of wavelengths. For example, the first wavelength and the second wavelength may be simultaneously generated during the first encoded measurement, the first wavelength and the third wavelength may be simultaneously generated during the second encoded measurement, and the second wavelength and the third wavelength may be simultaneously generated during the third encoded measurement.

The first set of wavelengths may be generated by a corresponding group of light sources of the light source unit 321, such that each subset of the first set of wavelengths is simultaneously generated at a corresponding subset of the plurality of outputs 316a-316c of the Echelle grating multiplexer 314. For example, in some variations where the first set of wavelengths includes three wavelengths, the first group of light sources 302a-302c may generate the wavelengths. In this way, light of the first wavelength generated by light source 302a is routed to the first output 316a of the Echelle grating multiplexer 314, light of the second wavelength generated by light source 302b is routed to the second output 316b of the Echelle grating multiplexer 314, and light of the third wavelength generated by light source 302c is routed to the third output 316c of the Echelle grating multiplexer 314.

In these instances, each encoded measurement of the first series of encoded measurements is associated with a different corresponding subset of the plurality of outputs 316a-316c of the Echelle grating multiplexer 314, such that two outputs of the plurality of outputs 316a-316c will simultaneously output light during each encoded measurement. Using the example described above, during the first encoded measurement, light of the first wavelength is generated at the first output 316a and light of the second wavelength is generated at the second output 316b. Similarly, during the second encoded measurement, light of the first wavelength is generated at the first output 316a and light of the third wavelength is generated at the third output 316c. During the third encoded measurement, light of the second wavelength is generated at the second output 316b and light of the third wavelength is generated at the third output 316c.

For each encoded measurement of the first series of encoded measurements, the optical measurement system is configured to simultaneously emit, at step 1114, light at the corresponding subset of the first group of wavelengths from a launch group of the photonic integrated circuit (e.g., the launch group 312a of the set of launch groups 312a-312d of the photonic integrated circuit 320 of FIG. 3B). For example, a switch network such as switch network 330 may route the light to launch group as described more detail herein. Similarly, light of the corresponding plurality of wavelengths that is simultaneously emitted from the launch group may be simultaneously emitted from the optical measurement system via a launch site, such that a corresponding region of the sample simultaneously receives the corresponding plurality of wavelengths.

Light generated at the at the corresponding subset of the plurality of outputs 316a-316c of the Echelle grating multiplexer 314 may be routed to the launch group in any manner as described herein. For example, a passive optical combiner, such as described herein with respect to FIGS. 4A and 4B, may optically couple the plurality of outputs 316a-316c of the Echelle grating multiplexer 314 to a common waveguide, which in turn may be optically connected to the launch group. Additionally or alternatively, in some variations the optical measurement system includes a switch network (e.g., switch network 310) that optically connects the plurality of outputs 316a-316c of the Echelle grating multiplexer 314 to the launch group. To the extent the switch network 310 is operable to selectively route light between a set of launch groups (e.g., the set of launch groups 312a-312d), the switch network 310 may be controlled (e.g., via the controller) to route the light generated by the light source unit 321 to at least the launch group. In some instances, light generated by the light source unit 321 may be split between multiple launch groups during the first series of encoded measurements. This may allow the optical measurement system to simultaneously perform multiple encoded measurements for different regions of a sample.

During each encoded measurement of the first series of encoded measurements, a detector group may, at step 1116, return light received during the simultaneous emission of the corresponding plurality of wavelengths. The detector group may generate a corresponding encoded measurement intensity of the first plurality of encoded measurement intensities. This encoded measurement intensity represents that amount of light of the corresponding plurality of wavelengths that is measured during the encoded measurement. As discussed in more detail herein, at least a portion of the corresponding plurality of wavelengths that is emitted from the optical measurement system may return to the optical measurement system after interacting with the sample, and the detector group may measure this return light.

For example, the first plurality of encoded measurements includes a first encoded measurement intensity that corresponds to the first encoded measurement and represents the amount of return light of the first wavelength and the second wavelength that is simultaneously measured by detector group during the first encoded measurement. The first plurality of encoded measurements further includes a second encoded measurement intensity corresponding to the second encoded measurement (e.g., representing the amount of return light of the first wavelength and the third wavelength simultaneously measured by detector group) and a third encoded measurement intensity corresponding to the third encoded measurement (e.g., representing the amount of return light of the second wavelength and the third wavelength simultaneously measured by the detector group).

While the first series of encoded measurements of the method of FIG. 11 is discussed herein as generating a single plurality of encoded measurement intensities, it should be appreciated that in some variations the first series of encoded measurements may generate multiple pluralities of encoded measurements. For example, in instances where the detector group includes multiple detector elements, each of which is capable of generating a different encoded measurement intensity during an encoded measurement. Accordingly, the detector group may generate, as part of the first series of encoded measurements, a corresponding plurality of encoded measurement intensities for each detector element. For example, a first detector element may generate a first plurality of encoded measurement intensities for the first series of encoded measurements (e.g., including a first encoded measurement intensity measured by the first detector element during the first encoded measurement, a second encoded measurement intensity measured by the first detector element during the second encoded measurement, and so on). Similarly, a second detector element may generate a second plurality of encoded measurement intensities for the second series of encoded measurements (e.g., including a first encoded measurement intensity measured by the second detector element during the first encoded measurement, a second encoded measurement intensity measured by the second detector element during the second encoded measurement, and so on).

Once the first plurality of encoded measurement intensities has been generated, the optical measurement system may, at step 1120, decode the first plurality of encoded measurement intensities to generate a corresponding derived measurement intensity for each wavelength of the first group of wavelengths. For example, a first plurality of derived measurement intensities may be generated that includes a first derived measurement intensity for the first wavelength, a second derived measurement intensity for the second wavelength, and a third derived measurement intensity for the third wavelength. These derived measurement intensities may be used, along with other derived measurement intensities or measured intensities generated during the spectroscopic measurement, to determine one or more properties of the sample being measured. It should be appreciated that in instances where multiple pluralities of encoded measurement intensities are generated by multiple detector elements of the detector group, each plurality of encoded measurement intensities may be decoded to generate a corresponding plurality of derived measurement intensities for the first group of wavelengths.

In some variations, the method 1100 may include performing one or more additional series of encoded measurements for different groups of wavelengths. For example, at step 1130, the optical measurement system performs a second series of encoded measurements for a second group of wavelengths to generate a second plurality of encoded measurement intensities. At least one wavelength of the second group of wavelengths may be different than wavelengths of the first group of wavelengths. In some variations, each of the second group of wavelengths is different than the wavelengths of the first group of wavelengths, such that the first and second groups of wavelengths do not share any common wavelengths.

For each encoded measurement of the second series of encoded measurements, the optical measurement system is configured to simultaneously generate, at step 1132, light at a corresponding subset of the second group of wavelengths. Each subset may include a corresponding plurality of wavelengths selected from the second group of wavelengths. The wavelengths generated during the first series of encoded measurements may be determined using a second encoding matrix, such as described herein with respect to the wavelength encoding matrix 1000 of FIG. 10.

For example, in some variations the second set of wavelengths includes three wavelengths (e.g., a fourth wavelength, a fifth wavelength, and a sixth wavelength, which may each be different than the corresponding wavelengths of the first group of wavelengths), and the second series of encoded measurements includes three encoded measurements (e.g., a first encoded measurement, a second encoded measurement, and a third encoded measurement). In these variations, each encoded measurement of the second series of encoded measurements includes a different subset of the second set of wavelengths. For example, the fourth wavelength and the fifth wavelength may be simultaneously generated during the first encoded measurement of the second series, the fourth wavelength and the sixth wavelength may be simultaneously generated during the second encoded measurement of the second series, and the fifth wavelength and the sixth wavelength may be simultaneously generated during the third encoded measurement of the second series.

The second set of wavelengths may be generated by a corresponding group of light sources of the light source unit 321, such that each subset of the second set of wavelengths is simultaneously generated at a corresponding subset of the plurality of outputs 316a-316c of the Echelle grating multiplexer 314. For example, in some variations where the second set of wavelengths includes three wavelengths, the second group of light sources 302d-302f may generate the wavelengths. In this way, light of the fourth wavelength generated by light source 302d is routed to the first output 316a of the Echelle grating multiplexer 314, light of the fifth wavelength generated by light source 302e is routed to the second output 316b of the Echelle grating multiplexer 314, and light of the sixth wavelength generated by light source 302f is routed to the third output 316c of the Echelle grating multiplexer 314.

In these instances, each encoded measurement of the second series of encoded measurements is associated with a different corresponding subset of the plurality of outputs 316a-316c of the Echelle grating multiplexer 314, such that two outputs of the plurality of outputs 316a-316c will simultaneously output light during each encoded measurement. Using the example described above, during the first encoded measurement of the second series, light of the fourth wavelength is generated at the first output 316a and light of the fifth wavelength is generated at the second output 316b. Similarly, during the second encoded measurement of the second series, light of the fourth wavelength is generated at the first output 316a and light of the sixth wavelength is generated at the third output 316c. During the third encoded measurement of the second series, light of the fifth wavelength is generated at the second output 316b and light of the sixth wavelength is generated at the third output 316c.

For each encoded measurement of the second series of encoded measurements, the optical measurement system is configured to simultaneously emit, at step 1134, light at the corresponding subset of the second group of wavelengths from the launch group. Similarly, light of the corresponding plurality of wavelengths that is simultaneously emitted from the launch group may be simultaneously emitted from the optical measurement system via the launch site, such that the corresponding region of the sample measured by the first series is also measured by the second series. The light may be routed between the light source unit 321 and the launch group in the same manner as described herein with respect to step 1114. It should be appreciated that different launch groups, launch sites, and detector groups may also be used to perform additional series of encoded measurements as part of a spectroscopic measurement.

During each encoded measurement of the second series of encoded measurements, the detector group may, at step 1136, return light received during the simultaneous emission of the corresponding plurality of wavelengths. The detector group may generate a corresponding encoded measurement intensity of the second plurality of encoded measurement intensities, such as described with respect to step 1116. For example, the second plurality of encoded measurements includes a first encoded measurement intensity that corresponds to the first encoded measurement of the second series and represents the amount of return light of the fourth wavelength and the fifth wavelength that is simultaneously measured by detector group during the first encoded measurement of the second series. The second plurality of encoded measurements further includes a second encoded measurement intensity corresponding to the second encoded measurement of the second series (e.g., representing the amount of return light of the fourth wavelength and the sixth wavelength simultaneously measured by detector group) and a third encoded measurement intensity corresponding to the third encoded measurement of the second series (e.g., representing the amount of return light of the fifth wavelength and the sixth wavelength simultaneously measured by the detector group). While the second series of encoded measurements of the method of FIG. 11 is discussed herein as generating a single plurality of encoded measurement intensities, it should be appreciated that in some variations the second series of encoded measurements may generate multiple plurality of encoded measurements as described in more detail herein.

Once the second plurality of encoded measurement intensities has been generated, the optical measurement system may, at step 1140, decode the second plurality of encoded measurement intensities to generate a corresponding derived measurement intensity for each wavelength of the second group of wavelengths. For example, a second plurality of derived measurement intensities may be generated that includes a first derived measurement intensity for the fourth wavelength, a second derived measurement intensity for the fifth wavelength, and a third derived measurement intensity for the sixth wavelength. These derived measurement intensities may be used, along with other derived measurement intensities or measured intensities generated during the spectroscopic measurement, to determine one or more properties of the sample being measured. It should be appreciated that in instances where multiple pluralities of encoded measurement intensities are generated by multiple detector elements of the detector group during the second series of encoded measurements, each plurality of encoded measurement intensities may be decoded to generate a corresponding plurality of derived measurement intensities for the second group of wavelengths.

It should be appreciated that, when an optical measurement system performs multiple series of encoded measurements as part of a spectroscopic measurement, the collective group of encoded measurements may be performed in any suitable order. Using the method 1100 as an example, in some variations the first series of encoded measurements may be fully performed before beginning the second series of encoded measurements. In other words, all of the encoded measurements of the first series of encoded measurements may performed before performing a first encoded measurement of the second series of encoded measurements. In other variations, one or more encoded measurements of the second series of encoded measurements may be interleaved with encoded measurements of the first series of encoded measurements. For example, the optical measurement system may perform at least a first set of (e.g., one or more) encoded measurements and second set of (e.g., one or more) encoded measurements as part of the first series of encoded measurements. The optical measurement system may perform at least one measurement of the second series of encoded measurement between i) performing the first set of encoded measurements of the first series of encoded measurements and ii) performing the second set of encoded measurements of the second series of encoded measurements. Similarly, one or more encoded measurements of the first series of encoded measurements may be interleaved with encoded measurements of the second series of encoded measurements. In one example, the optical measurement system may alternate between encoded measurements of the first series and the second series. Regardless of the order in which the individual encoded measurements are performed, the optical measurement system may separately process the pluralities of encoded measurement intensities generated by the different series of encoded measurements.

While a light source unit, such as light source unit 321 of FIG. 3B may be able to simultaneously emit light at multiple different combinations wavelengths, in some instances it may be desirable for the group of wavelengths associated with a series of encoded measurements to have wavelengths that are relatively close in terms of wavelength. Accordingly, in some variations, for a group of wavelengths associated with a series of encoded measurements, immediately adjacent wavelengths within the group may be separated by less than a threshold amount. For example, immediately adjacent wavelengths of the first group of wavelengths may separated by less than a threshold amount (e.g., the first wavelength and the second wavelength are separated by less than the threshold amount and the second wavelength and the third wavelength are separated by less than the threshold amount). Additionally or alternatively, immediately adjacent wavelengths of the second group of wavelengths may separated by less than the threshold amount (e.g., the fourth wavelength and the fifth wavelength are separated by less than the threshold amount and the fifth wavelength and the sixth wavelength are separated by less than the threshold amount). In some variations, the threshold amount is 15 nanometers. In some of these variations, the threshold amount is 10 nanometers.

Reducing the wavelength difference between wavelengths of a group of wavelengths may reduce the impact of wavelength-dependent changes that may occur to light generated by the light source unit 321. For example, in some variations a launch group is associated with a plurality of emitters, such that the plurality of emitters emits a corresponding plurality of overlapping beams of light that collectively form a larger overall beam of light. In some of these variations, the photonic integrated circuit may include a phase shifter array that is controllable to change the relative phases of light emitted by the plurality of emitters, such as described in U.S. Patent Publication No. US2024/0102856A1, filed August 16 2023 and titled "Despeckling in Optical Measurement Systems", which is hereby incorporated by reference in its entirety. Changing the relative phases of light emitted by individual emitters of the launch group may reduce the speckle noise associated with a given measurement. When these phase changes are applied during an encoded measurement, it may be desirable for each wavelength that is simultaneously emitted to experience a similar phase shift (and thereby a similar reduction in speckle noise). Accordingly, it may be desirable to use wavelengths that are relatively closely spaced during a series of encoded measurements, as this may reduce the impact of wavelength dependencies of the phase shifts provided by the phase shifter array.

When a light source unit includes light sources that are configured emit a plurality of wavelengths, a group of wavelengths used in a series of encoded measurements is selected immediately adjacent wavelengths of the plurality of wavelengths. For example, the first group of wavelengths described with respect to the first series of measurements are generated by a first group of light sources 302a-302c that emit immediately adjacent wavelengths of the plurality of light sources 302a-302m. Similarly, the second group of wavelengths described with respect to the second series of measurements are generated by a second group of light sources 302d-302f that emit immediately adjacent wavelengths of the plurality of light sources 302a-302m.

Additionally, when the first group of wavelengths and the second group of wavelengths have a common number of wavelengths (e.g., three), the wavelengths in the first group may be separated by a common set of frequency differences. This may facilitate routing of the various groups of light sources to the same set of outputs of the Echelle grating multiplexer, such as described in more detail herein. For example, the first group of wavelengths of the first series of encoded measurements may be selected such that light of the first wavelength and light of the second wavelength are separated by a first frequency difference, and that light of the second wavelength and light of the third wavelength are separated by a second frequency difference. The second group of wavelengths of the second series of encoded measurements may be selected such that light of the fourth wavelength and light of the fifth wavelength are separated by the first frequency difference, and that light of the fifth wavelength and light of the sixth wavelength are separated by the second frequency difference. In some variations, the first common frequency difference may be the same as the second common frequency difference.

In some variations, it may be possible for the intensity of light emitted from a launch group as part of an encoded measurement to vary. For example, local temperature changes around a light source may cause a corresponding change to the output power of light generated by that light source. While an optical measurement system may be configured to correct for these variations, it may be desirable to understand how much the output power of light emitted by the optical measurement system has fluctuated over the course of an encoded measurement. Accordingly, in some variations an optical measurement system may include a reference detector that is configured to generate a reference signal that is representative of the intensity of light that is emitted by the optical measurement system during a measurement.

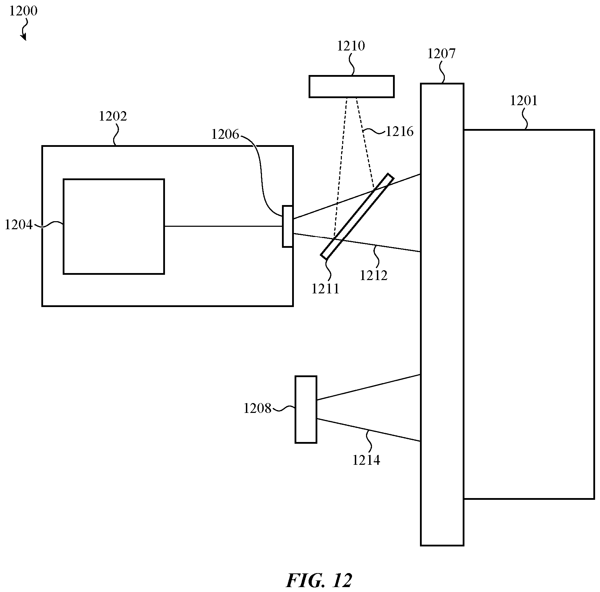

FIG. 12 shows a variation of an optical measurement system 1200 that includes a reference detector 1210. As shown, the optical measurement system 1200 that includes a photonic integrated circuit 1202 and a detector group 1208. The photonic integrated circuit 1202 includes a light source unit 1204 and a launch group 1206 optically connected to the light source unit 1204. The photonic integrated circuit 1202 may be operable to generate light via the light source unit 1204 and to emit a beam of light (referred to herein as "launch beam 1212") from the launch group 1206. At least a portion of the launch beam 1212 may exit the optical measurement system 1200 through a sampling interface 1207 (e.g., via an emission region of the sampling interface 1207). Also shown in FIG. 12 is a sample 1201 positioned in contact with the sampling interface 1207. The optical measurement system 1200 may be configured such that, when optical measurement system 1200 emits the launch beam 1212 while the sample 1201 is positioned in contact with the sampling interface 1207, a portion of the input beam 1212 will be returned to the optical measurement system 1200 as a beam of light (referred to herein as "collection beam 1214") after interacting with the sample 1201. The collection beam 1214 may be measured by the detector group 1208 (e.g., as an output signal as described herein), and the intensity of the collection beam 1214 may depend at least in part on the intensity of the launch beam 1212 and the properties of the sample 1201.

The reference detector 1210 is configured to measure a portion of the light generated by the light source unit 1204 before it exits the optical measurement system 1200 as the launch beam 1212. For example, in the variation shown in FIG. 12, the optical measurement system 1200 includes a beamsplitter 1211 that is configured to split a portion of light (referred to herein as "reference beam 1216") off of the launch beam 1212. The reference beam 1216, after being split off from the launch beam 1212, is directed to and measured by the reference detector 1210. There may be a predetermined relationship between the intensity of the reference beam 1216 and the intensity of the launch beam 1212, such that an output signal generated by the reference detector 1210 may be used to determine an intensity of light that is introduced into the sample 1201 during a spectroscopic measurement (e.g., the intensity of the launch beam 1212). While shown in FIG. 12 as measuring light after it has been emitted from the photonic integrated circuit 1202, the reference detector 1210 may instead be positioned to measure light before it has exited the photonic integrated circuit 1202. In these instances, an output signal generated by the reference detector 1210 may still indicate an intensity of the launch beam 1212 as it exits the optical measurement system, but the reference detector 1210 may not be able to directly account for downstream components that may impact the intensity of the light emitted from the optical measurement system 1200.

For a given individual measurement, the detector group 1208 may generate a measurement intensity (or multiple measurement intensities to the extent the detector group 1208 includes multiple detector elements) and reference detector 1210 may be used to generate a reference intensity (or multiple reference intensities to the extent the reference detector 1210 includes multiple detector elements). Because the reference intensity represents the intensity of light that is generated during the individual measurement (which may vary from measurement to measurement), the optical measurement system 1200 may generate a reference-corrected measurement intensity for an individual measurement using the corresponding reference and measurement intensities. The reference-corrected measurement intensity may be a normalized value that represents the relative percentage of light that is returned to optical measurement system as the collection beam 1214, and thus may account for fluctuations in the intensity of the launch beam 1212 during an individual measurement and/or between different individual measurements. The reference-corrected measurement intensity may be calculated using any suitable reference correction technique as will be readily understood by one of ordinary skill in the art.

When multiple wavelengths of light are simultaneously emitted from the photonic integrated circuit 1202 during an encoded measurement, the reference beam 1216 will simultaneously include multiple wavelengths of light. As with the detector group 1208, the reference detector 1210 may be unable to distinguish between the different wavelengths contained in the reference beam 1216. Accordingly, the reference detector 1210 may be unable to distinguish whether a given change in the intensity of the reference beam 1216 is the result of a change in the intensity of a particular wavelength or a particular combination of corresponding intensity changes for multiple wavelengths. This may impact the ability of the optical measurement system 1200 to accurately perform reference correction of an encoded measurement.

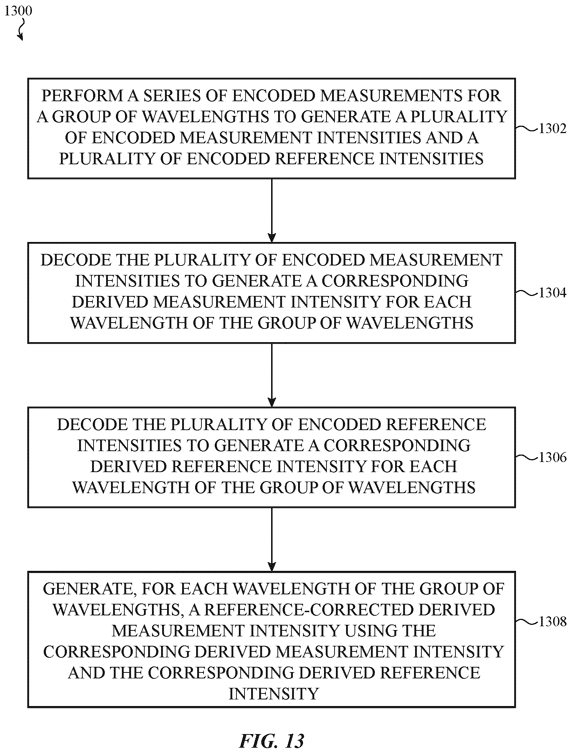

FIG. 13 depicts a method 1300 of performing a spectroscopic measurement that includes a series of encoded measurements that are reference corrected. At step 1302, an optical measurement system performs a series of encoded measurements for a group of wavelengths to generate a plurality of encoded measurement intensities and a plurality of encoded reference intensities. The series of encoded measurements may be performed using a photonic integrated circuit, a reference detector, and a detector group, such as described herein with respect to the optical measurement system 1200 of FIG. 12. For example, during each encoded measurement the photonic integrated circuit (e.g., the photonic integrated circuit 1202) may emit a launch beam that simultaneously is directed to a sample. While the photonic integrated circuit is emitting the launch beam, the detector group (e.g., detector group 1208) may measure a collection beam that is returned from the sample to generate a corresponding encoded measurement intensity of the plurality of encoded measurement intensities. Similarly, while the photonic integrated circuit is emitting the launch beam, the reference detector (e.g., reference detector 1210) may measure a portion of the launch beam that is emitted by photonic integrated circuit (e.g., the reference beam 1216) to generate a corresponding encoded reference intensity of the plurality of encoded reference intensities. It should be appreciated that the series of encoded measurements may be performed in any suitable manner as described herein with respect to the method 1100 of FIG. 11.

The wavelengths generated during the series of encoded measurements may be determined using a corresponding encoding matrix, such as described herein with respect to the wavelength encoding matrix 1000 of FIG. 10. Because the detector group and the reference detector measure the same wavelengths of light during each encoded measurement, the plurality of encoded measurement intensities and the plurality of encoded reference intensities will be encoded according to the same encoding matrix.

Once the plurality of encoded measurement intensities has been generated, the optical measurement system may, at step 1304, decode the plurality of encoded measurement intensities to generate a corresponding derived measurement intensity for each wavelength of the group of wavelengths. For example, in instances where the group of wavelengths includes three wavelengths, the plurality of derived measurement intensities may include a first derived measurement intensity for a first wavelength, a second derived measurement intensity for a second wavelength, and a third derived measurement intensity for a third wavelength.

Similarly, once the plurality of encoded reference intensities has been generated, the optical measurement system may, at step 1306, decode the plurality of encoded reference intensities to generate a corresponding derived reference intensity for each wavelength of the group of wavelengths. The encoded reference intensities may be decoded in the same manner that is used to decode the encoded measurement intensities. In instances where the group of wavelengths includes three wavelengths, the plurality of derived reference intensities may include a first derived reference intensity for the first wavelength, a second derived reference intensity for the second wavelength, and a third derived reference intensity for the third wavelength.

At step 1308, the optical measurement system may generate, for each wavelength in the group of wavelengths, a corresponding reference-corrected derived measurement intensity using the corresponding derived measurement intensity and the corresponding derived reference intensity. By separately decoding the encoded measurement intensities and the encoded reference intensities, the optical measurement system may provide more accurate reference correction for each wavelength within the group of wavelengths.

Exemplary methods, devices, electronic devices, and non-transitory computer-readable storage media are set out in the following items:
A light source unit, comprising:
   an Echelle grating multiplexer comprising a plurality of inputs, and a plurality of outputs positioned to receive light from the plurality of inputs; and
   a plurality of groups of light sources, wherein each group of light sources is operable to emit a plurality of wavelengths, wherein each light source of the plurality of groups of light sources is connected to a corresponding input of the plurality of inputs, and the plurality of inputs is positioned such that:
      light generated by a first light source of each of the plurality of groups of light sources is routed to a first output of the plurality of outputs; and
      light generated by a second light source of each of the plurality of groups of light sources is routed to a second output of the plurality of outputs.
2. The light source unit of item 1, wherein the plurality of inputs is positioned such that light generated by a third light source of each the plurality of the light sources is routed to a third output of the plurality of outputs.
3. The light source unit of item 1 or item 2, wherein the plurality of groups of light sources comprises a first group of light sources; and the first light source and the second light source of the first group of light sources are connected to immediately adjacent inputs of the plurality of inputs.
4. The light source unit of item 1 or item 2, wherein the plurality of groups of light source comprises a first group of light sources and a second group of light sources;
   the first light source of the first group of light sources is connected to a first input of the plurality of inputs;
   the second light source of the first group of light sources is connected to a second input of the plurality of inputs;
   the first light source of the second group of light sources is connected to a third input of the plurality of inputs;
   the second light source of the second group of light sources is connected to a fourth input of the plurality of inputs; and
   the third input is positioned between the first and second input.
5. The light source unit of item 1 or item 2, wherein:
   the plurality of groups of light sources comprises a first group of light sources and a second group of light sources;
   the first light source of the first group of light sources and the first light source of the second group of light sources are positioned on a first laser chip, and
   the second light source of the first group of light sources and the second light source of the second group of light sources are positioned on a second laser chip.
6. The light source unit of any of items 1-5, wherein the first output is connected to a first wavelength locking unit and the second output is connected to a second wavelength locking unit.
7. The light source unit of item 6, wherein:
   wherein the plurality of inputs is positioned such that light generated by a third light source of each the plurality of the light sources is routed to a third output of the plurality of outputs; and
   the third output is connected to a third wavelength locking unit.
8. The light source unit of any of items 1-7, wherein the first light source and the second light source of each of the plurality of groups generate light having a common frequency difference.
9. A light source unit, comprising:
   a first plurality of light sources operable to emit a first wavelength and a second wavelength of light, the first and the second wavelengths separated by less than a threshold amount;
   a second plurality of light sources operable to emit a third wavelength and a fourth wavelength of light, the third and the fourth wavelengths separated by less than the threshold amount; and
   a multiplexer comprising:
      a first input positioned to receive the first wavelength of light emitted by the first plurality of light sources;
      a second input positioned to receive the second wavelength of light emitted by the first plurality of light sources;
      a third input positioned to receive the third wavelength of light emitted by the second plurality of light sources;
      a fourth input positioned to receive the fourth wavelength of light emitted by the second plurality of light sources;
      a first output; and
      a second output, wherein:
         the multiplexer is configured to route light received from the first input and the third input to the first output; and
         the multiplexer is configured to route light received from the second input and the fourth input to the second output.
10. The light source unit of item 9, wherein the multiplexer is an Echelle grating multiplexer.
11. The light source unit of item 9, wherein the third output is positioned between the first input and the second output.
12. The light source unit of item 11, wherein the first wavelength is longer than the second wavelength.
13. The light source unit of item 11, wherein the second input is positioned between the third input and the fourth input.
14. The light source unit of any of items 9-13, wherein the first plurality of light sources is positioned on a first laser chip and the second plurality of light sources are positioned on a second laser chip.
15. The light source unit of any of items 9-14, comprising:
   a first wavelength locking unit; and
   a second wavelength locking unit, wherein the first output is connected to a first wavelength locking unit and the second output is connected to a second wavelength locking unit.
16. A method of operating a light source unit, comprising:
   simultaneously emitting, using a first plurality of light sources, a first wavelength of light and a second wavelength of light during a first period;
   receiving the first wavelength of light and the second wavelength of light at a multiplexer during the first period;
   outputting the first wavelength of light from a first output of the multiplexer during the first period;
   outputting the second wavelength of light from a second output of the multiplexer during the first period;
   simultaneously emitting, using a second plurality of light sources, a third wavelength of light and a fourth wavelength of light during a second period;
   receiving the third wavelength of light and the fourth wavelength of light at the multiplexer during the second period;
   outputting the third wavelength of light from the first output of the multiplexer during the second period; and
   outputting the fourth wavelength of light from the second output of the multiplexer during the second period.
17. The method of item 16, wherein the first wavelength of light is emitted from a first light source and the second wavelength of light is emitted from a second light source; and the first light source and the second light source connect to immediately adjacent inputs of the multiplexer.
18. The method of items 16 or item 17, wherein the first light source is positioned on a first laser chip; and the second light source is positioned on a second laser chip.
19. The method of item 16, wherein the first wavelength of light and the second wavelength of light have a first frequency difference, and the third wavelength of light and the fourth wavelength of light have the first frequency difference.
20. The method of item 16, wherein the first output is connected to a first wavelength locking unit and the second output is connected to a second wavelength locking unit.
21. A photonic integrated circuit comprising:
   a photonic switch configured to simultaneously route a first wavelength of light and a second wavelength of light having a predetermined frequency difference, the photonic switch comprising:
   a first coupler having a first input, a second input, a first output, and a second output;
   a second coupler having a third input, a fourth input, a third output, and a fourth output;
   a first leg connecting the first output of the first coupler to the third input of the second coupler;
   a second leg connecting the second output of the first coupler to the fourth input of the second coupler, wherein a length difference between the first leg and the second leg provides a free spectral range; and
   a first phase shifter positioned and controllable to selectively provide a first phase shift to light traveling between the first coupler and the second coupler, wherein:
      the free spectral range is selected based on the predetermined frequency difference, such that the first wavelength of light received at the first input and the second wavelength of light received at the second input will be routed to a common selection of the third and fourth outputs; and
      the first phase shifter at least partially controls the common selection of the third and fourth outputs.
22. The photonic integrated circuit of item 21, wherein the photonic switch is controllable to split the first wavelength of light and the second wavelength of light between the third output and the fourth output of the second coupler.
23. The photonic integrated circuit of item 21, wherein the photonic switch is controllable to selectively route the first wavelength of light and the second wavelength of light to a single output of the third output and the fourth output.
24. The photonic integrated circuit of any of items 21-23, wherein a second phase shifter is positioned and controllable to selectively provide a second amount of phase shift to light travelling between the first coupler and the second coupler.
25. The photonic integrated circuit of item 24, wherein the first phase shifter is positioned on the first leg and the first phase shifter provides the first phase shift to light travelling through the first leg.
26. The photonic integrated circuit of item 25, wherein the second phase shifter is positioned on the second leg, and the second phase shifter provides the second phase shift to light travelling through the second leg.
27. The photonic integrated circuit of item 21, wherein the controllable switch comprises a variable optical attenuator optically connected to the first input.
28. A photonic integrated circuit comprising:
   a plurality of light sources comprising:
      a first light source and a second light source, wherein the first light source is operable to emit a first wavelength of light and the second light source is operable to emit a second wavelength of light; and
   a photonic switch comprising:
      a first coupler having a first input, a second input, a first output, and a second output;
      a second coupler having a third input, a fourth input, a third output, and a fourth output;
      a first leg connecting the first output of the first coupler to the third input of the second coupler;
      a second leg connecting the second output of the first coupler to the fourth input of the second coupler, wherein a length difference between the first leg and the second leg provides a free spectral range; and
      a first phase shifter positioned and controllable to selectively provide a first phase shift to light traveling between the first coupler and the second coupler, wherein:
         the free spectral range is selected based on the predetermined frequency difference, such that the first wavelength of light received at the first input and the second wavelength of light received at the second input will be routed to a common selection of the third and fourth outputs; and
         the first phase shifter at least partially controls the common selection of the third and fourth outputs.
29. The photonic integrated circuit of item 28, wherein the first phase shifter is controllable to split the first wavelength of light and the second wavelength of light between the third output and the fourth output of the second coupler.
30. The photonic integrated circuit of item 28, wherein the first phase shifter is controllable to selectively route the first wavelength of light and the second wavelength of light to a single output of the third output or the fourth output.
31. The photonic integrated circuit of any of items 28-30, wherein a second phase shifter is positioned and controllable to selectively provide a second amount of phase shift to light travelling between the first coupler and the second coupler.
32. The photonic integrated circuit of item 31, wherein the first phase shifter is positioned on the first leg and the first phase shifter provides the first phase shift to light travelling through the first leg.
33. The photonic integrated circuit of item 32, wherein second phase shifter is positioned on the second leg, and the second phase shifter provides the second phase shift to light travelling through the second leg.
34. The photonic integrated circuit of item 28, wherein the controllable switch comprises a variable optical attenuator optically connected to the first input.
35. A method of operating a photonic integrated circuit having a plurality of light sources and a photonic switch including a first coupler, a second coupler, a first leg connecting the first coupler to the second coupler, a second leg connecting the first coupler to the second coupler, and a plurality of phase shifters, the method comprising:
   simultaneously generating, during a first period of time, a first wavelength of light and a second wavelength of light using the plurality of light sources, the first and second wavelengths of light having a predetermined frequency difference;
   receiving, during the first period of time, the first wavelength of light at a first input of the photonic switch and the second wavelength of light at a second input of the photonic switch; and
   applying a first phase shift to the first leg, during the first period of time, to simultaneously route the first wavelength of light and the second wavelength to a first common selection of outputs of the photonic switch, wherein:
      a length difference between the first leg and the second leg provides a free spectral range of the photonic switch; and
      the free spectral range is selected based on the predetermined frequency difference, such that the first wavelength of light received at the first input and the second wavelength of light received at the second input are combined into the same outputs of the photonic switch.
36. The method of item 35, comprising simultaneously receiving, during a second period of time, a third wavelength of light at the first input of the photonic switch and a fourth wavelength of light at the second input of the photonic switch, wherein the third and the fourth wavelengths of light having the predetermined frequency difference.
37. The method of item 36, comprising applying the first phase shift to the first leg, during the second period of time, to simultaneously route the third wavelength of light and the fourth wavelength to the first common selection of outputs of the photonic switch.
38. The method of item 36, comprising applying a second phase shift to the first leg, during the second period of time, to simultaneously route the third wavelength of light and the fourth wavelength to a second common selection of outputs of the photonic switch.
39. The method of any of items 35-38, wherein the photonic switch comprises a first phase shifter positioned to apply the first phase shift to the first leg and a second phase shifter positioned to provide a second phase shift to the second leg.
40. The method of item 39, comprising applying, during the first period of time, the second phase shift to the second leg.
41. A photonic integrated circuit, comprising:
   a light source unit comprising:
      a plurality of light sources; and
      a multiplexer optically connected to the plurality of light sources and comprising a first output and a second output; and
   a switch network optically connected to the first output and the second output and comprising a plurality of outputs, wherein:
      the light source unit is controllable, during a first period of time, to simultaneously output a first wavelength of light from the first output and a second wavelength of light from the second output; and
      the switch network is controllable, during the first period of time, to simultaneously route the first wavelength of light and the second wavelength of light to a first common selection of the plurality of outputs.
42. The photonic integrated circuit of item 41, wherein:
   the multiplexer is an Echelle grating multiplexer.
43. The photonic integrated circuit of item 41 or item 42, wherein:
   the light source unit is controllable, during a second period of time, to simultaneously output a third wavelength of light from the first output and a fourth wavelength of light from the second output;
   the switch network is controllable, during the second period of time, to simultaneously route the third wavelength of light and the fourth wavelength of light to a second common selection of the plurality of outputs;
   the first wavelength of light and the second wavelength of light have a first frequency difference; and
   the third wavelength of light and the fourth wavelength of light have the first frequency difference.
44. The photonic integrated circuit of any of items 41-43, wherein the switch network comprises a passive optical combiner that is configured to:
   receive the first wavelength of light from the first output and the second wavelength of light from the second output: and
   combine the first wavelength of light and the second wavelength of light into a first waveguide.
45. The photonic integrated circuit of item 44, wherein the switch network comprises a controllable switch optically connected to the first waveguide.
46. The photonic integrated circuit of any of items 41-43, wherein the switch network comprises a multiplexing photonic switch that is configured to:
   receive the first wavelength of light from the first output and the second wavelength of light from the second output; and
   combine the first wavelength of light and the second wavelength of light into a common selection of outputs of the multiplexing photonic switch.
47. The photonic integrated circuit of any of items 41-46, comprising:
   a first wavelength locking unit optically connected to the first output; and
   a second wavelength locking unit optically connected to the second output.
48. A photonic integrated circuit, comprising:
   a light source unit comprising:
      a first plurality of light sources;
      a second plurality of light sources;
      a first multiplexer optically connected to the first plurality of light sources and comprising a first output and a second output; and
      a second multiplexer optically connected to the second plurality of light sources and comprising a third output and a fourth output; and
   a switch network comprising a plurality of outputs and optically connected to the first output, the second output, third output, and the fourth output, wherein:
      the light source unit is controllable, during a first period of time, to simultaneously output a first wavelength of light from the first output and a second wavelength of light from the second output; and
      the switch network is controllable, during the second period of time, to simultaneously route the first wavelength of light and the second wavelength of light to a first common selection of the plurality of outputs.
49. The photonic integrated circuit of item 48, wherein:
   the first multiplexer is an Echelle grating multiplexer.
50. The photonic integrated circuit of item 48 or item 49, wherein:
   the light source unit is controllable, during a second period of time, to simultaneously output a third wavelength of light from the first output and a fourth wavelength of light from the second output;
   the switch network is controllable, during the second period of time, to simultaneously route the third wavelength of light and the fourth wavelength of light to a second common selection of the plurality of outputs;
   the first wavelength of light and the second wavelength of light have a first frequency difference; and
   the third wavelength of light and the fourth wavelength of light have the first frequency difference.
51. The photonic integrated circuit of item 50, wherein:
   the light source unit is controllable, during a third period of time, to simultaneously output a fifth wavelength of light from the third output and a sixth wavelength of light from the fourth output; and
   the switch network is controllable, during the third period of time, to simultaneously route the fifth wavelength of light and the sixth wavelength of light to a third common selection of the plurality of outputs.
52. The photonic integrated circuit of any of items 48-51, wherein the switch network comprises a first passive optical combiner that is optically connected to the first output and the second output, wherein the first passive optical combiner is configured to:
   combine light from the first output and second output having a first predetermined frequency difference into a first waveguide.
53. The photonic integrated circuit of item 52, wherein the switch network comprises a second passive optical combiner that is optically connected to the third output and the fourth output, wherein the second passive optical combiner is configured to:
   combine light from the third output and fourth output having a second predetermined frequency difference into a second waveguide.
54. The photonic integrated circuit of item 53, wherein the switch network comprises a first controllable switch optically connected to the first waveguide and the second waveguide.
55. The photonic integrated circuit of any of items 48-51, wherein the switch network comprises a first multiplexing optical switch that is optically connected to the first output and the second output, wherein the first multiplexing optical switch is configured to:
   combine light from the first output and second output having a first predetermined frequency difference into a common selection of outputs of the first multiplexing photonic switch.
56. The photonic integrated circuit of item 55, wherein the switch network comprises a second multiplexing optical switch that is optically connected to the third output and the fourth output, wherein the second multiplexing optical switch is configured to:
   combine light from the third output and fourth output having a second predetermined frequency difference into a common selection of outputs of the second multiplexing photonic switch.
57. The photonic integrated circuit of any of items 48-56, comprising:
   a first wavelength locking unit optically connected to the first output and the third output; and
   a second wavelength locking unit optically connected to the second output and the fourth output.
58. A method of operating a photonic integrated circuit having a light source unit and a switch network, the method comprising, during a first period of time:
   simultaneously outputting a first wavelength of light from a first output of a first multiplexer of the light source unit and a second wavelength of light from a second output of the first multiplexer; and
   routing, using the switch network, the first wavelength of light and the second wavelength of light to a first common selection of outputs of the switch network.
59. The method of item 58, comprising, during a second period of time:
   simultaneously outputting a third wavelength of light from the first output and a fourth wavelength of light from the second output; and
   routing, using the switch network, the third wavelength of light and the fourth wavelength of light to a second common selection of outputs of the switch network.
60. The method of item 58 or item 59, comprising, during a third period of time:
   simultaneously outputting a fifth wavelength of light from a first output of a second multiplexer of the light source unit and a sixth wavelength of light from a second output of the second multiplexer; and
   routing, using the switch network, the fifth wavelength of light and the sixth wavelength of light to a third common selection of outputs of the switch network.
61. An optical measurement system, comprising:
   a photonics integrated circuit comprising:
      a light source unit, comprising:
         an Echelle grating multiplexer comprising a plurality of inputs, and a plurality of outputs positioned to receive light from the plurality of inputs; and
         a plurality of light sources configured to generate a first plurality of wavelengths, wherein:
            each light source of the plurality of light sources is connected to a corresponding input of the plurality of inputs;
         the plurality of light sources comprises a first group of light sources operable to emit light of a first group of wavelengths of light; and
      a launch group optically coupled to the light source unit and configured to emit light received from the light source unit;
   a detector group; and
   a controller configured to perform a first series of encoded measurements using the light source unit, the launch group, and the detector group, wherein each encoded measurement of the first series of encoded measurements comprises:
      generating, using the light source unit, light at a corresponding plurality of wavelengths, wherein the corresponding plurality of wavelengths is a corresponding subset of the first group of wavelengths;
      simultaneously emitting the corresponding plurality of wavelengths of the generated light from the launch group; and
      measuring, using the detector group, return light received during the simultaneous emission of the corresponding plurality of wavelengths.
62. The optical measurement system of item 61, wherein:
   the control is configured to generate, using the first series of encoded measurements, a derived measurement intensity for each wavelength of the first group of wavelengths.
63. The optical measurement system of item 61 or item 62, wherein:
   the plurality of light sources comprises a second group of light sources operable to emit a second group of wavelengths of light;
   the controller is configured to perform a second series of encoded measurements using the light source unit, the launch group, and the detector group; and
   each encoded measurement of the second series of encoded measurements comprises:
      generating, using the light source unit, light at a corresponding plurality of wavelengths, wherein the corresponding plurality of wavelengths is a corresponding subset of the second group of wavelengths;
      simultaneously emitting the corresponding plurality of wavelengths of the generated light from the launch group; and
      measuring, using the detector group, return light received during the simultaneous emission of the corresponding plurality of wavelengths.
64. The optical measurement system of any of items 61 to 63, wherein:
   the first group of wavelengths is selected from immediately adjacent wavelengths of the first plurality of wavelengths.
65. The optical measurement system of any of items 61 to 64, wherein:
   the photonic integrated circuit comprises a passive optical combiner that is configured optically couple the plurality of outputs of the Echelle grating multiplexer to a common waveguide.
66. The optical measurement system of any of items 61 to 65, wherein:
   the first group of light sources comprises a first light source operable to emit light at a first wavelength, a second light source operable to emit light at a second wavelength, and a third light source operable to emit light at a second wavelength;
   the plurality of outputs of the Echelle grating multiplexer comprises a first output, a second output, and a third output;
   the Echelle grating multiplexer is configured to route light of the first wavelength generated by the first light source to the first output;
   the Echelle grating multiplexer is configured to route light of the second wavelength generated by the second light source to the second output; and
   the Echelle grating multiplexer is configured to route light of the third wavelength generated by the third light source to the third output.
67. The optical measurement system of any of items 61 to 66, comprising:
   a reference detector configured to measure an intensity of the light emitted by the launch group.
68. A method of performing a spectroscopic measurement using an optical measurement system, the method comprising:
   performing, using a photonic integrated circuit and a detector group of the optical measurement system, a first series of encoded measurements for a first group of wavelengths to generate a first plurality of encoded measurement intensities, wherein:
   the photonic integrated circuit comprises a light source unit and a launch group;
   the light source unit comprises an Echelle grating multiplexer having a plurality of outputs; and
   performing the first series of encoded measurement comprises, for each encoded measurement of the first series of encoded measurements:
      generating, at a corresponding subset of the plurality of outputs of the Echelle grating multiplexer, light at a corresponding plurality of wavelengths, wherein the corresponding plurality of wavelengths is a corresponding subset of the first group of wavelengths;
      simultaneously emitting the corresponding plurality of wavelengths of the generated light from the launch group; and
      measuring, using the detector group, return light received during the simultaneous emission of the corresponding plurality of wavelengths to generate a corresponding encoded measurement intensity of the first plurality of encoded measurement intensities.
69. The method of item 68, comprising:
   decoding the first plurality of encoded measurement intensities to generate a corresponding derived measurement intensity for each wavelength of the first group of wavelengths.
70. The method of item 68 or item 69, wherein:
   the plurality of outputs of the Echelle grating multiplexer comprises a first output, a second output, and a third output; and
   the first group of wavelengths comprises a first wavelength, a second wavelength, and a third wavelength.
71. The method of item 70, wherein:
   the first series of encoded measurements comprises a first encoded measurement; and
   during the first encoded measurement of the first series of encoded measurements:
      light of the first wavelength is generated at the first output;
      light of the second wavelength is generated at the second output;
      light of the first wavelength and the second wavelength is simultaneously emitted from the launch group; and
      the detector group generates a first encoded measurement intensity of the first plurality of encoded measurement intensities.
72. The method of item 71, wherein:
   the first series of encoded measurements comprises a second encoded measurement; and
   during the second encoded measurement of the first series of encoded measurements:
      light of the first wavelength is generated at the first output;
      light of the third wavelength is generated at the third output;
      light of the first wavelength and the third wavelength is simultaneously emitted from the launch group; and
      the detector group generates a second encoded measurement intensity of the first plurality of encoded measurement intensities.
73. The method of any of items 68 to 72, comprising:
   performing, using the photonic integrated circuit and the detector group, a second series of encoded measurements for a second group of wavelengths to generate a second plurality of encoded measurement intensities, wherein:
   performing the second series of encoded measurement comprises, for each encoded measurement of the second series of encoded measurements:
   generating, at a corresponding subset of the plurality of outputs of the Echelle grating multiplexer, light at a corresponding plurality of wavelengths, wherein the corresponding plurality of wavelengths is a corresponding subset of the second group of wavelengths;
   simultaneously emitting the corresponding plurality of wavelengths of the generated light from the launch group; and
   measuring, using the detector group, return light received during the simultaneous emission of the corresponding plurality of wavelengths to generate a corresponding encoded measurement intensity of the second plurality of encoded measurement intensities.
74. The method of item 73, comprising:
   decoding the second plurality of encoded measurement intensities to generate a corresponding derived measurement intensity for each wavelength of the second group of wavelengths.
75. The method of item 73 or item 74, wherein:
   the first group of wavelengths and the second group of wavelengths have a common number of wavelengths.
76. The method of item 75, wherein:
   the first group of wavelengths and the second group of wavelengths have a common set of frequency differences.
77. A method of performing a spectroscopic measurement using an optical measurement system, the method comprising:
   performing, using the optical measurement system, a first series of encoded measurements for a group of wavelengths to generate a plurality of encoded measurement intensities,
   decoding the plurality of encoded measurement intensities to generate a corresponding derived measurement intensity for each wavelength of the group of wavelengths;
   decoding the plurality of encoded references intensities to generate a corresponding derived reference intensity for each wavelength of the group of wavelengths; and
   generating, for each wavelength of the group of wavelength, a corresponding reference-corrected derived measurement intensity using the corresponding derived measurement intensity and the corresponding derived reference intensity.
78. The method of item 77, wherein:
   the series of encoded measurements is performed using a photonic integrated circuit, a detector group, and a reference detector of the optical measurement system;
   the detector group generates the plurality of encoded measurement intensities; and
   the reference detector generates the plurality of encoded reference intensities.
79. The method of item 78, wherein:
   the photonic integrated circuit comprises a light source unit and a launch group;
   the light source unit comprises an Echelle grating multiplexer having a plurality of outputs.
80. The method of item 79, wherein:
   performing the series of encoded measurement comprises, for each encoded measurement of the series of encoded measurements:
   generating, at a corresponding subset of the plurality of outputs of the Echelle grating multiplexer, light at a corresponding plurality of wavelengths, wherein the corresponding plurality of wavelengths is a corresponding subset of the group of wavelengths;
   simultaneously emitting the corresponding plurality of wavelengths of the generated light from the launch group;
   measuring, using the detector group, return light received during the simultaneous emission of the corresponding plurality of wavelengths to generate a corresponding encoded measurement intensity of the plurality of encoded measurement intensities; and
   measuring, using the reference detector, a portion of the generated light emitted from the launch group.
81. A photonic integrated circuit, comprising:
   a light source unit comprising:
   an Echelle grating multiplexer comprising a plurality of inputs, and a plurality of outputs positioned to receive light from the plurality of inputs; and
   a set of tunable light sources, wherein:
      each tunable light source of the set of tunable light sources is connected to a corresponding input of the plurality of inputs; and
      each tunable light source of the set of tunable light sources is operable to selectively emit light at a corresponding plurality of wavelengths that comprises a first corresponding wavelength and a second corresponding wavelength, such that:
         light of the first corresponding wavelength emitted by each tunable light source of the set of tunable light sources is routed to a first output of the plurality of outputs; and
         light of the second corresponding wavelength emitted by each tunable light source of the set of tunable light sources is routed to a second output of the plurality of outputs.
82. The photonic integrated circuit of item 81, wherein:
   the corresponding plurality of wavelengths of each of tunable light source of the set of tunable light sources comprises a third corresponding wavelength; and
   light of the third corresponding wavelength emitted by each tunable light source of the set of tunable light sources is routed to a third output of the plurality of outputs.
83. The photonic integrated circuit of item 81 or item 82, wherein:
   the set of tunable light sources comprises a plurality of tunable light sources.
84. The photonic integrated circuit of item 83, wherein:
   the corresponding first wavelength and the corresponding second wavelength emitted by each tunable light source of the plurality of tunable light sources have a common frequency difference.
85. The photonic integrated circuit of any of items 81 to 84, wherein:
   the light source unit comprises a set of groups of light sources, each group of light sources is operable to emit a corresponding plurality of wavelengths;
   each light source of the set of groups of light sources is connected to a corresponding input of the plurality of inputs, and the plurality of inputs is positioned such that:
      light generated by a first light source of each of the set of groups of light sources is routed to the first output of the plurality of outputs; and
      light generated by a second light source of each of the set of groups of light sources is routed to the second output of the plurality of outputs.
86. The photonic integrated circuit of any of items 81 to 85, comprising:
   a passive optical combiner that is configured optically couple the plurality of outputs of the Echelle grating multiplexer to a common waveguide.
87. A photonic integrated circuit, comprising:
   a light source unit comprising:
      a set of tunable light sources;
      a plurality of light sources;
      a first multiplexer optically connected to the plurality of tunable light sources and comprising a first plurality of outputs; and
      a second multiplexer optically connected to the plurality of light sources and comprising a second plurality of outputs, wherein:
   the light source unit is controllable, during a first period of time, to output a first wavelength of light from a first output of the first plurality of outputs;
   the light source unit is controllable, during a second period of time, to output a second wavelength of light from a second output of the first plurality of outputs;
   the light source unit is controllable, during a third period of time, to simultaneously output a third wavelength of light from a first output of the second plurality of outputs and a second wavelength of light from a second output of the second plurality of outputs; and
   the first wavelength and the second wavelength are generated by a tunable light source of the set of tunable light sources.
88. The photonic integrated circuit of item 87, comprising:
   a switch network optically connected to the first plurality of outputs and the second plurality of outputs, and comprising a third plurality of outputs.
89. The photonic integrated circuit of item 88, wherein:
   the switch network is controllable, during the first period of time, to route the first wavelength of light to a first common selection of the third plurality of outputs; and
   the switch network is controllable, during the second period of time, to route the second wavelength of light to a second common selection of the third plurality of outputs.
90. The photonic integrated circuit of item 88 or item 89, wherein:
   the switch network is controllable, during the third period of time, to simultaneously route the third wavelength of light and the fourth wavelength of light to a third common selection of the third plurality of outputs.
91. The photonic integrated circuit of any of items 88 to 90, wherein:
   the switch network comprises a multiplexing photonic switch that is configured to:
   receive the third wavelength of light from the first output of the second plurality of outputs and the fourth wavelength of light from the second output of the second plurality of outputs; and
   combine the third wavelength of light and the fourth wavelength of light into a common selection of outputs of the multiplexing photonic switch.
92. The photonic integrated circuit of any of items 88 to 91, wherein:
   the switch network comprises a controllable switch that is optically connected to the first output of the first plurality of outputs and the second output of the first plurality of outputs.
93. The photonic integrated circuit of any of items 88 to 92, wherein:
   the first multiplexer is an Echelle grating multiplexer.
94. The photonic integrated circuit of any of items 88 to 93, wherein:
   the second multiplexer is an Echelle grating multiplexer.
95. The photonic integrated circuit of any of items 88 to 94, wherein:
   the light source unit comprises a set of wavelength locking units.
96. A method of operating a light source unit of a photonic integrated circuit, comprising:
   emitting, using a first tunable light source, a first wavelength of light of during a first period;
   receiving the first wavelength of light at a first input of an Echelle grating multiplexer during the first period;
   outputting the first wavelength of light from a first output of the Echelle grating multiplexer during the first period;
   emitting, using the first tunable light source, a second wavelength of light during a second period;
   receiving the second wavelength of light at the first input of the Echelle grating multiplexer during the second period; and
   outputting the second wavelength of light from a second output of the Echelle grating multiplexer during the second period.
97. The method of item 96, comprising:
   emitting, using a second tunable light source, a third wavelength of light of during a third period;
   receiving the third wavelength of light at a second input of the Echelle grating multiplexer during the third period;
   outputting the third wavelength of light from the first output of the Echelle grating multiplexer during the first period;
   emitting, using the second tunable light source, a fourth wavelength of light during a fourth period;
   receiving the fourth wavelength of light at the second input of the Echelle grating multiplexer during the fourth period; and
   outputting the fourth wavelength of light from the second output of the Echelle grating multiplexer during the fourth period.
98. The method of item 97, wherein:
   the first wavelength of light and the second wavelength of light have a first frequency difference; and
   the third wavelength of light and the fourth wavelength of light have the first frequency difference.
99. The method of any of items 96 to 98, wherein:
   a passive optical combiner optically couples the first output and the second output the Echelle grating multiplexer to a common waveguide.
100. The method of any of items 96 to 99, comprising:
   simultaneously emitting, using a first plurality of light sources, a fifth wavelength of light and a sixth wavelength of light during a fifth period;
   receiving the fifth wavelength of light and the sixth wavelength of light at the Echelle grating multiplexer during the fifth period;
   outputting the fifth wavelength of light from the first output of the Echelle grating multiplexer during the fifth period; and
   outputting the sixth wavelength of light from the second output of the Echelle grating multiplexer during the fifth period.

The foregoing description, for purposes of explanation, uses specific nomenclature to provide a thorough understanding of the described embodiments. However, it will be apparent to one skilled in the art, after reading this description, that the specific details are not required in order to practice the described embodiments. Thus, the foregoing descriptions of the specific embodiments described herein are presented for purposes of illustration and description. They are not targeted to be exhaustive or to limit the embodiments to the precise forms disclosed. It will be apparent to one of ordinary skill in the art, after reading this description, that many modifications and variations are possible in view of the above teachings.

## Claims

1. A light source unit, comprising:
an Echelle grating multiplexer comprising a plurality of inputs, and a plurality of outputs positioned to receive light from the plurality of inputs; and
a plurality of groups of light sources, wherein each group of light sources is operable to emit a plurality of wavelengths, wherein each light source of the plurality of groups of light sources is connected to a corresponding input of the plurality of inputs, and the plurality of inputs is positioned such that:
light generated by a first light source of each of the plurality of groups of light sources is routed to a first output of the plurality of outputs; and
light generated by a second light source of each of the plurality of groups of light sources is routed to a second output of the plurality of outputs.

2. The light source unit of claim 1, wherein the plurality of inputs is positioned such that light generated by a third light source of each the plurality of the light sources is routed to a third output of the plurality of outputs.

3. The light source unit of claim 1 or claim 2, wherein the plurality of groups of light sources comprises a first group of light sources; and the first light source and the second light source of the first group of light sources are connected to immediately adjacent inputs of the plurality of inputs.

4. The light source unit of claim 1 or claim 2, wherein the plurality of groups of light source comprises a first group of light sources and a second group of light sources;
the first light source of the first group of light sources is connected to a first input of the plurality of inputs;
the second light source of the first group of light sources is connected to a second input of the plurality of inputs;
the first light source of the second group of light sources is connected to a third input of the plurality of inputs;
the second light source of the second group of light sources is connected to a fourth input of the plurality of inputs; and
the third input is positioned between the first and second input.

5. The light source unit of claim 1 or claim 2, wherein:
the plurality of groups of light sources comprises a first group of light sources and a second group of light sources;
the first light source of the first group of light sources and the first light source of the second group of light sources are positioned on a first laser chip, and
the second light source of the first group of light sources and the second light source of the second group of light sources are positioned on a second laser chip.

6. The light source unit of any of claims 1-5, wherein the first output is connected to a first wavelength locking unit and the second output is connected to a second wavelength locking unit.

7. The light source unit of claim 6, wherein:
wherein the plurality of inputs is positioned such that light generated by a third light source of each the plurality of the light sources is routed to a third output of the plurality of outputs; and
the third output is connected to a third wavelength locking unit.

8. The light source unit of any of claims 1-7, wherein the first light source and the second light source of each of the plurality of groups generate light having a common frequency difference.

9. A light source unit, comprising:
a first plurality of light sources operable to emit a first wavelength and a second wavelength of light, the first and the second wavelengths separated by less than a threshold amount;
a second plurality of light sources operable to emit a third wavelength and a fourth wavelength of light, the third and the fourth wavelengths separated by less than the threshold amount; and
a multiplexer comprising:
a first input positioned to receive the first wavelength of light emitted by the first plurality of light sources;
a second input positioned to receive the second wavelength of light emitted by the first plurality of light sources;
a third input positioned to receive the third wavelength of light emitted by the second plurality of light sources;
a fourth input positioned to receive the fourth wavelength of light emitted by the second plurality of light sources;
a first output; and
a second output, wherein:
the multiplexer is configured to route light received from the first input and the third input to the first output; and
the multiplexer is configured to route light received from the second input and the fourth input to the second output.

10. The light source unit of claim 9, wherein the multiplexer is an Echelle grating multiplexer.

11. The light source unit of claim 9, wherein the third output is positioned between the first input and the second output.

12. The light source unit of claim 11, wherein the first wavelength is longer than the second wavelength.

13. The light source unit of claim 11, wherein the second input is positioned between the third input and the fourth input.

14. The light source unit of any of claims 9-13, wherein the first plurality of light sources is positioned on a first laser chip and the second plurality of light sources are positioned on a second laser chip.

15. The light source unit of any of claims 9-14, comprising:
a first wavelength locking unit; and
a second wavelength locking unit, wherein the first output is connected to a first wavelength locking unit and the second output is connected to a second wavelength locking unit.
